# EUROPEAN PATENT APPLICATION

(11) **EP 4 579 951 A1**
(43) Date of publication of application: **02.07.2025**
(21) Application number: 23873229.1
(22) Date of filing: 27.09.2023
(51) Int. Cl.: H01Q 1/38, H01Q 1/24, H04M 1/02, H05K 1/11, H05K 1/02

(54) **ELECTRONIC DEVICE COMPRISING ANTENNA**

(30) Priority: 27.09.2022 KR 20220122501; 28.10.2022 KR 20220141805
(71) Applicant: Samsung Electronics Co., Ltd., Suwon-si, Gyeonggi-do 16677 (KR)
(72) Inventor: PARK, Seongjin, Suwon-si, Gyeonggi-do 16677 (KR); KIM, Hosaeng, Suwon-si, Gyeonggi-do 16677 (KR); YUN, Sumin, Suwon-si, Gyeonggi-do 16677 (KR); JO, Jaehoon, Suwon-si, Gyeonggi-do 16677 (KR)
(74) Representative: HGF
(86) International application number: PCT/KR2023/015068
(87) International publication number: WO 2024/072120

(57) **Abstract**

According to an embodiment of the present invention, an electronic device may comprise a wireless communication circuit, an antenna structure, a non-conductive dielectric, and a conductive path. The antenna structure may comprise a printed circuit board electrically connected to the wireless communication circuit. The printed circuit board may comprise a first side and a second side facing in the opposite direction as the first side. The printed circuit board may comprise an antenna element disposed on the first side or disposed, closer to the first side than the second side, inside the printed circuit board. The non-conductive dielectric faces the first side and may overlap the antenna element when viewed from above the first side. The conductive path may be at least partially disposed on the printed circuit board and electrically connected to the wireless communication circuit. The conductive path may be in physical contact with the non-conductive dielectric. Various other embodiments may be possible.

## Description

### [Technical Field]

The present disclosure relates to an electronic device comprising an antenna.

### [Background Art]

With the advancement of wireless communication technology, electronic devices are being used widely in our daily lives, and the use of content is increasing. Electronic devices contain multiple antennas to support various communication technologies.

The above information may be provided as related art for the purpose of assisting in understanding the present disclosure. No claim or determination is made as to whether any of the above is applicable as prior art related to the present disclosure.

### [Disclosure of Invention]

### [Technical Problem]

As the range of applications available expands, the number of antennas included in electronic devices is increasing. Electronic devices are becoming thinner while adding components for various functions, making it difficult to dispose antennas in limited spaces while reducing electrical influences with various elements within the electronic device and ensuring coverage (or communication range) and radiation performance for the desired frequency band.

Embodiments of the present disclosure may provide an electronic device including an antenna for securing or improving coverage and/or antenna radiation performance.

The technical problems to be achieved in the present disclosure are not limited to the technical problems mentioned above, and other technical problems not mentioned can be understood by a person having ordinary skills in the technical field to which the present invention belongs from the description below.

### [Solution to Problem]

According to an exemplary embodiment of the present disclosure, an electronic device may comprise a wireless communication circuit, an antenna structure, a non-conductive dielectric, and a conductive path. The antenna structure may comprise a printed circuit board electrically connected to the wireless communication circuit. The printed circuit board may comprise a first surface and a second surface facing in the opposite direction from the first surface. The printed circuit board may comprise an antenna element disposed on the first surface or disposed, closer to the first surface than the second surface, inside the printed circuit board. The non-conductive dielectric may face the first surface and overlap the antenna element when viewed from above the first surface. The conductive path may be at least partially disposed on the printed circuit board and electrically connected to the wireless communication circuit. The conductive path may be in physical contact with the non-conductive dielectric.

According to an exemplary embodiment of the present disclosure, an electronic device may comprise a wireless communication circuit, an antenna structure, a non-conductive dielectric, and a conductive path. The antenna structure may comprise a printed circuit board electrically connected to the wireless communication circuit. The printed circuit board may comprise a first surface and a second surface facing in the opposite direction from the first surface. The printed circuit board may comprise a first antenna element disposed on the first surface or disposed, closer to the first surface than the second surface, inside the printed circuit board. The printed circuit board may comprise a second antenna element disposed closer to the first surface than the first antenna element. The non-conductive dielectric may face the first surface and overlap the first antenna element and the second antenna element when viewed from above the first surface. The conductive path may be at least partially disposed on the printed circuit board and electrically connected to the wireless communication circuit. The conductive path may be in physical contact with the non-conductive dielectric.

### [Advantageous Effects of Invention]

An electronic device including an antenna according to an exemplary embodiment of the present disclosure may secure or improve coverage and/or antenna radiation performance by using a dielectric resonator.

In addition, the effects that can be obtained or expected by various embodiments of the present disclosure will be disclosed directly or implicitly in the detailed description of the embodiments of the present disclosure. For example, the various effects expected by various embodiments of the present disclosure will be disclosed in the detailed description to be described later.

### [Brief Description of Drawings]

FIG. 1 is a block diagram of an electronic device in a network environment according to an embodiment of the present disclosure.
FIG. 2 is a block diagram illustrating an electronic device in a network environment including a plurality of cellular networks according to an embodiment of the present disclosure.
FIG. 3 are diagrams illustrating a foldable electronic device in an unfolded state according to an embodiment of the present disclosure.
FIG. 4 are diagrams illustrating a foldable electronic device in a folded state according to an embodiment of the present disclosure.
FIGS. 5 and 6 are diagrams illustrating an antenna module according to an embodiment of the present disclosure.
FIGS. 7 and 8 are diagrams illustrating beam patterns generated from an antenna module according to an embodiment of the present disclosure.
FIG. 9 are diagrams illustrating the distribution of radiation fields generated from the first radiating portion according to an embodiment of the present disclosure.
FIG. 10 are graphs illustrating radiation patterns of a first radiating portion according to an embodiment of the present disclosure.
FIG. 11 are heat maps illustrating wave energy according to a feeding to an antenna module in free space according to an embodiment of the present disclosure.
FIG. 12 is an exploded perspective view of an antenna module according to an embodiment of the present disclosure.
FIG. 13 is a perspective view of an antenna module according to an embodiment of the present disclosure.
FIG. 14 is a cross-sectional view of an antenna module as viewed along line A-A' in FIG. 13 according to an embodiment of the present disclosure.
FIG. 15 is a cross-sectional view of an antenna module of another embodiment that is a variation of the embodiment of FIG. 14 according to various embodiments of the present disclosure.
FIG. 16 are graphs illustrating radiation patterns of a first radiating portion according to the permittivity of the first dielectric in the embodiment of FIG. 13 according to an embodiment of the present disclosure.
FIG. 17 are graphs illustrating radiation patterns of a first radiating portion along the length of the first conductive portion extending in a first direction toward the first surface in the embodiment of FIG. 14 according to an embodiment of the present disclosure.
FIG. 18 is a diagram illustrating an antenna module according to various embodiments of the present disclosure.
FIG. 19 is a cross-sectional view of an antenna module as viewed along line B-B' in FIG. 18 according to various embodiments of the present disclosure.
FIG. 20 are heat maps illustrating wave energy for electromagnetic waves radiated by various feedings to the antenna module of FIG. 18 according to an embodiment of the present disclosure.
FIG. 21 is a block diagram illustrating a communication system included in an electronic device according to various embodiments of the present disclosure.
FIG. 22 is a cross-sectional view illustrating a portion of an electronic device according to various embodiments of the present disclosure.

### [Mode for the Invention]

Hereinafter, various example embodiments of the disclosure disclosed herein will be described in greater detail with reference to the accompanying drawings.

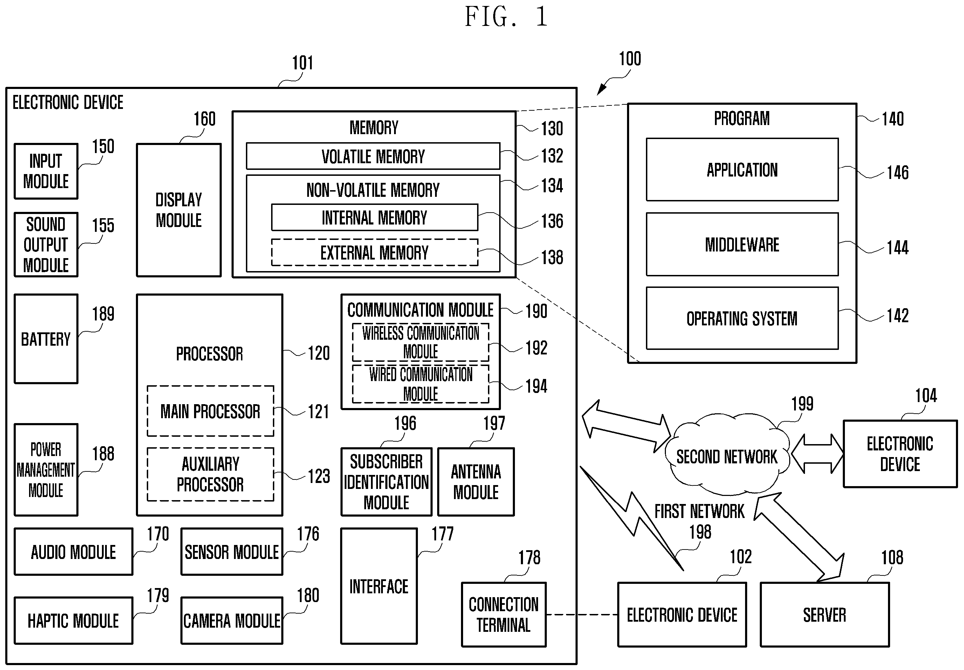

FIG. 1 is a block diagram of an electronic device 101 in a network environment 100 according to an embodiment of the present disclosure.

With reference to FIG. 1, the electronic device 101 in the network environment 100 may communicate with an external electronic device 102 through a first network 198 (e.g., a short-range wireless communication network), or at least one of an external electronic device 104 or a server 108 through a second network 199 (e.g., a long-range wireless communication network). The electronic device 101 may communicate with the external electronic device 104 through the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound through the input module 150, or output the sound through the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication through the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device through the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device through the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 through the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) on the basis of 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or through a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online through an application store (e.g., PLAYSTORE^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

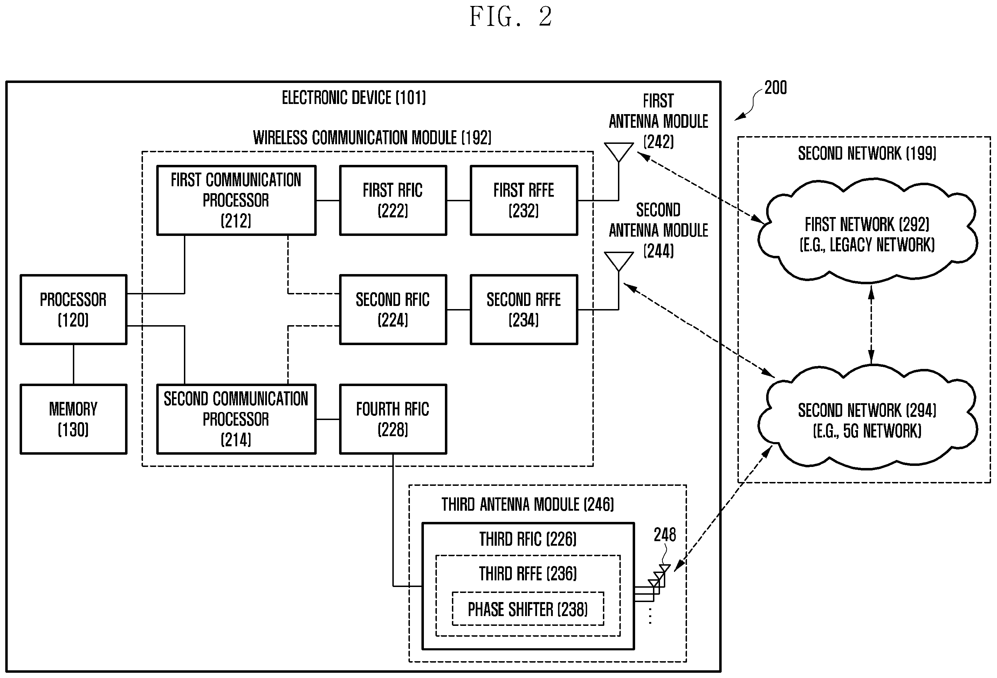

FIG. 2 is a block diagram 200 illustrating an electronic device 101 in a network environment including a plurality of cellular networks according to an embodiment of the present disclosure.

With reference to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and/or an antenna 248. The electronic device 101 may include a processor 120 and a memory 130. The second network 199 may include a first cellular network 292 and a second cellular network 294. In another embodiment, the electronic device 101 may further include at least one of the components described in FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least a portion of the wireless communication module 192. In another embodiment, the fourth RFIC 228 may be omitted or may be included as a part of the third RFIC 226.

The first communication processor 212 may support establishment of a communication channel of a band to be used for wireless communication with the first cellular network 292, and legacy network communication through the established communication channel. According to various embodiments, the first cellular network may be a legacy network including a second generation (2G), a third generation (3G), a fourth generation (4G), or a long term evolution (LTE) network. The second communication processor 214 may support establishment of a communication channel corresponding to a designated band (e.g., about 6 GHz to about 60 GHz) among the bands to be used for wireless communication with the second cellular network 294, and 5G network communication through the established communication channel. According to various embodiments, the second cellular network 294 may be a fifth generation (5G) network defined by 3GPP. Additionally, according to an embodiment, the first communication processor 212 or the second communication processor 214 may support establishment of a communication channel corresponding to another designated band (e.g., about 6 GHz or less) among the bands to be used for wireless communication with the second cellular network 294, and 5G network communication through the established communication channel. According to an embodiment, the first communication processor 212 and the second communication processor 214 may be implemented in a single chip or a single package. According to various embodiments, the first communication processor 212 or the second communication processor 214 may be formed in a single chip or a single package with the processor 120, the coprocessor 123, or the communication module 190.

The first RFIC 222 may, during transmission, convert a baseband signal generated by the first communication processor 212 into a radio frequency (RF) signal of about 700 MHz to about 3 GHz used in the first cellular network 292 (e.g., a legacy network). During reception, the RF signal may be acquired from the first cellular network 292 (e.g., a legacy network) through an antenna (e.g., the first antenna module 242) and preprocessed through an RFFE (e.g., the first RFFE 232). The first RFIC 222 may convert the preprocessed RF signal into a baseband signal so that it may be processed by the first communication processor 212.

The second RFIC 224 may, during transmission, convert a baseband signal generated by the first communication processor 212 or the second communication processor 214 into an RF signal (hereinafter, a 5G Sub6 RF signal) of a Sub6 band (e.g., about 6 GHz or less) used in the second cellular network 294 (e.g., a 5G network). During reception, the 5G Sub6 RF signal may be acquired from the second cellular network 294 (e.g., the 5G network) through an antenna (e.g., the second antenna module 244) and preprocessed through an RFFE (e.g., the second RFFE 234). The second RFIC 224 may convert the preprocessed 5G Sub6 RF signal into a baseband signal so that the preprocessed 5G Sub6 RF signal may be processed by a corresponding communication processor among the first communication processor 212 or the second communication processor 214.

The third RFIC 226 may convert a baseband signal generated by the second communication processor 214 into an RF signal (hereinafter, "5G Above6 RF signal") of a 5G Above6 band (e.g., about 6 GHz to about 60 GHz) to be used in the second cellular network 294 (e.g., a 5G network). During reception, the 5G Above6 RF signal may be acquired from the second cellular network 294 (e.g., a 5G network) through an antenna (e.g., the antenna 248) and preprocessed through the third RFFE 236. The third RFIC 226 may convert the preprocessed 5G Above6 RF signal into a baseband signal so that it can be processed by the second communication processor 214. According to an embodiment, the third RFFE 236 may be formed as a part of the third RFIC 226.

The electronic device 101 may, according to an embodiment, include a fourth RFIC 228 separately from or at least as a part of the third RFIC 226. In such a case, the fourth RFIC 228 may convert a baseband signal generated by the second communication processor 214 into an RF signal (hereinafter, referred to as an IF signal) of an intermediate frequency band (e.g., about 9 GHz to about 11 GHz) and then transmit the IF signal to the third RFIC 226. The third RFIC 226 may convert the IF signal into a 5G Above6 RF signal. During reception, the 5G Above6 RF signal may be received from the second cellular network 294 (e.g., a 5G network) through an antenna (e.g., antenna 248) and converted into an IF signal by the third RFIC 226. The fourth RFIC 228 may convert the IF signal into a baseband signal for processing by the second communications processor 214.

According to an embodiment, the first RFIC 222 and the second RFIC 224 may be implemented as at least a portion of a single chip or a single package. According to an embodiment, the first RFFE 232 and the second RFFE 234 may be implemented as at least a portion of a single chip or a single package. According to an embodiment, at least one antenna module of the first antenna module 242 or the second antenna module 244 may be omitted or combined with another antenna module to process RF signals of corresponding multiple bands.

According to an embodiment, the third RFIC 226 and the antenna 248 may be disposed on the same substrate to form a third antenna module 246. For example, the wireless communication module 192 or the processor 120 may be disposed on a substrate (e.g. a main PCB). In this case, a third RFIC 226 may be disposed on a portion (e.g., a lower surface) of a second substrate (e.g., a sub PCB) separate from the first substrate, and an antenna 248 may be disposed on another portion (e.g., a top surface) to form a third antenna module 246. By disposing the third RFIC 226 and the antenna 248 on the same substrate, it is possible to reduce the length of a transmission line therebetween. This may reduce, for example, the loss (e.g., attenuation) of a signal in a high-frequency band (e.g., about 6 GHz to about 60 GHz) used for 5G network communication by the transmission line. As a result, the electronic device 101 may improve the quality or speed of communication with the second cellular network 294 (e.g., a 5G network).

According to an embodiment, the antenna 248 may be formed as an antenna array comprising a plurality of antenna elements that may be used for beamforming. In this case, the third RFIC 226 may include, for example, a plurality of phase shifters 238 corresponding to the plurality of antenna elements as part of the third RFFE 236. During transmission, each of the plurality of phase shifters 238 may shift the phase of a 5G Above6 RF signal to be transmitted to an external source (e.g., a base station of a 5G network) of the electronic device 101 through its corresponding antenna element. During reception, each of the plurality of phase shifters 238 may shift the phase of a 5G Above6 RF signal received from the external source through its corresponding antenna element to the same or substantially the same phase. This enables transmission or reception through beamforming between the electronic device 101 and the external source.

The second cellular network 294 (e.g., a 5G network) may operate independently (e.g., Stand-Alone (SA)) or connected (e.g., Non-Stand Alone (NSA)) to the first cellular network 292 (e.g., a legacy network). For example, the 5G network may only have an access network (e.g., a 5G radio access network (RAN) or next generation RAN (NG RAN)) and no core network (e.g., next generation core (NGC)). In such a case, the electronic device 101 may access an external network (e.g., the Internet) under the control of the core network (e.g., evolved packed core (EPC)) of the legacy network after accessing the access network of the 5G network. Protocol information for communicating with a legacy network (e.g., LTE protocol information) or protocol information for communicating with a 5G network (e.g., New Radio (NR) protocol information) may be stored in the memory 230 and accessed by other components (e.g., the processor 120, the first communication processor 212, or the second communication processor 214).

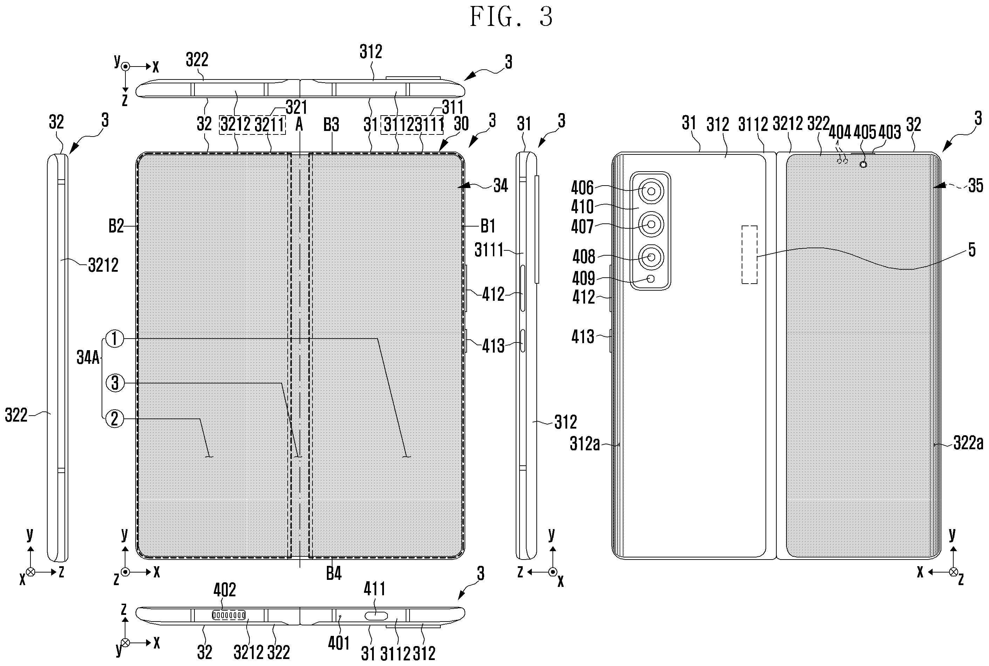

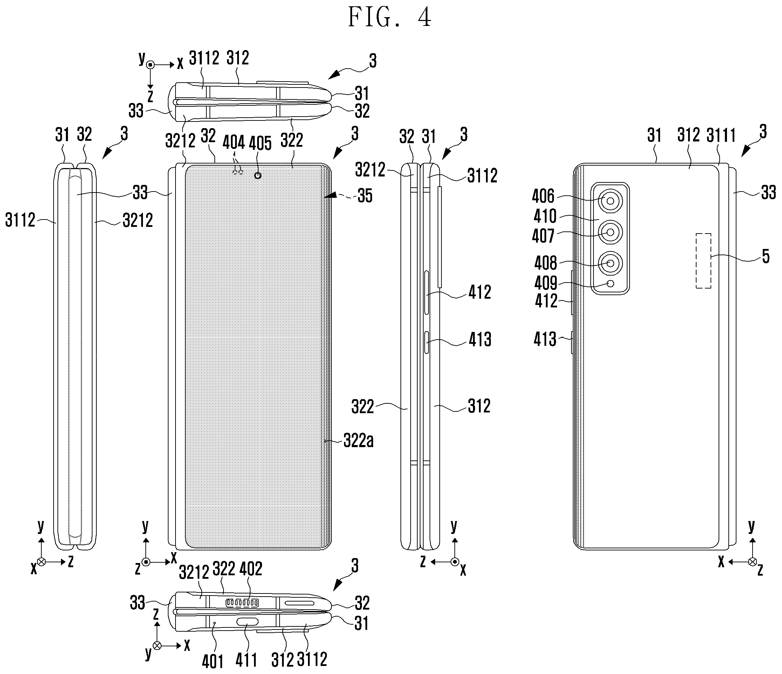

FIG. 3 are diagrams illustrating a foldable electronic device 3 in an unfolded state (or unfolding state, or flat state) according to an embodiment of the present disclosure. FIG. 4 are diagrams illustrating a foldable electronic device 3 in a folded state (or folding state) according to an embodiment of the present disclosure.

With reference to FIGS. 3 and 4, the foldable electronic device 3 may include a foldable housing 30, a first display module (e.g., a flexible display module or a foldable display module) 34, and/or a second display module 35. In various embodiments, the foldable electronic device 3 may be the electronic device 101 of FIG. 1.

According to an embodiment, the foldable housing 30 may include a first housing (or a first housing portion or a first housing structure) 31, a second housing (or a second housing portion or a second housing structure) 32, a hinge housing 33, and/or a hinge portion (not shown separately). The first housing 31 and the second housing 32 may be connected through the hinge portion and may be rotatable corresponding to each other with respect to the hinge portion. The hinge portion may include one or more hinges or hinge modules (or hinge assemblies).

According to an embodiment, the display area 34A of the first display module 34 may include a first display area (or first active area or first screen area) ①, a second display area (or second active area or second screen area) ②, and a third display area (or third active area or third screen area) ③ as active areas of the first display module 34 capable of displaying an image. The first display area ① may be positioned corresponding to the first housing 31. The second display area ② may be positioned corresponding to the second housing 32. The third display area ③ may be a portion connecting the first display area ① and the second display area ② of the first display module 34. The third display area ③ may be positioned corresponding to a hinge portion. The first display area ① may be disposed in the first housing 31, and the shape of the first display area ① may be maintained by the support of the first housing 31. The second display area ② may be disposed in the second housing 32, and the shape of the second display area ② may be maintained by the support of the second housing 32. The first display area ① and the second display area ② may be provided substantially flat, for example. The unfolded state of the foldable electronic device 3 may be a state in which the third display area ③ is disposed substantially flat.

According to an embodiment, in the unfolded state of the foldable electronic device 3, the first display area ① and the second display area ② may form an angle of about 180 degrees, and the display area 34A including the first display area ①, the second display area ②, and the third display area ③ may be provided (or disposed) in a substantially flat form. Because of the relative positions between the first display area ① disposed in the first housing 31 and the second display area ② disposed in the second housing 32 in the unfolded state of the foldable electronic device 3, the third display area ③ connecting the first display area ① and the second display area ② may be disposed substantially flat. For example, in the unfolded state of the foldable electronic device 3, the third display area ③ may be pulled from both sides by the first display area ① and the second display area ②, and the pulling force may be provided so as to reduce damage to the third display area ③ while flatly disposing the third display area ③. For example, the third display area ③ may be provided with an extended width so as to be flatly disposed while reducing stress caused by being pulled by the first display area ① and the second display area ② in the unfolded state of the foldable electronic device 3.

The coordinate axes are illustrated on the basis of the first housing 31, and for example, the +z-axis direction may be interpreted as the direction in which the flat first display area ① of the foldable electronic device 3 faces, the y-axis direction may be interpreted as the direction parallel to the center line A of the foldable electronic device 3, and the x-axis direction may be interpreted as the direction perpendicular to the center line A of the foldable electronic device 3.

According to an embodiment, in the unfolded state of the foldable electronic device 3, the hinge portion may support the third display area ③. In the unfolded state of the foldable electronic device 3 , when an external force (e.g., external pressure such as a touch input using a user's finger or a touch input using an electronic pen) is applied to the third display area ③, the hinge portion may contribute to reducing the sagging phenomenon of the third display area ③ so that the third display area ③ can be maintained flat. When an external impact is applied to the foldable electronic device 3 in the unfolded state because of a reason such as a drop, the hinge portion may be configured to reduce the impact of the external impact on the third display area ③. The hinge portion may support the third display area 3 such that the third display area 3 can be disposed flatly without sagging in the unfolded state of the foldable electronic device 3, thereby reducing the phenomenon of creasing.

According to an embodiment, the foldable electronic device 3 may be provided in an infolding manner in which the display area 34A of the first display module 34 is folded inward. A surface of the foldable electronic device 3 on which the display area 34A of the first display module 34 is visible may be interpreted as the 'front surface of the foldable electronic device 3', and a surface of the foldable electronic device 3 facing in the opposite direction from the front surface of the foldable electronic device 3 may be interpreted as the 'rear surface of the foldable electronic device 3'. The foldable electronic device 3 may be configured such that the front surface or the first display module 34 may be folded inward.

According to an embodiment, FIG. 4 illustrates a fully folded state of the foldable electronic device 3 in which the first housing 31 and the second housing 32 are disposed so that they no longer come close to each other. In the fully folded state of the foldable electronic device 3, the first display area ① and the second display area ② may be positioned to face each other, and the third display area ③ may be disposed in a bended form. In the fully folded state of the foldable electronic device 3, the angle between the first housing 31 and the second housing 32 (or the angle between the first display area ① and the second display area ② may be about 0 degree to about 10 degrees, and the display area 34A may be substantially invisible. Although not illustrated, the intermediate state of the foldable electronic device 3 may be a state between the unfolded state and the fully folded state, or a less folded state compared to the fully folded state. For example, in the case of an intermediate state in which the angle between the first housing 31 and the second housing 32 is greater than a certain angle, a usage environment in which the user does not have substantial difficulty in using the display area 34A may be provided. Hereinafter, the 'folded state of the foldable electronic device 3' described in the present disclosure may refer to a fully folded state as opposed to an intermediate state of a less folded state.

According to an embodiment, when viewing the unfolded state of the foldable electronic device 3, the display area 34A of the first display module 34 may be provided in a symmetrical form with respect to the center line A of the foldable electronic device 3. The center line A may correspond to the middle of the width of the third display area ③ extended from the first boundary between the first display area ① and the third display area ③ to the second boundary between the second display area ② and the third display area ③ when viewing the unfolded state of the foldable electronic device 3. The third display area ③ disposed in a bended form in the folded state of the foldable electronic device 3 may be in a substantially symmetrical form with respect to the center line A of the foldable electronic device 3.

According to an embodiment, when viewing the unfolded state of the foldable electronic device 3, the display area 34A of the first display module 34 may be substantially rectangular. The display area 34A may include a first edge B1, a second edge B2, a third edge B3, and a fourth edge B4. The first edge B1 and the second edge B2 may be substantially parallel to the center line A. The third edge B3 may connect one end of the first edge B1 and one end of the second edge B2, and the fourth edge B4 may connect the other end of the first edge B1 and the other end of the second edge B2. The first display area ① may include the first edge B1, a portion of the third edge B3, and a portion of the fourth edge B4. The second display area ② may include a second edge B2, a portion of the third edge B3, and a portion of the fourth edge B4. The third display area ③ may include a portion of the third edge B3 and a portion of the fourth edge B4. In the folded state of the foldable electronic device 3, the first edge B1 and the second edge B2 may be substantially overlapped and aligned. In the folded state of the foldable electronic device 3, a portion of the third edge B3 included in the first display area ① and a portion of the third edge B3 included in the second display area ② may be substantially overlapped and aligned. In the folded state of the foldable electronic device 3, a portion of the fourth edge B4 included in the first display area ① and a portion of the fourth edge B4 included in the second display area ② may be substantially overlapped and aligned.

According to an embodiment, the first display module 34 may include a first border area (not shown separately) extended from the first display area ①. The combination of the first display area ① and the first border area of the first display module 34 may be defined or interpreted as a 'first area', and the first area may be disposed in the first housing 31. The first border area may be covered by the first housing 31 and may not be exposed to the outside. The first display module 34 may include a second border area (not shown separately) extended from the second display area ②. The combination of the second display area ② and the second border area of the first display module 34 may be defined or interpreted as a 'second area', and the second area may be disposed in the second housing 32. The second border area may be covered by the first housing 31 and not be exposed to the outside.

According to an embodiment, the first display module 34 may include a third border area (not shown separately) extending from the third display area ③. A combination of the third display area ③ and the third border area among the first display modules 34 may be defined or interpreted as a 'third area', and the third area may be positioned corresponding to the hinge portion. The third border area may be covered by a material (or member) disposed in the third border area and may not be exposed to the outside. The material disposed in the third border area may be exposed to the outside in an unfolded state of the foldable electronic device 3 to provide a portion of the appearance of the foldable electronic device 3. The material disposed in the third border area may include a flexible material that may reduce a decrease in the bendability of the third display area ③ (or the third area) when it is disposed in a bended form in a folded state of the foldable electronic device 3.

According to an embodiment, the first housing 31 may include a first frame (or a first frame structure or a first framework) 311, and/or a first cover 312 disposed on the first frame 311.

According to an embodiment, the first frame 311 may include a first support member 3111 and a first side (or a first side surface, a first lateral member, a first side surface structure, or a first side surface bezel structure) 3112. The support member 3111 and the first side 3112 may be connected. The first frame 311 may be provided in an integral form, for example, including the first support member 3111 and the first side 3112. The first support member 3111 may be referred to by various other terms such as a 'first bracket', a 'first support body ', a 'first support member', or a 'first support structure' as an internal structure positioned inside the foldable electronic device 3 corresponding to the first housing 31. For example, the first display area ① may be disposed on the first support member 3111, and the first support member 3111 may support the first display area ①. The first display area ① and the first cover 312 may be positioned on opposite sides with the first support member 3111 interposed therebetween. The first side 3112 may be disposed to at least partially surround a space between the first display area ① and the first cover 312. The first side 3112 may be disposed along an edge of the first display area ① of the first display module 34. The first side 3112 may provide a first side surface of the foldable electronic device 3 corresponding to the first display area ① of the foldable electronic device 3. The first display area ① may provide one surface (e.g., the first front surface or the first front surface area) of an outer surface of the foldable electronic device 3, and the first cover 312 may provide the other surface (e.g., the first rear surface or the first rear surface area) of the outer surface of the foldable electronic device 3 facing in a direction substantially opposite to the first display area ①. The first cover 312 may be referred to as a 'first rear cover' as an element that provides at least a portion of the first rear surface corresponding to the first housing 31 of the rear surface of the foldable electronic device 3. Various electrical components (or electronic parts), such as printed circuit boards or batteries, may be disposed on the first support 3111 between the first support 3111 and the first cover 312.

According to an embodiment, the second housing 32 may include a second frame (or a second frame structure or a second framework) 321, and/or a second cover 322 disposed on the second frame 321.

According to an embodiment, the second frame 321 may include a second support member 3211 and a second side (or a second side surface, a second lateral member, a second side surface structure, or a second side surface bezel structure) 3212. The support member 3211 and the second side 3212 may be connected. The second frame 321 may be provided in an integral form, for example, including the second support member 3211 and the second side 3212. The second support member 3211 may be referred to by various other terms such as a 'second bracket', a 'second support body', a 'second support member', or a 'second support structure' as an internal structure positioned inside the foldable electronic device 3 corresponding to the second housing 32. For example, the second display area ② may be disposed on the second support member 3211, and the second support member 3211 may support the second display area . The second display area ② and the second cover 322 may be positioned on opposite sides with the second support member 3211 therebetween. The second side 3212 may be disposed to at least partially surround a space between the second display area ② and the second cover 322. The second side 3212 may be disposed along the edge of the second display area ② of the first display module 34. The second side 3212 may provide a second side surface of the foldable electronic device 3 corresponding to the second display area ② of the foldable electronic device 3. The second display area ② may provide one surface (e.g., the second front surface or the second front surface area) of the outer surface of the foldable electronic device 3, and the second cover 322 may provide the other surface (e.g., the second rear surface or the second rear surface area) of the outer surface of the foldable electronic device 3 facing in a direction substantially opposite to the second display area . The second cover 322 may be referred to as a 'second rear cover' as an element that provides at least a portion of the second rear surface corresponding to the second housing 32 of the rear surface of the foldable electronic device 3. Various electrical components (or electronic parts), such as printed circuit boards or batteries may be disposed on the second support 3211 between the second support 3211 and the second cover 322.

According to an embodiment, the foldable electronic device 3 may include one or more flexible printed circuit boards (not shown separately) disposed across the hinge portion. The one or more flexible printed circuit boards may electrically connect a first electrical element (e.g., a first printed circuit board (not shown separately)) disposed on a first frame 311 and a second electrical element (e.g., a second printed circuit board (not shown separately)) disposed on a second frame 321.

According to various embodiments, the foldable electronic device 3 may further include a first inner support (not shown separately) disposed or coupled to the first frame 311. For example, the first inner support may be positioned between the first cover 312 and the first support portion 3111 of the first frame 311. The first inner support may be disposed on or coupled to the first support portion 3111 through various methods, such as screw fastening. The first inner support may cover and protect a component, such as a first printed circuit board (not shown separately) or a first battery (not shown separately), disposed between the first support portion 3111 and the first cover 3112. In various embodiments, the first frame 311 may be referred to as a 'first front case' and the first internal support may be referred to as a 'first rear case'.

According to various embodiments, the first inner support may include a non-metallic material, and a conductive pattern utilized as an antenna radiator may be disposed or included in the first inner support.

According to various embodiments, the foldable electronic device 3 may further include a second inner support (not shown separately) disposed or coupled to the second frame 321. For example, the second inner support may be positioned between the second cover 322 and the second support 3211 of the second frame 321. The second inner support may be disposed on or coupled to the second support 3211 in various ways, such as screw fastening. The second inner support may cover and protect a component, such as a second printed circuit board (not shown separately) or a second battery (not shown separately), disposed between the second support 3211 and the second cover 3212. In various embodiments, the second frame 321 may be referred to as a 'second front case' and the second inner support may be referred to as a 'second rear case'.

According to various embodiments, the second inner support may comprise a non-metallic material, and a conductive pattern utilized as an antenna radiator may be disposed or included in the second inner support.

According to an embodiment, the hinge housing (or hinge cover) 33 may be combined with a hinge module (not shown separately). When the foldable electronic device 3 is transitioned from an unfolded state to a folded state, because of a change in the relative position between the first frame 311 and the second frame 321 which are connected to each other through the hinge portion and a change in the state of the hinge portion (or hinge module) combined with the hinge housing 33, a gap between the first housing 31 and the second housing 32 on the opposite side of the third display area ③ of the first display module 34 may be opened, and the hinge housing 33 may be exposed to the outside through the opened gap. In the folded state of the foldable electronic device 3, the hinge housing 33 may become a portion of the exterior that covers the interior of the foldable electronic device 3. The hinge housing 33 may be more exposed to the outside in the completely folded state (see FIG. 4) than in the intermediate state of the foldable electronic device 3. When the foldable electronic device 3 is transitioned from the folded state to the unfolded state, because of a change in the relative position between the first frame 311 and the second frame 321 connected to each other through the hinge portion and a change in the state of the hinge portion (or hinge module) combined with the hinge housing 33, the gap between the first housing 31 and the second housing 32 on the opposite side of the third display area ③ of the first display module 34 may be closed, and the hinge housing 33 may be positioned in the inner space resulting from the combination of the first frame 311 and the second frame 321 and may not be exposed to the outside.

According to an embodiment, the second display module 35 may be disposed in a different direction from the first display module 34. The second display module 35 may, for example, provide a display area (or screen area) facing in the opposite direction from the second display area ② of the first display module 34.

According to an embodiment, the second cover 322 may include a light transmitting area (or opening) provided corresponding to the second display module 35, and the second display module 35 may be visually visible through the light transmitting area of the second cover 322. The second display module 35 may be provided in a form in which a transparent cover (a transparent plate that covers and protects the display, for example, a window) is omitted, and may be combined with the second cover 322 through an optically transparent adhesive material (for example, an optical clear adhesive (OCA), an optical clear resin (OCR), or a super view resin (SVR)).

According to various embodiments, the second display module 35 may be provided in a form including a second cover 322. In this case, the second cover 322 may be interpreted as being excluded from the foldable housing 30.

According to an embodiment, the foldable electronic device 3 may be configured to display an image through a second display module 35 instead of the first display module 34 in a folded state.

According to an embodiment, the first cover 312 may include a first curved area 312a that is seamlessly extended and curved toward the first display area ① corresponding to the first edge B1 of the display area 34A. The second cover 322 may include a second curved area 322a that is seamlessly extended and curved toward the second display area ② corresponding to the second edge B2 of the display area 24A. In the unfolded state or the folded state of the foldable electronic device 3, the first curved area 312a and the second curved area 322a may be provided symmetrically to each other on opposite sides, thereby contributing to an attractive appearance.

According to an embodiment, the second display module 35 may include a flexible display that can be bent and disposed along the second curved area 322a.

According to various embodiments, the first cover 312 may be provided substantially flat without the first curved area 312a. The second cover 322 may be provided substantially flat without the second curved area 322a. In this case, the second display module 35 may include a rigid display.

According to an embodiment, the foldable electronic device 3 may include one or more audio input modules (e.g., the input module 150 of FIG. 1), one or more audio output modules (e.g., the audio output module 155 of FIG. 1), one or more sensor modules (e.g., the sensor module 176 of FIG. 1), one or more camera modules (e.g., the first camera module 405, the second camera module 406, the third camera module 407, and/or the fourth camera module 408), one or more light-emitting modules (e.g., the light-emitting module 409), one or more connection terminals, one or more key input modules (e.g., the input module 150 of FIG. 1), and/or an antenna module 5. The foldable electronic device 3 may omit at least one of the components or additionally include other components. The positions or numbers of the components included in the foldable electronic device 3 are not limited to the illustrated examples and may vary.

Any one of the one or more sound input modules may, for example, include a microphone (or microphone module) (not shown separately) positioned inside the foldable electronic device 3 corresponding to a microphone hole 401 provided on an exterior (e.g., a first side surface) of the foldable electronic device 3. The positions or numbers of microphones and microphone holes corresponding to the microphones are not limited to the illustrated examples and may vary. In various embodiments, the foldable electronic device 3 may include a plurality of microphones (not shown separately) used to detect a direction of sound.

One of the one or more audio output modules may, for example, include a first speaker (or a first speaker module) (not shown separately) for multimedia playback (or for recording playback) positioned inside the foldable electronic device 3 corresponding to a first speaker hole 402 provided on an exterior surface (e.g., a second side surface) of the foldable electronic device 3. Another one of the one or more audio output modules may, for example, include a second speaker (or a second speaker module) (e.g., a call receiver) (not shown separately) for calling positioned inside the foldable electronic device 3 corresponding to a second speaker hole (e.g., a receiver hole) 403 provided on an exterior surface (e.g., a first rear surface) of the foldable electronic device 3. The positions or numbers of the speakers and the speaker holes corresponding to the speakers are not limited to the illustrated examples and may vary. In various embodiments, the microphone hole and the speaker hole may be implemented as a single hole (not shown separately). In various embodiments, a piezo speaker in which the speaker hole is omitted may be provided (not shown separately).

Any one of the one or more sensor modules may include an optical sensor (or optical sensor module) 404 positioned in the inner space of the second housing 32 corresponding to the second cover 322. The optical sensor 404 may be positioned in alignment with an opening provided in the second display module 35 or may be at least partially inserted into the opening. External light may reach the optical sensor 404 through the second cover 322 and the opening provided in the second display module 35. The optical sensor 404 may include, for example, a proximity sensor or an illuminance sensor. The number or location of the optical sensors is not limited to the illustrated examples and may vary.

According to various embodiments, the optical sensor 404 may be positioned in the inner space of the second housing 32 so as to overlap with at least a portion of the display area of the second display module 35 when viewed from above the second cover 322. In this case, the optical sensor 404 or the location of the optical sensor 404 may be visually distinguished (or exposed) or invisible. The optical sensor 404 may be positioned, for example, on the rear surface of the second display module 35 or below or beneath the second display module 35. In various embodiments, the optical sensor 404 may be positioned aligned with or at least partially inserted into a recess provided in the rear surface of the second display module 35. A portion of the second display module 35 that at least partially overlaps with the optical sensor 404 may include a different pixel structure and/or wiring structure from other portions (not shown separately). For example, a portion of the second display module 35 that at least partially overlaps with the optical sensor 404 may have a different pixel density (e.g., number of pixels per unit area) from other portions. A pixel structure and/or wiring structure formed in a portion of the second display module 35 that at least partially overlaps with the optical sensor 404 may reduce light loss between the outside and the optical sensor 404. As another example, a plurality of pixels may not be disposed in a portion of the second display module 35 that at least partially overlaps with the optical sensor 404.

According to various embodiments, various other sensors (not shown separately), not limited to an optical sensor 404, such as a proximity sensor or an illuminance sensor, may be positioned corresponding to an opening provided in the second display module 35, or positioned on the rear surface of the second display module 35 or below or beneath the second display module 35. For example, an optical, electrostatic, or ultrasonic biometric sensor (e.g., a fingerprint sensor) may be positioned corresponding to an opening provided in the second display module 35, or positioned on the rear surface of the second display module 35 or below or beneath the second display module 35.

According to various embodiments, various sensors (or sensor modules) may be positioned corresponding to openings provided in the first display module 34, or positioned on the rear surface of the first display module 34, or below first display module 34 (not shown separately).

According to an embodiment, the first camera module 405 may be positioned in the inner space of the second housing 32 corresponding to the second cover 322. For example, the first camera module 405 may be positioned in alignment with an opening provided in the second display module 35 or may be at least partially inserted into the opening. External light may reach the first camera module 405 through the opening of the second cover 322 and the second display module 35. The opening of the second display module 35 aligned with or overlapping with the first camera module 405 may be provided in the form of a through hole, as in the illustrated example. In various embodiments, the opening of the second display module 35 aligned with or overlapping with the first camera module 405 may be provided as a notch (not illustrated separately).

According to various embodiments, the first camera module 405 may be positioned in the inner space of the second housing 32 so as to overlap with at least a portion of the display area of the second display module 35 when viewed from above the second cover 322. In this case, the first camera module 405 or the position of the first camera module 405 may be visually distinguished (or exposed) or invisible. The first camera module 405 may be positioned, for example, on the rear surface of the second display module 35 or below or beneath the second display module 35, and the first camera module 405 or the position of the first camera module 405 may be visually distinguished (or exposed) or invisible. In various embodiments, the first camera module 405 may be positioned in alignment with or at least partially inserted into a recess provided on the rear surface of the second display module 35. The first camera module 405 may include, for example, a hidden display rear camera (e.g., an under display camera (UDC)). A portion of the second display module 35 that at least partially overlaps with the first camera module 405 may include a different pixel structure and/or wiring structure from other portions (not shown separately). For example, a portion of the second display module 25 that at least partially overlaps with the first camera module 405 may have a different pixel density (e.g., number of pixels per unit area) from other portions. The pixel structure and/or wiring structure formed in a portion of the second display module 35 that at least partially overlaps with the first camera module 405 may reduce light loss between the outside and the first camera module 405. For another example, a plurality of pixels may not be disposed in a portion of the second display module 35 that at least partially overlaps with the first camera module 405.

According to an embodiment, the second camera module 406, the third camera module 407, or the fourth camera module 408 may be positioned in the inner space of the first housing 31 corresponding to the first cover 312. The first housing 21 or the first cover 312 may include a camera cover portion (e.g., a camera decoration portion) 410 disposed corresponding to the second camera module 406, the third camera module 407, and the fourth camera module 408. The camera cover portion 410 may include a camera hole (or light transmitting area) provided corresponding to the second camera module 406, a camera hole (or light transmitting area) provided corresponding to the third camera module 407, and a camera hole (or light transmitting area) provided corresponding to the fourth camera module 408. The number or location of camera modules provided in response to the first cover 312 is not limited to the illustrated example and may vary.

According to an embodiment, the second camera module 406, the third camera module 407, and the fourth camera module 408 may have different properties (e.g., angles of view) or functions. The second camera module 406, the third camera module 407, and the fourth camera module 408 may provide different angles of view (or lenses with different angles of view), and the foldable electronic device 3 may selectively use at least one camera module on the basis of a user's selection regarding the angle of view. Any one of the second camera module 406, the third camera module 407, and the fourth camera module 408 may include a wide-angle camera module, a telephoto camera module, a color camera module, a monochrome camera module, or an infrared (IR) camera (e.g., a time of flight (TOF) camera, a structured light camera) module. In various embodiments, the IR camera module may also operate as at least a portion of a sensor module.

According to an embodiment, the light emitting module 409 may be positioned in the inner space of the first housing 31 corresponding to a flash hole (or light transmitting area) provided in the camera cover portion 310 of the first cover 312. The light emitting module 409 may include a light source for the second camera module 406, the third camera module 407, and/or the fourth camera module 408. The light emitting module 409 may include various light sources such as a light emitting diode (LED) or a xenon lamp.

According to various embodiments, any one of the one or more light-emitting modules (e.g., an LED, an IR LED, or a xenon lamp) (not shown separately) may be configured to provide status information of the foldable electronic device 3 in the form of light. In various embodiments, any one of the one or more light-emitting modules (not shown separately) may be positioned corresponding to the first front surface and may provide a light source that is linked to the operation of the first camera module 405.

According to an embodiment, one of the one or more connecting terminals may include a first connector (or connector module or interface terminal) (not illustrated separately) positioned inside the foldable electronic device 3 corresponding to a first connector hole 411 formed on an exterior (e.g., a first side surface) of the foldable electronic device 3. The first connector may be, for example, a universal serial bus (USB) connector or a high definition multimedia interface (HDMI) connector. The foldable electronic device 3 may transmit and/or receive data and/or power with an external electronic device electrically connected to the first connector. The positions or numbers of the first connector and the connector holes 411 corresponding to the first connector are not limited to the illustrated examples and may vary.

According to various embodiments, one of the one or more connecting terminals may include a second connector (or a second connector module or a second interface terminal) (not shown separately) positioned inside the foldable electronic device 3 corresponding to a second connector hole (not shown separately) formed on an exterior surface (e.g., a first side surface or a second side surface) of the foldable electronic device 3. For example, an external storage medium (e.g., a subscriber identity module (SIM) card or a memory card (e.g., a secure digital memory (SD) card)) may be connected to the second connector.

According to an embodiment, one of the one or more key input modules may include a first key 412 positioned on an exterior (e.g., a first side surface) of the foldable electronic device 3 and a key signal generating unit positioned inside the foldable electronic device 3 corresponding to the first key 412. Another one of the one or more key input modules may include a second key 413 positioned on the exterior of the foldable electronic device 3 and a key signal generating unit positioned inside the foldable electronic device 3 corresponding to the second key 413. The positions or number of the keys are not limited to the illustrated examples and may vary.

According to an embodiment, the antenna module 5 may be positioned inside the foldable electronic device 3 corresponding to the first cover 312. The foldable electronic device 3 may transmit an electromagnetic signal (or a radio signal, an RF signal, a radio wave, or an electromagnetic wave) to the outside of the foldable electronic device 3 through the antenna module 5. The electromagnetic signal from the antenna module 5 may penetrate the first cover 312 and proceed to the outside of the foldable electronic device 3. The foldable electronic device 3 may receive an electromagnetic signal from the outside of the foldable electronic device 3 through the antenna module 5. The electromagnetic signal from the outside of the foldable electronic device 3 may penetrate the first cover 312 and reach the antenna module 5.

According to various embodiments, the antenna module 5 may be disposed at various other locations facing the foldable housing 30 (not shown separately).

According to various embodiments, the foldable electronic device 3 may include a detachable pen input device (e.g., an electronic pen, a digital pen, or a stylus pen) (not shown separately). The pen input device may, for example, be implemented so as to be inserted into an inner space of the first housing 31 or the second housing 32. As another example, the pen input device may be detachably attached to a hinge housing 33. The hinge housing 33 may include a recess, and the pen input device may be fitted into the recess.

The foldable electronic device 3 may further include various components depending on its provision form. These components are not all listed because they are modified in various ways depending on the convergence trend of the foldable electronic device 3, but components equivalent to the above-mentioned components may be additionally included in the foldable electronic device 3. In various embodiments, specific components may be excluded from the above-mentioned components or replaced with other components depending on their provision form.

According to various embodiments, the present disclosure illustrates, but is not limited to, a foldable electronic device 3. The scope of various embodiments of the present disclosure may be applied to bar type or plate type electronic devices, slidable electronic devices, stretchable electronic devices, and/or rollable electronic devices.

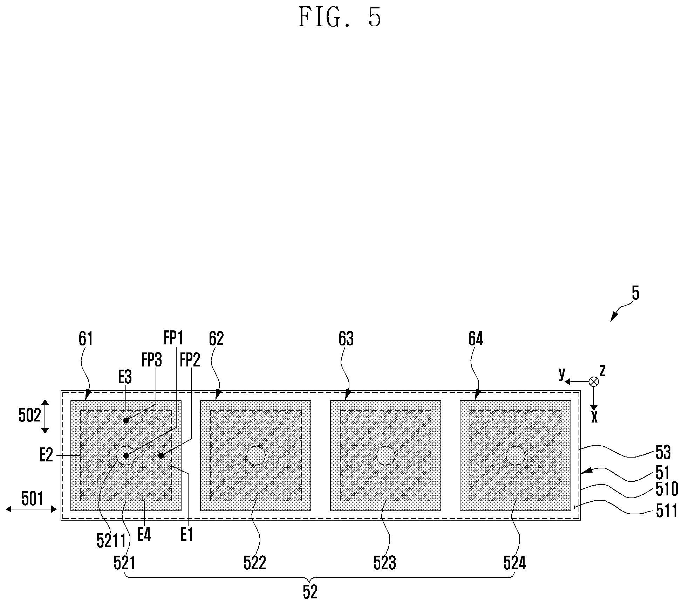

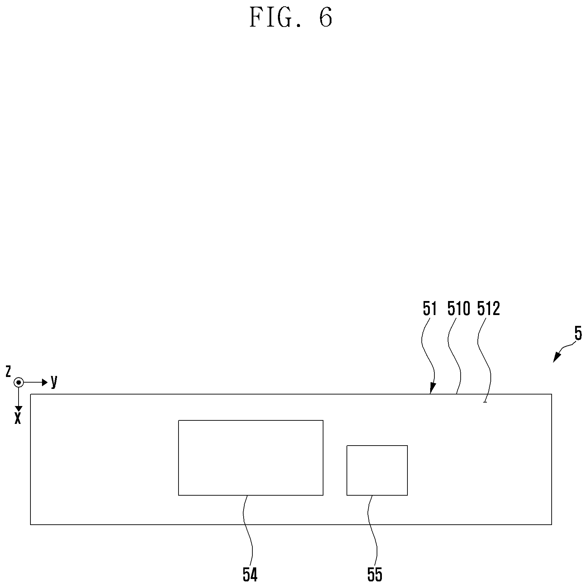

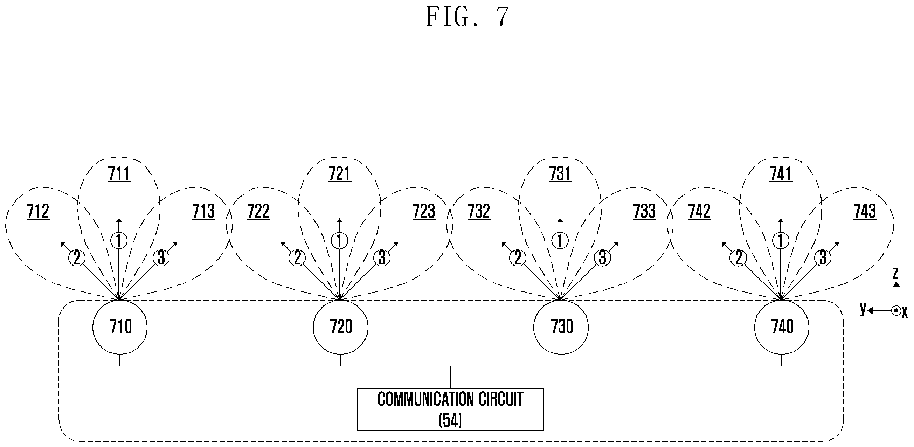

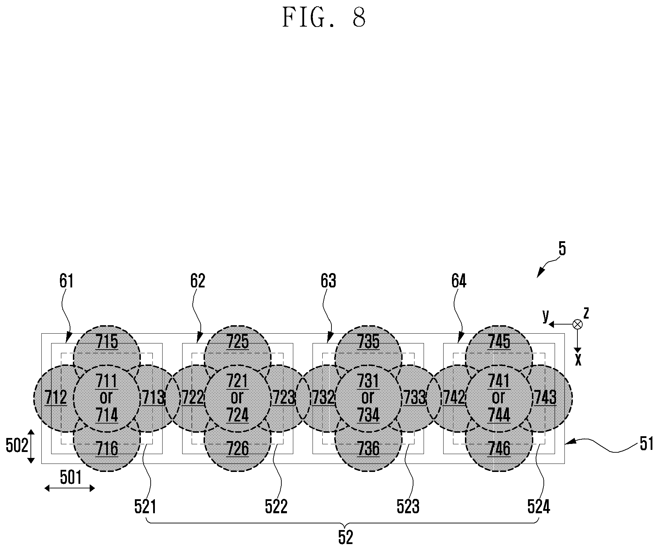

FIGS. 5 and 6 are diagrams illustrating an antenna module 5 according to an embodiment of the present disclosure. FIGS. 7 and 8 are diagrams illustrating beam patterns generated from an antenna module 5 according to an embodiment of the present disclosure.

With reference to FIGS. 5, 6, 7, and 8, the antenna module 5 may include an antenna structure 51, a communication circuit (or wireless communication circuit) 54, a power management circuit 55, a first dielectric 61, a second dielectric 62, a third dielectric 63, and/or a fourth dielectric 64.

According to various embodiments, the antenna module 5 may be the third antenna module 246 of FIG. 2.

According to an embodiment, the antenna structure 51 may include a printed circuit board 510. The printed circuit board 510 may include a first surface 511 and a second surface 512 facing in an opposite direction from the first surface 511. The first surface 511 and the second surface 512 may be, for example, substantially parallel.

According to an embodiment, the first surface 511 of the printed circuit board 510 may face the first cover 312 (see FIG. 3). A second surface 512 of the printed circuit board 510 may face the first display area ① of the first display module 34.

According to an embodiment, the printed circuit board 510 may include a plurality of pattern layers (not shown separately) including conductive patterns, and a plurality of non-conductive layers (e.g., insulting layers) (not shown separately) stacked in alteration with the plurality of pattern layers.

According to an embodiment, the printed circuit board 510 may include a plurality of conductive vias (not shown separately). A conductive via may be a conductive hole provided to allow for disposition of a connecting wire for electrically connecting conductive patterns of different pattern layers. The conductive via may, for example, include a plated through hole (PTH), a laser through hole (LVH), a buried through hole (BVH), or a stacked via. At least one conductive via may, for example, electrically connect signal line patterns (e.g., patterns of conductive lines utilized as electrical paths) included in different pattern layers as a portion of a signal line. At least one conductive via may, for example, electrically connect ground planes (or ground areas or ground patterns) included in different pattern layers.

According to an embodiment, the printed circuit board 510 may include an antenna array 52. For example, the antenna array 52 may be implemented as some conductive patterns among a plurality of pattern layers included in the printed circuit board 510. The antenna array 52 may be disposed on the first surface 511 or may be disposed within the printed circuit board 510 closer to the first surface 511 than to the second surface 512. The antenna array 52 may include a plurality of antenna elements 521, 522, 523, 524, and 525. The plurality of antenna elements 521, 522, 523, and 524 may, for example, be the antenna 248 of FIG. 2.

According to an embodiment, the plurality of antenna elements 521, 522, 523, and 524 may have substantially the same shape and may be disposed at a predetermined interval. The plurality of antenna elements 521, 522, 523, and 524 may be disposed in a sixth direction 501 (e.g., the y-axis direction) when viewed from above the first surface 511 (e.g., when viewed in the +z-axis direction). The sixth direction 501 may, for example, be substantially parallel to the center line A of the foldable electronic device 3 (see FIG. 3).

According to various embodiments, the plurality of antenna elements 521, 522, 523, and 524 may be disposed in a seventh direction 502 (e.g., the x- axis direction) that is perpendicular to the sixth direction 501 when viewed from above the first surface 511.

According to an embodiment, when viewed from above the first surface 511 (e.g., when viewed in the +z-axis direction), the plurality of antenna elements 521, 522, 523, and 524 may be substantially square. For example, the first antenna element 521 may include a first edge E1, a second edge E2, a third edge E3, and a fourth edge E4 when viewed from above the first surface 511. When viewed from above the first surface 511, the first edge E1 and the second edge E2 may be spaced apart from each other in a sixth direction 501 and may be substantially parallel to each other. When viewed from above the first surface 511, the third edge E3 and the fourth edge E4 may be spaced apart from each other in the seventh direction 502 and may be substantially parallel to each other. The remaining antenna elements 522, 523, and 524 may have substantially the same shape as the first antenna element 521. The shapes of the plurality of antenna elements 521, 522, 523, and 524 are not limited thereto and may vary. The plurality of antenna elements 521, 522, 523, and 524may, for example, be provided in various polygonal shapes, such as a circle, an ellipse, or a triangle (not shown separately).

According to various embodiments, the number or location of antenna elements included in the antenna array 52 is not limited to the illustrated embodiment and may vary (not illustrated separately).

According to various embodiments, the number or location of the antenna arrays 52 is not limited to the illustrated embodiment and may vary (not illustrated separately).

According to an embodiment, the printed circuit board 510 may include a ground plane 53 that acts as an antenna ground. The ground plane 53 may contribute to securing antenna radiation performance (or radio transmission/reception performance or communication performance) and/or coverage with respect to the plurality of antenna elements 521, 522, 523, and 524. The ground plane 53 may reduce electromagnetic interference (EMI) (or signal loss) with respect to the plurality of antenna elements 521, 522, 523, and 524.

According to an embodiment, the ground plane 53 may be disposed closer to the second surface 512 of the printed circuit board 512 than the antenna array 52. When viewed from above the first surface 511 of the printed circuit board 510 (e.g., when viewed in the +z-axis direction), the antenna array 52 may at least partially overlap with the ground plane 53. For example, the antenna array 52 may be included in a first pattern layer (not shown separately) of the printed circuit board 510, and the ground plane 53 may be included in a second pattern layer (not shown separately) closer to the second surface 512 than the first pattern layer.

According to an embodiment, the antenna structure 51 may operate as a patch antenna. When the communication circuit 54 provides (or feedings) an electromagnetic signal (or a radio signal, an RF signal, or a radiated current) to the plurality of antenna elements 521, 522, 523, and 524, the antenna structure 51 may operate as a resonator (e.g., a patch antenna) because the plurality of antenna elements 521, 522, 523, and 524 act as radiating elements while resonating with the ground plane 53. The plurality of antenna elements 521, 522, 523, and 524 may be interpreted as a plurality of patches.

According to an embodiment, the plurality of antenna elements 521, 522, 523, and 524 may be included in a single pattern layer (not shown separately) among the plurality of pattern layers included in the printed circuit board 510 (e.g., a single layer patch structure). For example, the plurality of antenna elements 521, 522, 523, and 524 may be directly fed from the communication circuit 54.

According to various embodiments, the printed circuit board 510 may further include a plurality of dummy antenna elements (e.g., dummy patches) (not shown separately) (e.g., a stacked patch structure). The plurality of dummy antenna elements may be positioned to overlap with the plurality of antenna elements 521, 522, 523, and 524 one-to-one when viewed from above the first surface 511 and may be electrically floating. One pattern layer including the plurality of dummy antenna elements may be positioned closer to the first surface 511 than another pattern layer including the plurality of antenna elements 521, 522, 523, and 524. The communication circuit 54 may provide (or feeding) an electromagnetic signal (or a radio signal, an RF signal, or a radiated current) to a plurality of antenna elements 521, 522, 523, and 524, and the dummy antenna elements may be indirectly fed from the plurality of antenna elements 521, 522, 523, and 524. The plurality of antenna elements 521, 522, 523, and 524 may be interpreted as a plurality of feeding antenna elements. The plurality of dummy antenna elements may be electromagnetically coupled with the plurality of antenna elements 521, 522, 523, and 524 to act as part of a radiator and adjust radiation features. The plurality of dummy antenna elements may, for example, shift a resonant frequency of the antenna module 5 to a specified frequency or by a specified amount. A plurality of dummy antenna elements may, for example, expand the bandwidth through which an electromagnetic signal can be transmitted or received through the antenna module 5 or form different frequency bands (e.g., multi-bands). A plurality of dummy antenna elements may, for example, improve antenna performance by reducing electromagnetic noise.

According to various embodiments, the printed circuit board 510 may further include a plurality of feeding antenna elements (not shown) that at least partially overlap with the plurality of antenna elements 521, 522, 523, and 524 and are physically separated from the plurality of antenna elements 521, 522, 523, and 524 when viewed from above the first surface 511 (e.g., a stacked patch structure). A pattern layer including the plurality of antenna elements 521, 522, 523, and 524 may be positioned closer to the first surface 511 than a pattern layer including the plurality of feeding antenna elements. A communication circuit 54 may provide (or feeding) an electromagnetic signal (or a radio signal, an RF signal, or a radiated current) to a plurality of feeding antenna elements, and the plurality of antenna elements 521, 522, 523, and 524 may be indirectly fed from the plurality of feeding antenna elements. The plurality of antenna elements 521, 522, 523, and 524 may be interpreted as a plurality of dummy antenna elements.

According to an embodiment, the communication circuit 54 may be disposed on the second surface 512 of the printed circuit board 510 through a conductive adhesive material (or conductive bonding material) such as solder. The communication circuit 54 may be electrically connected to the plurality of antenna elements 521, 522, 523, and 524 through wires (or electrical paths) included in the printed circuit board 510.

According to an embodiment, the communication circuit 54 may include a radio frequency integrated circuit (RFIC). The communication circuit 54 may be, for example, the third RFIC 226 of FIG. 2.

According to various embodiments, the communication circuit 54 may be disposed on a printed circuit board different from the printed circuit board 510 (e.g., a printed circuit board on which components such as the processor 120, the memory 130, or the communication module 190 of FIG. 1 are disposed). For example, the communication circuit 54 may be omitted from the antenna module 5.

According to an embodiment, the communication circuit 54 may up-convert or down-convert the frequency of a signal being transmitted or received. For example, the communication circuit 54 may receive an intermediate frequency (IF) signal from a wireless communication circuit (e.g., the wireless communication module 192 of FIG. 1) disposed on another printed circuit board, and up-convert the received IF signal to a radio frequency (RF) signal (e.g., a millimeter wave). As another example, the communication circuit 54 may down-convert an RF signal received through the antenna array 52 to an IF signal , and the IF signal may be provided to a wireless communication circuit (e.g., the wireless communication module 192 of FIG. 1) disposed on another printed circuit board.

According to an embodiment, the communication circuit 54 may transmit and/or receive signals of substantially the same frequency band (or frequency) through a plurality of antenna elements 521, 522, 523, and 524.

According to an embodiment, the communication circuit 54 may transmit and/or receive signals in at least a portion of a frequency band from about 3 GHz to about 100 GHz through a plurality of antenna elements 521, 522, 523, and 524.

According to an embodiment, the power management circuit 55 may be disposed on the second surface 512 of the printed circuit board 510 through a conductive adhesive material (or conductive bonding material), such as solder. The power management circuit 55 may be electrically connected to the communication circuit 54 or various other components (e.g., passive components) disposed on the printed circuit board 510 through wires (or electrical paths) included in the printed circuit board 510.

According to an embodiment, the power management circuit 55 may include a power management integrated circuit (PMIC).

According to various embodiments, the power management circuit 55 may be disposed on a printed circuit board different from the printed circuit board 510 (e.g., a printed circuit board on which components such as the processor 120, the memory 130, or the communication module 190 of FIG. 1 are disposed). For example, the power management circuit 55 may be omitted from the antenna module 5.

According to an embodiment, the antenna module 5 may be electrically connected to another printed circuit board (e.g., a printed circuit board on which components such as the processor 120, the memory 130, or the communication module 190 of FIG. 1 are disposed) through an electrical connection member (not shown separately) such as a flexible printed circuit board. For example, one end of the electrical connection member (not shown separately) may be electrically connected to a connector (e.g., an FPCB connector) (not shown separately) disposed on the second surface 512, and the other end of the electrical connection member may be electrically connected to a connector disposed on another printed circuit board. As another example, one end of the electrical connection member (not shown separately) may be electrically connected to conductive terminals (e.g., lands or copper pads) provided on the second surface 512 through a conductive adhesive material (or a conductive bonding material) such as solder.

According to various embodiments, the antenna module 5 may further include a shielding member (or electromagnetic shielding member) (not shown) surrounding at least one of the communication circuit 54 and/or the power management circuit 55. The shielding member may reduce electromagnetic interference (e.g., electromagnetic noise) regarding the communication circuit 54 and/or the power management circuit 55. The shielding member may include a conductive member, such as a shield can, for example. As another example, the shielding member may include a protective member, such as a urethane resin, and a conductive paint, such as an electromagnetic interference (EMI) paint, applied to an outer surface of the protective member. In various embodiments, the shielding member may be provided as various shielding sheets.

According to various embodiments, the antenna module 5 may further include a frequency tuning circuit (not shown) disposed on a printed circuit board 510. The frequency tuning circuit may include, for example, a tuner or a passive element. The frequency tuning circuit may shift the impedance matching, or resonant frequency, to a specified frequency or by a specified amount.

According to an embodiment, the first dielectric 61, the second dielectric 62, the third dielectric 63, and/or the fourth dielectric 64 may be disposed on or coupled to a first surface 511 of a printed circuit board 510. For example, the first dielectric 61 may be positioned corresponding to the first antenna element 521. When viewed from above the first surface 511, the first dielectric 61 may overlap with the first antenna element 521. For example, the second dielectric 62 may be positioned corresponding to the second antenna element 522. When viewed from above the first surface 511, the second dielectric 62 may overlap with the second antenna element 522. For example, the third dielectric 63 may be positioned corresponding to the third antenna element 523. When viewed from above the first surface 511, the third dielectric 63 may overlap with the third antenna element 523. For example, the fourth dielectric 64 may be positioned corresponding to the fourth antenna element 524. When viewed from above the first surface 511, the fourth dielectric 64 may overlap with the fourth antenna element 524.

According to an embodiment, the first dielectric 61, the second dielectric 62, the third dielectric 63, and the fourth dielectric 64 may be provided in substantially the same form.

According to an embodiment, the first dielectric 61, the second dielectric 62, the third dielectric 63, and the fourth dielectric 64 may include non-conductive materials. With respect to a frequency (e.g., a resonant frequency) of an electromagnetic signal transmitted and/or received through the antenna module 5, the first dielectric 61, the second dielectric 62, the third dielectric 63, and the fourth dielectric 64 may have a relative permittivity that is greater than that of a conductor having a relative permittivity being substantially 1.

According to an embodiment, the antenna module 5 may include a first electrical path (or a first conductive path) (not shown) for transmitting an electromagnetic signal (or a radio signal, an RF signal, or a radiated current) to the first dielectric 61. A first end of the first electrical path may be electrically connected to a communication circuit 54. A second end of the first electrical path may be in physical contact with or directly connected to the first dielectric 61. A portion of the first dielectric 61 through which the electromagnetic signal is transmitted from the second end of the first electrical path may be defined or interpreted as a first feeding portion FP1. In some embodiments, the first electrical path, or the second end of the first electrical path, may be defined or interpreted as a 'first feeding portion ', and the portion of the first dielectric 61 through which an electromagnetic signal is transmitted from the second end of the first electrical path may be defined or interpreted as a 'first feeding area' or a 'first feeding point'. The provision of an electromagnetic signal by a communication circuit (e.g., the communication circuit 54 of FIG. 6) to a first feeding portion FP1 (or a first electrical path, a first feeding area, or a first feeding point) may be defined or interpreted as a 'first feeding'.

According to various embodiments, the first electrical path may be interpreted as a first transmission line or a first feeding line along which an electromagnetic signal (or a radio signal, an RF signal, or a radiated current) is transmitted.

According to an embodiment, when the communication circuit 54 transmits (or feedings) an electromagnetic signal (or a radio signal, an RF signal, or a radiated current) through the first electrical path, the first dielectric 61 may operate as a first dielectric resonator (or a first dielectric resonator antenna (DRA)). When the communication circuit 54 transmits (or feedings) an electromagnetic signal through the first electrical path, the first dielectric resonator may be provided because of a discontinuity between the first dielectric 61 and a medium in contact with (or surrounding) the first dielectric 61. The medium in contact with (or surrounding) the first dielectric 61 may include, for example, air. When the first dielectric 61 contacts the first cover 312 (see FIG. 3), the medium in contact with the first dielectric 61 (or surrounding the first dielectric 61) may include a first cover 312.

According to various embodiments, the second end of the first electrical path may be indirectly connected to the first dielectric 61. For example, another dielectric (not shown separately) may be disposed between the second end of the first electrical path and the first dielectric 61, and the first dielectric 61 may indirectly receive an electromagnetic signal from the second end through the other dielectric. A combination of the first dielectric 61 and the other dielectric may be defined or interpreted as a dielectric resonator, and the first feeding portion FP1 may be included in the other dielectric.

According to an embodiment, the first electrical path may be included in a printed circuit board 510.

According to various embodiments, the first electrical path may include a first partial electrical path (or first partial conductive path) (not shown separately), and a second partial electrical path (or second partial conductive path) (not shown separately) electrically connected to the first partial electrical path. For example, the first partial electrical path may be included in the printed circuit board 510. For example, the second partial electrical path may be included in a separate structure (or member) (not shown separately) disposed on or coupled to the printed circuit board 510 (e.g., the first surface 511 of the printed circuit board 510).

According to an embodiment, the first electrical path may be physically separated from the plurality of antenna elements 521, 522, 523, and 524.

According to an embodiment, the first antenna element 521 may include an opening 5211 corresponding to a first electrical path. The first electrical path may penetrate the opening 5211.

According to an embodiment, the opening 5211 may be provided at the center of the first antenna element 521. When viewed from above the first surface 511, a distance at which the opening 5211 is spaced apart from the first edge E1 in the sixth direction 501 and a distance at which the opening 5211 is spaced apart from the second edge E2 in the sixth direction 501 may be substantially the same. When viewed from above the first surface 511, a distance at which the opening 5211 is spaced apart from the third edge E3 in the seventh direction 502 and a distance at which the opening 5211 is spaced apart from the fourth edge E4 in the seventh direction 502 may be substantially the same.

According to an embodiment, when viewed from above the first surface 511, a distance at which the first feeding portion FP1 is spaced apart from the first edge E1 in the sixth direction 501 and a distance at which the first feeding portion FP1 is spaced apart from the second edge E2 in the sixth direction 501 may be substantially the same. When viewed from above the first surface 511, a distance at which the first feeding portion FP1 is spaced apart from the third edge E3 in the seventh direction 502 and a distance at which the first feeding portion FP1 is spaced apart from the fourth edge E4 in the seventh direction 502 may be substantially the same.

According to an embodiment, the printed circuit board 510 may include a second electrical path (not shown) for transmitting an electromagnetic signal (or a radio signal, an RF signal, or a radiated current) to the first antenna element 521. The second electrical path may electrically connect the first antenna element 521 and the communication circuit 54. The portion of the first antenna element 521 through which the electromagnetic signal is transmitted from the second electrical path may be defined or interpreted as a second feeding portion FP2. In some embodiments, the second electrical path, or the portion of the second electrical path connected to the first antenna element 521, may be defined or interpreted as a 'second feeding portion', and the portion of the first antenna element 521 through which the electromagnetic signal is transmitted from the second electrical path may be defined or interpreted as a 'second feeding area' or a 'second feeding point'. The provision of an electromagnetic signal by a communication circuit (e.g., the communication circuit 54 of FIG. 6) to a second feeding portion FP2 (or a second electrical path, a second feeding area, or a second feeding point) may be defined or interpreted as a 'second feeding'.

According to various embodiments, the second electrical path may be interpreted as a second transmission line or a second feeding line along which an electromagnetic signal (or a radio signal, an RF signal, or a radiated current) is transmitted.

According to an embodiment, when viewed from above the first surface 511, the second feeding portion FP2 may be positioned between the opening 5211 (or the first feeding portion FP1) and the first edge E1.

According to an embodiment, when viewed from above the first surface 511, the second feeding portion FP2 may be positioned closer to the first edge E1 than the opening 5211 (or the first feeding portion FP1).

According to various embodiments, the second feeding portion FP2 may be substantially positioned at the first edge E1 (not shown separately).

According to an embodiment, when the communication circuit 54 provides (or feedings) an electromagnetic signal (or a radio signal, an RF signal, or a radiated current) to the second feeding portion FP2 through the second electrical path, a signal having a first linear polarization may be radiated from the first antenna element 521. When the communication circuit 54 provides an electromagnetic signal to the feeding portion FP2, a first linear polarization having a first polarization direction may be radiated by a current path (or a distribution of surface current) on the first antenna element 521. The first linear polarization may be an electromagnetic wave that propagates while oscillating in the first polarization direction. The first linear polarization may be interpreted as a polarity direction of an electric field with respect to a propagation direction (or transmission direction) of an electromagnetic wave radiated (or transmitted) from the first antenna element 521. The first polarization direction is a direction in which the electric field oscillates (or a direction parallel to a vector of the electric field) and may be perpendicular to the propagation direction of the electromagnetic wave. The propagation direction of the electromagnetic wave may be a direction in which a plane of the first antenna element 521 in the form of a flat plate (or plane) faces (for example, a -z-axis direction in which a first surface 511 of a printed circuit board 510 faces).

According to an embodiment, the first polarization direction of the first linear polarization radiated from the first antenna element 521 when fed by the second feeding portion FP2 may be substantially in the sixth direction 501.

According to an embodiment, the printed circuit board 510 may include a third electrical path (not shown) for transmitting an electromagnetic signal (or a radio signal, an RF signal, or a radiated current) to the first antenna element 521. The third electrical path may electrically connect the first antenna element 521 and the communication circuit 54. A portion of the first antenna element 521 through which the electromagnetic signal is transmitted from the third electrical path may be defined or interpreted as a third feeding portion FP3. In some embodiments, the third electrical path, or a portion of the third electrical path connected to the first antenna element 521, may be defined or interpreted as a 'third feeding portion', and a portion of the first antenna element 421 through which the electromagnetic signal is transmitted from the third electrical path may be defined or interpreted as a 'third feeding area' or a 'third feeding point'. The provision of an electromagnetic signal by a communication circuit (e.g., the communication circuit 54 of FIG. 6) to a third feeding portion FP3 (or a third electrical path, a third feeding area, or a third feeding point) may be defined or interpreted as a 'third feeding'.

According to various embodiments, the third electrical path may be interpreted as a third transmission line or a third feeding line along which an electromagnetic signal (or a radio signal, an RF signal, or a radiated current) is transmitted.

According to an embodiment, when viewed from above the first surface 511, the third feeding portion FP3 may be positioned between the opening 5211 (or the first feeding portion FP1) and the third edge E1. When viewed from above the first surface 511, the second feeding portion FP2 and the third feeding portion FP3 may form, for example, a substantially 90 degree angle with respect to the opening 5211 (or the first feeding portion FP1).

According to an embodiment, when viewed from above the first surface 511, the third feeding portion FP3 may be positioned closer to the third edge E3 than the opening 5211 (or the first feeding portion FP1).

According to various embodiments, the third feeding portion FP3 may be substantially located at the third edge E3 (not shown separately).

According to an embodiment, when viewed from above the first surface 511, the distance at which the third feeding portion FP3 is spaced from the third edge E3 in the seventh direction 502 may be substantially equal to the distance at which the second feeding portion FP2 is spaced from the first edge E1 in the sixth direction 501.

According to an embodiment, when viewed from above the first surface 511, the distance at which the third feeding portion FP3 is spaced from the opening 5211 in the seventh direction 502 may be substantially equal to the distance at which the second feeding portion FP2 is spaced from the opening 5211 in the sixth direction 501.

According to an embodiment, when the communication circuit 54 provides (or feedings) an electromagnetic signal (or a radio signal, an RF signal, or a radiated current) to the third feeding portion FP3 through the third electrical path, a signal having a second linear polarization may be radiated from the first antenna element 521. When the communication circuit 54 provides an electromagnetic signal to the third feeding portion FP3, a second linear polarization having a second polarization direction (or oscillating in the second polarization direction) may be radiated by the current path (or distribution of surface current) on the first antenna element 521. The second polarization direction may be perpendicular to the propagation direction of the electromagnetic wave (e.g., -z axis direction).

According to an embodiment, the second polarization direction of the second linear polarization radiated from the first antenna element 521 when fed by the third feeding portion FP3 may be substantially in the seventh direction 502.

According to various embodiments, a single feeding portion may be provided to replace the second feeding portion FP2 and the third feeding portion FP3. The single feeding portion may be substantially located, for example, at a first corner (e.g., a first vertex) where the first edge E1 and the third edge E3 meet, a second corner (e.g., a second vertex) where the second edge E2 and the third edge E3 meet, a third corner (e.g., a third vertex) where the second edge E2 and the fourth edge E4 meet, or a fourth corner (e.g., a fourth vertex) where the first edge E1 and the fourth edge E4 meet, when viewed from above the first surface 511. For another example, a single feeding portion may be located between the opening 5211 (or the first feeding portion FP1) and the first corner, between the opening 5211 (or the first feeding portion FP1) and the second corner, between the opening 5211 (or the first feeding portion FP1) and the third corner, or between the opening 5211 (or the first feeding portion FP1) and the fourth corner, when viewed from above the first surface 511. When the communication circuit 54 provides (or feedings) an electromagnetic signal (or a radio signal, an RF signal, or a radiated current) to the feeding portion, the linear polarization radiated from the first antenna element 521 may have a polarization direction substantially parallel to a diagonal direction that forms a substantially 45 degree angle with respect to the sixth direction 501 or the seventh direction 502 when viewed from above the first surface 511. The linear polarization having a diagonal polarization direction may be interpreted as a composite of a first polarization component having a first polarization direction parallel to the sixth direction 501 and a second polarization component parallel to the seventh direction 502.

According to various embodiments, the shape of the first antenna element 521 and the position of the feeding portion are not limited to the illustrated example, and may be variously provided so as to radiate linear polarization corresponding to at least one selected or designated frequency band. The linear polarization may be interpreted as a composite of a first polarization component and a second polarization component each having a polarization direction that is perpendicular to each other.

According to various embodiments, the shape of the first antenna element 521 and the position of the feeding portion are not limited to the illustrated example, and may be variously provided so as to be able to radiate a circular polarization corresponding to at least one selected or designated frequency band. The circular polarization may be interpreted as a composite of a first polarization component and a second polarization component having polarization directions that are perpendicular to each other. When the phase difference between the first polarization component and the second polarization component is substantially 90 degrees, the composite of the first polarization component and the second polarization component may provide a composite wave having the feature of a circular polarization where an axial ratio is substantially close to 1.

According to various embodiments, the shape of the first dielectric 61 and the position or number of the first feeding portions FP1 are not limited to the illustrated example and may vary (not illustrated separately). For example, the antenna module 5 may include a plurality of first electrical paths physically connected to a plurality of first feeding portions (not illustrated separately) of the first dielectric 61.

According to various embodiments, the shape or position of the opening 5211 provided in the first antenna element 521 is not limited to the illustrated example and may vary (not illustrated separately). For example, the opening 5211 may be provided in a polygonal shape such as an oval or a triangle, not limited to the illustrated circular shape, when viewed from above the first surface 511. For another example, the opening 5211 may be replaced by a notch provided in the first edge E1, the second edge E2, the third edge E3, or the fourth edge E4.

According to various embodiments, the opening 5211 of the first antenna element 521 may be omitted. For example, the first feeding portion FP1 of the first dielectric 61 may be positioned in a portion of the first dielectric 61 that does not overlap with the first antenna element 521 when viewed from above the first surface 511.

According to an embodiment, a first radiating portion (or a first resonator or a first resonant portion ) 710 provided by a combination of a first dielectric resonator (or a first dielectric resonant portion) including a first dielectric 61 and a resonator (hereinafter, a 'first patch resonator' or ' a first patch resonant portion') including a first antenna element 521 may improve (e.g., expand) the coverage of the antenna module 5 or improve the antenna radiation performance of the antenna module 5 compared to a comparative example in which the first dielectric resonator is omitted.

According to an embodiment, the foldable electronic device 3 (see FIG. 3) may include a beamforming system (or a beamforming circuit) for the antenna module 5. The beamforming system may enable receiving a stronger signal in a desired direction, transmitting a signal in a desired direction, or preventing receiving a signal from an undesired direction. The beamforming system included in the communication circuit 54 may control the phase or amplitude of an electromagnetic signal (or a radio signal, an RF signal, or a radiated current) to adjust a beam pattern (e.g., shape and direction of the beam).

According to an embodiment, a processor (e.g., the processor 120 of FIG. 1) may determine a phase of an electromagnetic signal (or a radio signal, an RF signal, or a radiated current) provided to the first feeding portion FP1, the second feeding portion FP2, or the third feeding portion FP3 according to a frequency (or a frequency band) used by an application (or a program) on the basis of codebook information about beamforming stored in a memory (e.g., the memory 130 of FIG. 1). The communication circuit 54 of the antenna module 5 may adjust the phase of an electromagnetic signal provided to the first feeding portion FP1, the second feeding portion FP2, or the third feeding portion FP3 under the control of the processor. The communication circuit 54 of the antenna module 5 may efficiently control (e.g., allocate or dispose) a plurality of beams through a plurality of radiating portions (or resonators) included in the antenna module 5 under the control of the processor.

According to an embodiment, a second radiation field (or a second electromagnetic field) may be generated from the first patch resonator of the first radiating portion 710 when the communication circuit 54 has a second feeding that provides an electromagnetic signal (or a radio signal, RF signal, or radiated current) to the second feeding portion FP2.

According to an embodiment, the second radiation field generated during the second feeding to the second feeding portion FP2 may provide a first beam pattern 711 that can radiate or concentrate a relatively more electromagnetic wave energy (or wave energy) in a first direction ① substantially directed toward the first surface 511. The first direction ① may be substantially perpendicular to the sixth direction 501 and the seventh direction 502.

According to an embodiment, the second radiation field generated during the second feeding to the second feeding portion FP2 and the first beam pattern 711 provided by the second radiation field, for example, may correspond to a first linear polarization having a substantially first polarization direction (e.g., a substantially sixth direction 501).

According to an embodiment, when the communication circuit 54 has a first feeding providing an electromagnetic signal (or a radio signal, RF signal, or radiated current) to a first feeding portion FP1, and a second feeding providing an electromagnetic signal to a second feeding portion FP2, a first radiation field (or a first electromagnetic field) may be generated from a first dielectric resonator of the first radiating portion 710, and a second radiation field (or a second electromagnetic field) may be generated from a first patch resonator of the first radiating portion 710. Because of interference (e.g., constructive interference and/or destructive interference) between the first radiation field and the second radiation field, a second beam pattern 712 or a third beam pattern 713 may be provided, which is capable of radiating or concentrating a relatively more electromagnetic wave energy (or wave energy) in a direction different from the first direction ① (or tilted with respect to the first direction ①).

According to an embodiment, the communication circuit 54 may adjust the phase difference of the electromagnetic signal provided to the first feeding portion FP1 and the electromagnetic signal provided to the second feeding portion FP2. The interference between the first radiation field generated from the first dielectric resonator of the first radiating portion 710 and the second radiation field generated from the first patch resonator of the first radiating portion 710 may provide a second beam pattern 712 that can radiate or concentrate a relatively more electromagnetic wave energy (or wave energy) in a second direction ② different from the first direction ① because of the phase difference between the electromagnetic signals provided to the first feeding portion FP1 and the electromagnetic signals provided to the second feeding portion FP2. The interference between the first radiation field generated from the first dielectric resonator of the first radiating portion 710 and the second radiation field generated from the first patch resonator of the first radiating portion 710 may provide a third beam pattern 713 that can radiate or concentrate a relatively more electromagnetic wave energy (or wave energy) in a third direction ③ different from the first direction ① and the second direction ② because of the phase difference between the electromagnetic signals provided to the first feeding portion FP1 and the electromagnetic signals provided to the second feeding portion FP2.

According to an embodiment, the second direction ② corresponding to the second beam pattern 712 and the third direction ③ corresponding to the third beam pattern 713 may be substantially perpendicular to the seventh direction 502 (e.g., the y-axis direction) and may form an acute or obtuse angle with the first direction ① (e.g., the -z-axis direction). The second direction ② and the third direction ③ may be provided substantially symmetrically when viewed from the seventh direction 502.

According to an embodiment, for the second beam pattern 712, the phase difference between the electromagnetic signal provided to the first feeding portion FP1 and the electromagnetic signal provided to the second feeding portion FP2 may be substantially -90°. For the third beam pattern 713, the phase difference between the electromagnetic signal provided to the first feeding portion FP1 and the electromagnetic signal provided to the second feeding portion FP2 may be substantially +90°.

According to an embodiment, the second beam pattern 712 or third beam pattern 713 radiated during the first feeding to the first feeding portion FP1 and the second feeding to the second feeding portion FP2 may correspond to a first linear polarization having a substantially first polarization direction (e.g., a substantially sixth direction 501). The first radiating portion 710 including the first dielectric resonator and the first patch resonator may extend coverage (or beam coverage), compared to a comparative example in which the first dielectric resonator is omitted. The first radiating portion 710 including the first dielectric resonator and the first patch resonator may concentrate electromagnetic wave energy for a coverage range (or coverage angle range) corresponding to a different direction (e.g., a second direction (②) or a third direction (③)) or may expand the effective area in which electromagnetic waves can be transmitted and/or received, compared to a comparative example in which the first dielectric resonator is omitted.

According to an embodiment, a third radiation field (or a third electromagnetic field) may be generated from the first patch resonator of the first radiating portion 710 when the communication circuit 54 has a third feeding that provides an electromagnetic signal (or a radio signal, an RF signal, or a radiated current) to the third feeding portion FP3.

According to an embodiment, the third radiation field generated during the third feeding to the third feeding portion FP3 may provide a fourth beam pattern 714 that can radiate or concentrate a relatively more electromagnetic wave energy (or wave energy) in a first direction ① substantially directed toward the first surface 511.

According to an embodiment, the third radiation field generated during the third feeding to the third feeding portion FP3 and the fourth beam pattern 714 provided by the third radiation field, for example, may correspond to a second linear polarization having a substantially second polarization direction (e.g., a substantially seventh direction 502).

According to an embodiment, when the communication circuit 54 has a first feeding providing an electromagnetic signal (or a radio signal, RF signal, or radiated current) to a first feeding portion FP1, and a third feeding providing an electromagnetic signal to a third feeding portion FP2, a first radiation field (or a first electromagnetic field) may be generated from a first dielectric resonator of the first radiating portion 710, and a third radiation field (or a third electromagnetic field) may be generated from a first patch resonator of the first radiating portion 710. Because of interference (e.g., constructive interference and/or destructive interference) between the first radiation field and the third radiation field, a fifth beam pattern 715 or a sixth beam pattern 716 may be provided, which is capable of radiating or concentrating a relatively more electromagnetic wave energy (or wave energy) in a direction different from the first direction ① (or tilted with respect to the first direction ①).

According to an embodiment, the communication circuit 54 may adjust the phase difference of the electromagnetic signal provided to the first feeding portion FP1 and the electromagnetic signal provided to the third feeding portion FP3. The interference between the first radiation field generated from the first dielectric resonator of the first radiating portion 710 and the third radiation field generated from the first patch resonator of the first radiating portion 710 may provide a fifth beam pattern 715 that can radiate or concentrate a relatively more electromagnetic wave energy (or wave energy) in a fourth direction different from the first direction ① because of the third phase difference between the electromagnetic signals provided to the first feeding portion FP1 and the electromagnetic signals provided to the third feeding portion FP3. The interference between the first radiation field generated from the first dielectric resonator of the first radiating portion 710 and the third radiation field generated from the first patch resonator of the first radiating portion 710 may provide a sixth beam pattern 716 that can radiate or concentrate a relatively more electromagnetic wave energy (or wave energy) in a fifth direction different from the first direction ① and the fourth direction because of the phase difference between the electromagnetic signals provided to the first feeding portion FP1 and the electromagnetic signals provided to the third feeding portion FP3.

According to an embodiment, the fourth direction corresponding to the fifth beam pattern 715 and the fifth direction corresponding to the sixth beam pattern 716 may be substantially perpendicular to the seventh direction 502 (e.g., the y-axis direction) and may form an acute or obtuse angle with the first direction ① (e.g., the -z-axis direction). The fourth direction and the fifth direction may be provided substantially symmetrically when viewed from the sixth direction 501.

According to an embodiment, the angle formed by the fourth direction or the fifth direction with respect to the first direction ① may be substantially equal to the angle formed by the second direction ② or the third direction ③ with respect to the first direction ①.

According to an embodiment, for the fifth beam pattern 715, the phase difference between the electromagnetic signal provided to the first feeding portion FP1 and the electromagnetic signal provided to the third feeding portion FP3 may be substantially -90°. For the sixth beam pattern 716, the phase difference between the electromagnetic signal provided to the first feeding portion FP1 and the electromagnetic signal provided to the third feeding portion FP3 may be substantially +90°.

According to an embodiment, the fifth beam pattern 715 or sixth beam pattern 716 radiated during the first feeding to the first feeding portion FP1 and the third feeding to the third feeding portion FP3 may correspond to a second linear polarization having a substantially second polarization direction (e.g., a substantially seventh direction 502). The first radiating portion 710 including the first dielectric resonator and the first patch resonator may extend coverage (or beam coverage), compared to a comparative example in which the first dielectric resonator is omitted. The first radiating portion 710 including the first dielectric resonator and the first patch resonator may concentrate electromagnetic wave energy for a coverage range (or coverage angle range) corresponding to a different direction (e.g., a fourth direction or a fifth direction) or may expand the effective area in which electromagnetic waves can be transmitted and/or received, compared to a comparative example in which the first dielectric resonator is omitted.

According to an embodiment, in substantially the same manner as the first radiating portion 710 provided by the combination of the first dielectric resonator including the first dielectric 61 and the first patch resonator including the first antenna element 521, the antenna module 5 may provide the second radiating portion (or second resonator or second resonant portion ) 720 provided by the combination of the second dielectric resonator (or second dielectric resonant portion) including the second dielectric 62 and the resonator (hereinafter, "second patch resonator" or "second patch resonant portion ") including the second antenna element 522. The first beam pattern 711, the second beam pattern 712, the third beam pattern 713, the fourth beam pattern 714, the fifth beam pattern 715, and/or the sixth beam pattern 716 may be generated from the first radiator 710 in a manner substantially identical or similar to the way in which the first beam pattern 711, the second beam pattern 712, the third beam pattern 713, the fourth beam pattern 714, the fifth beam pattern 715, and/or the sixth beam pattern 716 are generated from the first radiating portion 710.

According to an embodiment, in substantially the same manner as the first radiating portion 710 provided by the combination of the first dielectric resonator including the first dielectric 61 and the first patch resonator including the first antenna element 521, the antenna module 5 may provide a third radiating portion (or third resonator or third resonant portion ) 730 provided by the combination of the third dielectric resonator (or third dielectric resonant portion) including the third dielectric 63 and the resonator (hereinafter, "third patch resonator" or "third patch resonant portion ") including the third antenna element 523. The first beam pattern 731, the second beam pattern 732, the third beam pattern 733, the fourth beam pattern 734, the fifth beam pattern 735, and/or the sixth beam pattern 736 may be generated from the third radiator 730 in a manner substantially identical to or similar to the way in which the first beam pattern 711, the second beam pattern 712, the third beam pattern 713, the fourth beam pattern 714, the fifth beam pattern 715, and/or the sixth beam pattern 716 are generated from the first radiating portion 710.

According to an embodiment, in substantially the same manner as the first radiating portion 710 provided by the combination of the first dielectric resonator including the first dielectric 61 and the first patch resonator including the first antenna element 521, the antenna module 5 may provide a fourth radiating portion (or fourth resonator or fourth resonant portion) 740 provided by the combination of the fourth dielectric resonator (or fourth dielectric resonant portion) including the fourth dielectric 64 and the resonator (hereinafter, "fourth patch resonator" or "fourth patch resonant portion ") including the fourth antenna element 524. The first beam pattern 741, the second beam pattern 742, the third beam pattern 743, the fourth beam pattern 744, the fifth beam pattern 745, and/or the sixth beam pattern 746 may be generated from the fourth radiator 740 in a manner substantially identical or similar to the way in which the first beam pattern 711, the second beam pattern 712, the third beam pattern 713, the fourth beam pattern 714, the fifth beam pattern 715, and/or the sixth beam pattern 716 are generated from the first radiating portion 710.

According to an embodiment, because of the interference (e.g., constructive interference and/or destructive interference) between the plurality of first beam patterns 711, 721, 731, and 741 during the second feeding to the first radiating portion 710, the second radiating portion 720, the third radiating portion 730, and the fourth radiating portion 740, the transmission and/or reception performance of the first linear polarization may be secured or improved for a coverage area corresponding to the first direction ①.

According to an embodiment, because of the phase difference between the first feeding and the second feeding for the first radiating portion 710, the second radiating portion 720, the third radiating portion 730, and the fourth radiating portion 740, the interference (e.g., constructive interference and/or destructive interference) between the plurality of second beam patterns 712, 722, 732, and 742 may result in securing or improving the transmission and/or reception performance of the first linear polarization for a coverage area corresponding to the second direction ②.

According to an embodiment, because of the phase difference between the first feeding and the second feeding for the first radiating portion 710, the second radiating portion 720, the third radiating portion 730, and the fourth radiating portion 740, the interference between the plurality of third beam patterns 713, 723, 733, and 743 (e.g., constructive interference and/or destructive interference) between the plurality of third beam patterns 713, 723, 733, and 743, may result in securing or improving the transmission and/or reception performance of the first linear polarization for a coverage area corresponding to the third direction ③.

According to an embodiment, the interference (e.g., constructive interference and/or destructive interference) between the plurality of fourth beam patterns 714, 724, 734, and 744 during the third feeding to the first radiating portion 710, the second radiating portion 720, the third radiating portion 730, and the fourth radiating portion 740 may result in securing or improving the transmission and/or reception performance of the second linear polarization for the coverage area corresponding to the first direction ①.

According to an embodiment, because of the phase difference between the first feeding and the third feeding for the first radiating portion 710, the second radiating portion 720, the third radiating portion 730, and the fourth radiating portion 740, the interference (e.g., constructive interference and/or destructive interference) between the plurality of fifth beam patterns 715, 725, 735, and 745, the transmission and/or reception performance of the second linear polarization may be secured or improved for a coverage area corresponding to the fourth direction.

According to an embodiment, because of the phase difference between the first feeding and the third feeding for the first radiating portion 710, the second radiating portion 720, the third radiating portion 730, and the fourth radiating portion 740, the interference (e.g., constructive interference and/or destructive interference) between the plurality of sixth beam patterns 716, 726, 736, and 746, the transmission and/or reception performance of the second linear polarization may be secured or improved for a coverage area corresponding to the fifth direction.

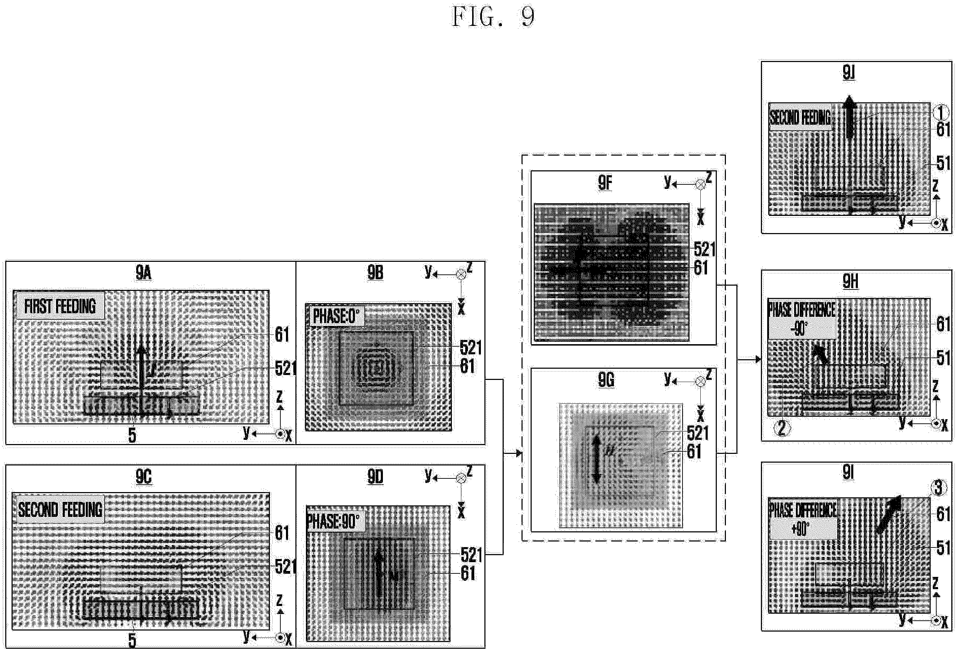

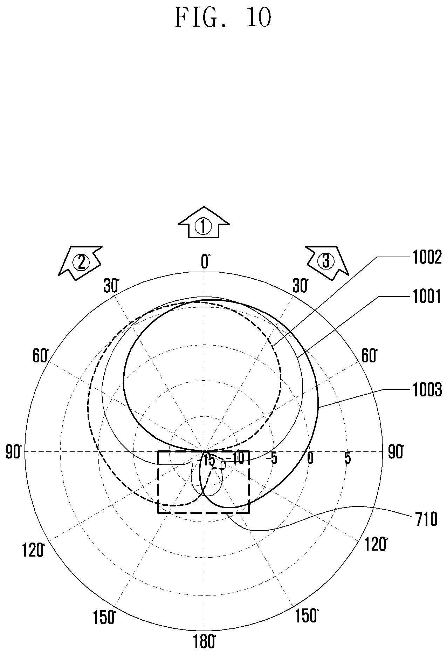

FIG. 9 are diagrams illustrating a distribution of radiation fields (or electromagnetic fields) generated from the first radiating portion 710 (see FIG. 7) according to an embodiment of the present disclosure. FIG. 10 are graphs illustrating radiation patterns of the first radiating portion 710 according to an embodiment. FIG. 10 are graphs illustrating radiation patterns of the first radiating portion according to an embodiment of the present disclosure.

With reference to FIGS. 5, 6, 9, and 10, when there are a first feeding providing an electromagnetic signal (or a radio signal, RF signal, or radiated current) to a first feeding portion FP1, and a second feeding providing an electromagnetic signal to a second feeding portion FP2, a first radiation field (or a first electromagnetic field) may be generated from a first dielectric resonator of the first radiating portion 710, and a second radiation field (or a second electromagnetic field) may be generated from a first patch resonator of the first radiating portion 710.

In an embodiment, the electric field included in the first radiation field generated during the first feeding may be provided in TE011 mode, and the electric field included in the second radiation field generated during the second feeding may be provided in TE111 mode.

According to an embodiment, the communication circuit 54 may adjust the phase of the first feeding and the phase of the second feeding such that the phase difference between the first feeding and the second feeding to the first radiating portion 710 is substantially -90°. '9A' is a diagram illustrating a distribution of an electric field in a first radiation field. '9B' is a diagram illustrating a distribution of a magnetic field in the first radiation field. '9C' is a diagram illustrating the distribution of an electric field in a second radiation field. '9D' is a diagram illustrating the distribution of a magnetic field in the second radiation field. Because of the interference (e.g., constructive interference and/or destructive interference) between the first radiation field and the second radiation field, a fourth radiation field may be provided. '9F' is a diagram illustrating a distribution of an electric field in the fourth radiation field. "9G" is a diagram illustrating the distribution of a magnetic field in the fourth radiation field. '9H' is a diagram illustrating the distribution of the wave energy in the fourth radiation field. Since the phase difference between the TE011 mode and the TE111 mode is substantially -90°, a relatively more wave energy may be radiated or concentrated for the coverage area corresponding to the second direction ②. '1002' of FIG. 10 is a graph illustrating a second radiation pattern (e.g., the second beam pattern 712 of FIG. 8) for a coverage area corresponding to the second direction ②.

According to an embodiment, the communication circuit 54 may adjust the phase of the first feeding and the phase of the second feeding such that the phase difference between the first feeding and the second feeding for the first radiating portion 710 is substantially +90°. '9I' is a diagram illustrating a distribution of the wave energy of the fourth radiation field when the phase difference between the first feeding and the second feeding is substantially +90°. Since the phase difference between the TE011 mode and the TE111 mode is substantially +90°, a relatively more wave energy may be radiated or concentrated for the coverage area corresponding to the third direction ③. '1003' of FIG. 10 is a graph illustrating a third radiation pattern (e.g., the third beam pattern 713 of FIG. 8) for a coverage area corresponding to the third direction ③.

According to an embodiment, '9J' is a diagram illustrating a distribution of the wave energy of a second radiation field (or a second electromagnetic field) generated from a first patch resonator of the first radiation part 710 when there is a second feeding to the first radiation part 710. The wave energy may be relatively more radiated or concentrated for a coverage area corresponding to the first direction ①. '1001' of FIG. 10 is a graph illustrating a first radiation pattern (e.g., the first beam pattern 711 of FIG. 8) for a coverage area corresponding to the first direction ①.

According to an embodiment, the first radiation pattern 1001 generated during the second feeding, and the second radiation pattern 1002 or third radiation pattern 1003 generated during the first feeding and the second feeding, may substantially correspond to a first linear polarization of the first polarization direction.

According to an embodiment, in substantially the same or similar manner as the first radiation pattern 1001 (e.g., the first beam pattern 711 of FIG. 8) is generated during the second feeding to the second feeding portion FP2, a fourth radiation pattern (e.g., the fourth beam pattern 714 of FIG. 8) may be generated during the third feeding to the third feeding portion FP3. In substantially the same or similar manner as the second radiation pattern 1002 (e.g., the second beam pattern 712 of FIG. 8) or the third radiation pattern 1003 (e.g., the third beam pattern 713 of FIG. 8) are generated during the first feeding to the first feeding portion FP1 and the second feeding to the second feeding portion FP2, the fifth radiation pattern (e.g., the fifth beam pattern 715 of FIG. 8) or the sixth radiation pattern (e.g., the sixth beam pattern 716 of FIG. 8) may be generated during the first feeding to the first feeding portion FP1 and the third feeding to the third feeding portion FP3. The fourth radiation pattern generated during the third feeding and the fifth radiation pattern or the sixth radiation pattern generated during the first feeding and the third feeding may substantially correspond to a second linear polarization of the second polarization direction.

According to an embodiment, the first radiating portion 710 may further provide a second radiation pattern 1002 (e.g., the second beam pattern 712 of FIG. 8), a third radiation pattern 1003 (e.g., the third beam pattern 713 of FIG. 8), a fifth radiation pattern (e.g., the fifth beam pattern 715 of FIG. 8), or a sixth radiation pattern (e.g., the sixth beam pattern 716 of FIG. 8), thereby extending the coverage of the antenna module 5. The remaining radiating portions of the antenna module 5 (e.g., the second radiating portion 720, the third radiating portion 730, and the fourth radiating portion 740 of FIG. 7) may radiate a plurality of radiation patterns in substantially the same or similar manner as the first radiating portion 710.

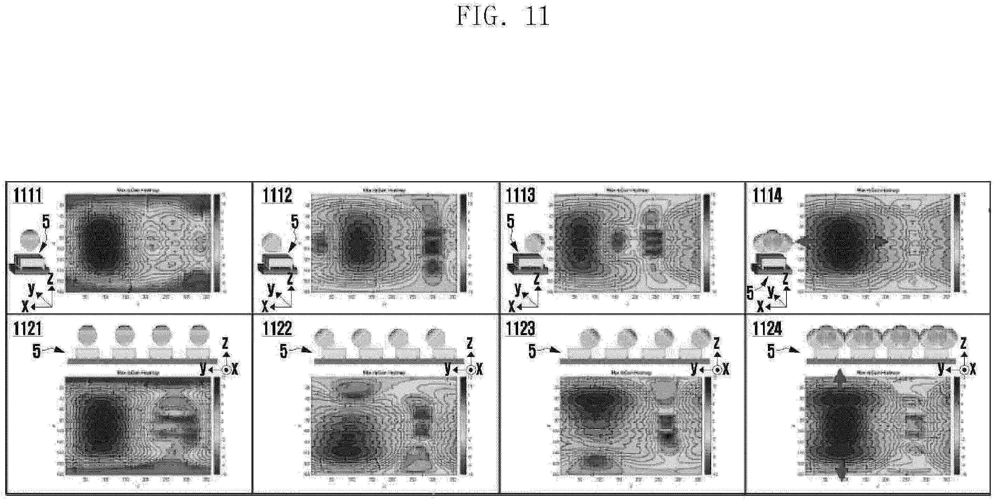

FIG. 11 are heat maps illustrating wave energy according to a feeding to an antenna module 5 in free space according to an embodiment of the present disclosure.

With reference to FIGS. 7 and 11, '1111' is a heat map illustrating the wave energy in a first polarization direction radiated during a second feeding to the first radiating portion 710, the second radiating portion 720, the third radiating portion 730, and the fourth radiating portion 740. During the second feeding, for example, a plurality of first beam patterns 711, 721, 731, and 741 shown in FIG. 8 may be generated. '1112' is a heat map illustrating the wave energy in the first polarization direction radiated during the first feeding and the second feeding at a -90° phase difference with respect to the first radiating portion 710, the second radiating portion 720, the third radiating portion 730, and the fourth radiating portion 740. During the first feeding and the second feeding with a -90° phase difference, for example, the plurality of second beam patterns 712, 722, 732, and 742 shown in FIG. 8 may be generated. '1113' is a heat map illustrating the wave energy in the first polarization direction radiated during the first feeding and the second feeding with a +90° phase difference with respect to the first radiating portion 710, the second radiating portion 720, the third radiating portion 730, and the fourth radiating portion 740. During the first feeding and the second feeding with a +90° phase difference, for example, the plurality of third beam patterns 713, 723, 733, and 743 shown in FIG. 8 may be generated. '1114' is a heat map illustrating the composite of the wave energy in the first polarization direction radiated during the second feeding, the wave energy in the first polarization direction radiated during the first feeding and the second feeding with a -90° phase difference, and the wave energy in the first polarization direction radiated during the first feeding and the second feeding with a +90° phase difference.

With reference to FIGS. 7 and 11, '1121' is a heat map illustrating the wave energy in the second polarization direction radiated during a third feeding with respect to the first radiating portion 710, the second radiating portion 720, the third radiating portion 730, and the fourth radiating portion 740. During the third feeding, for example, a plurality of fourth beam patterns 714, 724, 734, and 744 shown in FIG. 8 may be generated. '1122' is a heat map illustrating the wave energy in the second polarization direction radiated during the first feeding and the third feeding with a - 90° phase difference with respect to the first radiating portion 710, the second radiating portion 720, the third radiating portion 730, and the fourth radiating portion 740. During the first feeding and the third feeding with a -90° phase difference, for example, a plurality of fifth beam patterns 715, 725, 735, and 745 shown in FIG. 8 may be generated. '1123' is a heat map illustrating the wave energy in the second polarization direction radiated during the first feeding and the third feeding with a +90° phase difference with respect to the first radiating portion 710, the second radiating portion 720, the third radiating portion 730, and the fourth radiating portion 740. During the first feeding and the third feeding with a +90° phase difference, for example, the plurality of sixth beam patterns 716, 726, 736, and 746 shown in FIG. 8 may be generated. '1124' is a heat map illustrating the composite of the wave energy in the second polarization direction radiated during the third feeding, the wave energy in the second polarization direction radiated during the first feeding and the third feeding with a -90° phase difference, and the wave energy in the second polarization direction radiated during the first feeding and the third feeding with a +90° phase difference.

Table 1 illustrates the gain of the antenna module 5 for electromagnetic waves in the first polarization direction and electromagnetic waves in the second polarization direction, at an operating frequency of about 28 GHz.

**[Table 1]**

| 28GHz | Electromagnetic waves of the first polarization direction | | Electromagnetic waves of the second polarization direction | |
|---|---|---|---|---|
| | Beam during second feeding | Total beams | Beam during second feeding | Total beams |
| Peak | 11.7 | 11.7 | 11.0 | 11.0 |
| Cumulative distribut ion function (CDF) 50% | 1.0 | 4.9 | 1.5 | 4.7 |
| Unit: dB | | | | |

With reference to FIGS. 7 and 11 and Table 1, the first radiating portion 710, the second radiating portion 720, the third radiating portion 730, and the fourth radiating portion 740 of the antenna module 5 further utilize dielectric resonators in the patch resonator to extend coverage. For example, on the basis of CDF 50%, a radiating portion provided by a combination of a dielectric resonator and a patch resonator may have an improved performance of about 3.9 dB for an electromagnetic wave in the first polarization direction, compared to a patch resonator. For example, on the basis of CDF 50%, a radiating portion provided by a combination of a dielectric resonator and a patch resonator may have an improved performance of about 3.2 dB for an electromagnetic wave in the second polarization direction, compared to a patch resonator.

Table 2 illustrates the gain for the antenna module of the comparative example and the gain for the antenna module 5 of the present disclosure (see FIG. 5) in free space.

**[Table 2]**

| Division | | 25 GHz | | 28GHz | | 38.5GHz | |
|---|---|---|---|---|---|---|---|
| | | CDF | Peak | CDF | Peak | CDF | Peak |
| Antenna module for comparison example | First linear polari zatio n | 3.3 | 9.2 | 2.6 | 11.8 | 1.4 | 13.3 |
| | Second linear polari zatio n | 2.8 | 9.9 | 2.1 | 11.1 | 0.5 | 12.2 |
| Antenna module 5 of the present disclosure | First linear polari zatio n | 6.1 | 10.1 | 5.0 | 11.8 | 3.8 | 13.3 |
| | Second linear polari | 6.5 | 11.5 | 5.0 | 11.1 | 4.1 | 12.6 |
| | zatio n | | | | | | |
| Unit: dB | | | | | | | |

Table 3 illustrates the gain for the antenna module of the comparative example in an electronic device (e.g., the foldable electronic device 3 of FIG. 3) and the gain for the antenna module 5 of the present disclosure (see FIG. 5).

**[Table 3]**

| Division | | 25GHz | | 28GHz | | 38.5GHz | |
|---|---|---|---|---|---|---|---|
| | | CDF 50% | Peak | CDF | Peak | CDF | Peak |
| Antenna module for compari son example | 1st linear polarizat ion | -0.7 | 10.2 | -1.0 | 11.4 | -1.9 | 10.3 |
| | Second linear polarizat ion | -0.4 | 8.7 | -1.2 | 11.0 | -2.4 | 9.9 |
| Antenna module 5 of the present disclosu re | 1st linear polarizat ion | 1.6 | 12.5 | 0.8 | 11.4 | 0.2 | 10.4 |
| | Second linear polarizat ion | 2.0 | 11.6 | 1.4 | 11.0 | -0.4 | 10.5 |
| Unit: dB | | | | | | | |

The antenna module 5 according to an embodiment of the present disclosure may include a plurality of radiating portions (e.g., the first radiating portion 710, the second radiating portion 720, the third radiating portion 730, and/or the fourth radiating portion 740 of FIG. 7) provided by a combination of dielectric resonators and patch resonators. The antenna module of the comparative example may be provided with the dielectric resonator omitted, compared to the antenna module 5 according to an embodiment of the present disclosure.

With reference to Tables 2 and 3, the antenna module 5 according to an embodiment of the present disclosure may provide superior coverage compared to the antenna module of the comparative example. For example, in free space, the antenna module 5 may have an improved performance of about 2.4 to about 3.7 dB, on the basis of a CDF of 50%, compared to the antenna module of the comparative example. For example, in an electronic device (e.g., the foldable electronic device 3 of FIG. 3), the antenna module 5 may have an improved performance of about 1.8 to about 2.6 dB, on the basis of a CDF of 50%, compared to the antenna module of the comparative example.

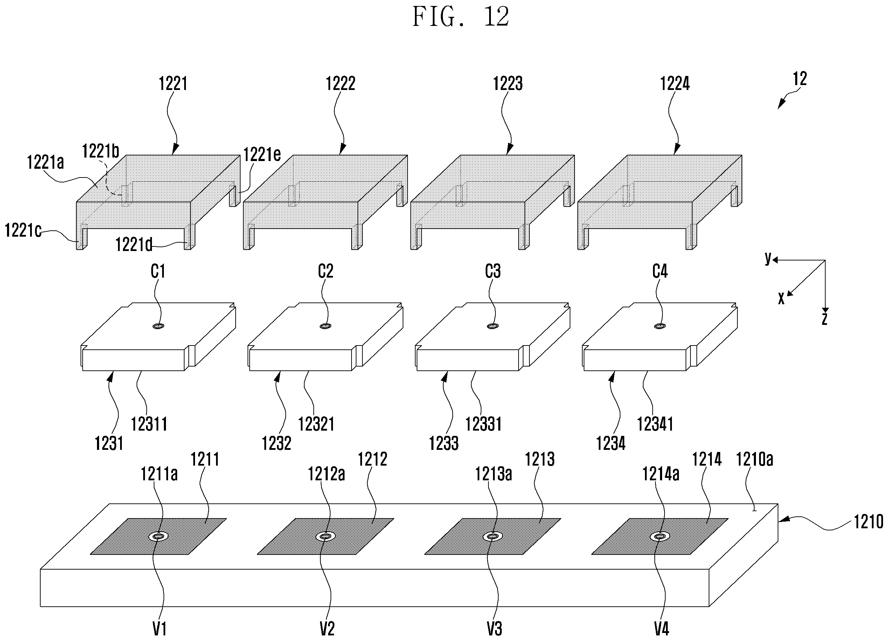

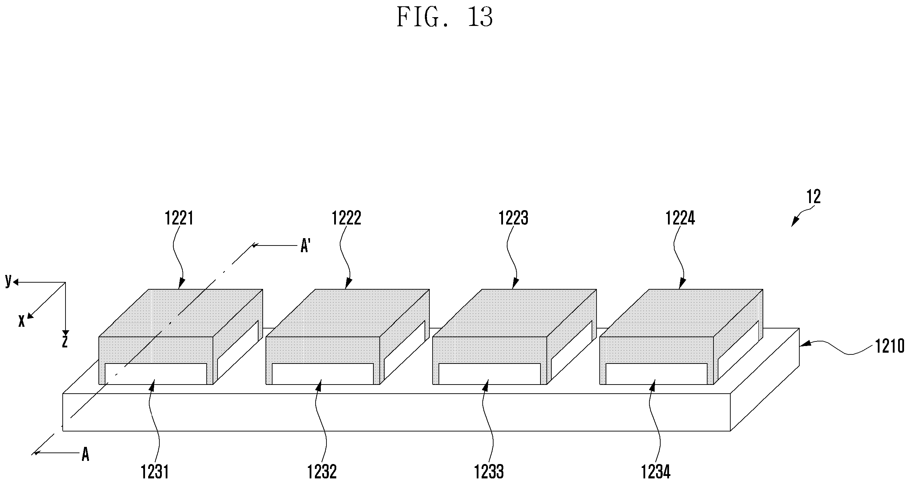

FIG. 12 is an exploded perspective view of an antenna module 12 according to an embodiment of the present disclosure. FIG. 13 is an exploded perspective view of the antenna module 12 according to an embodiment of the present disclosure.

With reference to FIGS. 12 and 13, the antenna module 12 may include a printed circuit board (or antenna structure) 1210 (e.g., the printed circuit board 510 of FIG. 5), a first dielectric 1221 (e.g., the first dielectric 61 of FIG. 5), a second dielectric 1222 (e.g., the second dielectric 62 of FIG. 5), a third dielectric 1223 (e.g., the third dielectric 63 of FIG. 5), a fourth dielectric 1224 (e.g., the fourth dielectric 64 of FIG. 5), a first connector 1231, a second connector 1232, a third connector 1233, a fourth connector 1234, and/or a communication circuit (e.g., the communication circuit 54 of FIG. 6).

According to an embodiment, the printed circuit board 1210 may include a first surface 1210a (e.g., the first surface 511 of FIG. 5) and a second surface (e.g., the second surface 512 of FIG. 5) facing in an opposite direction from the first surface 1210a. The printed circuit board 1210 may include a first antenna element (or a first patch) 1211 (the first antenna element 521 of FIG. 5), a second antenna element (or a second patch) 1212 (the second antenna element 522 of FIG. 5), a third antenna element (or third patch) 1213 (the third antenna element 523 of FIG. 5), and/or a fourth antenna element (or fourth patch) 1214 (the first antenna element 524 of FIG. 5). The antenna array (e.g., the antenna array 52 of FIG. 5) including the first antenna element 1211, the second antenna element 1212, the third antenna element 1213, and the fourth antenna element 1214 may be disposed on the first surface 1210a, or may be disposed on the interior of the printed circuit board 1210 closer to the first surface 1210a than the second surface.

According to an embodiment, the communication circuit (e.g., the communication circuit 54 of FIG. 6) may be disposed on the second surface (e.g., the second surface 512 of FIG. 6) of the printed circuit board 1210.

According to an embodiment, the first dielectric 1221, the second dielectric 1222, the third dielectric 1223, and the fourth dielectric 1224 may be disposed on or coupled to the first surface 1210a of the printed circuit board 1210. The first dielectric 1221 may be positioned corresponding to the first antenna element 1211. When viewed from above the first surface 1210a (e.g., when viewed in the +z axis direction), the first dielectric 1221 may overlap with the first antenna element 1211. The second dielectric 1222 may be positioned corresponding to the second antenna element 1212. When viewed from above the first surface 1210a, the second dielectric 1222 may be overlapped with the second antenna element 1212. The third dielectric 1223 may be positioned corresponding to the third antenna element 1213. When viewed from above the first surface 1210a, the third dielectric 1223 may overlap with the third antenna element 1213. The fourth dielectric 1224 may be positioned corresponding to the fourth antenna element 1214. When viewed from above the first surface 1210a, the fourth dielectric 1224 may overlap with the fourth antenna element 1214.

According to an embodiment, a first connector 1231 may be positioned corresponding to the first antenna element 1211 and the first dielectric 1221, and may be disposed at least partially between the printed circuit board 1210 and the first dielectric 1221. A second connector 1232 may be positioned corresponding to the second antenna element 1212 and the second dielectric 1222, and may be disposed at least partially between the printed circuit board 1210 and the second dielectric 1222. A third connector 1233 may be positioned corresponding to the third antenna element 1213 and the third dielectric 1223, and may be disposed at least partially between the printed circuit board 1210 and the third dielectric 1223. A fourth connector 1234 may be positioned corresponding to the fourth antenna element 1214 and the fourth dielectric 1224, and may be disposed at least partially between the printed circuit board 1210 and the fourth dielectric 1224.

According to an embodiment, the first dielectric 1221 may include a first portion 1221a and a plurality of second portions 1221b, 1221c, 1221d, and 1221e. The first portion 1221a may overlap with the first antenna element 1211 when viewed from above the first surface 1210a. The first connector 1231 may be positioned between the first portion 1221a and the printed circuit board 1210. The plurality of second portions 1221b, 1221c, 1221d, and 1221e may extend from the first portion 1221a and may be in contact with or be coupled to the first surface 1210a of the printed circuit board 1210. The plurality of second portions 1221b, 1221c, 1221d, and 1221e (e.g., ribs or bridges) may support spacing between the first portion 1221a and the first surface 1210a of the printed circuit board 1210. The second dielectric 1222, third dielectric 1223, or fourth dielectric 1224 may be provided substantially the same as or similar to the first dielectric 1221.

According to an embodiment, the first antenna element 1211 may include a first opening 1211a (e.g., the opening 5211 of FIG. 5). The second antenna element 1212 may include a second opening 1212a. The third antenna element 1213 may include a third opening 1213a. The fourth antenna element 1214 may include a fourth opening 1214a.

According to an embodiment, the printed circuit board 1210 may include a first conductive via V1 positioned corresponding to a first opening 1211a of the first antenna element 1211, a second conductive via V2 positioned corresponding to a second opening 1212a of the second antenna element 1212, a third conductive via V3 positioned corresponding to the third opening 1213a of the third antenna element 1213, and/or a fourth conductive via V4 positioned corresponding to a fourth opening 1214a of the fourth antenna element 1214. The first conductive via V1 may penetrate the first opening 1211a. The second conductive via V2 may penetrate the second opening 1212a. A third conductive via V3 may penetrate the third opening 1213a. The fourth conductive via V4 may penetrate the fourth opening 1214a. The first conductive via V1 may be part of a first electrical path (or first conductive path) connecting the first dielectric 1221 and a communication circuit (e.g., the communication circuit 54 of FIG. 6). The second conductive via V2 may be part of a second electrical path (or second conductive path) connecting the second dielectric 1222 and the communication circuit (e.g., the communication circuit 54 of FIG. 6). The third conductive via V3 may be part of a third electrical path (or third conductive path) connecting the third dielectric 1223 and the communication circuit (e.g., the communication circuit 54 of FIG. 6). The fourth conductive via V4 may be part of a fourth electrical path (or fourth conductive path) connecting the fourth dielectric 1224 and the communication circuit (e.g., the communication circuit 54 of FIG. 6).

According to an embodiment, the first connector 1231 may include a first conductive portion C1 connecting the first conductive via V1 and the first dielectric 1221. One end of the first conductive portion C1 may be electrically connected to the first conductive via V1 via a conductive adhesive material or conductive bonding material such as solder. The first conductive portion C1 may be part of a first electrical path (or first conductive path) connecting the first dielectric 1221 and a communication circuit (e.g., the communication circuit 54 of FIG. 6).

According to an embodiment, the other end of the first conductive portion C1 may be in physical contact or direct connection with the first dielectric 1221. During the first feeding, the first dielectric 1221 may receive an electromagnetic signal directly from the first conductive portion C1.

According to an embodiment, the first connector 1231 may include a first non-conductive portion 12311 including a non-conductive material, such as a polymer. The first conductive portion C1 may be disposed on the first non-conductive portion 12311.

According to an embodiment, the first connector 1231 may be implemented as a printed circuit board. For example, the first non-conductive portion 12311 may be a non-conductive layer (e.g., a dielectric layer) of a printed circuit board, and the first conductive portion C1 may be a conductive via provided on the non-conductive layer.

According to various embodiments, the first conductive portion C1 may be connected to the first dielectric 1221 indirectly through the first non-conductive portion 12311. The first dielectric 1221 and the first non-conductive portion 12311 may be in physical contact. During the first feeding by a communication circuit (e.g., the communication circuit 54 of FIG. 6), the first dielectric 1221 may indirectly receive an electromagnetic signal from the first conductive portion C1 through the first non-conductive portion 12311. In various embodiments, the combination of the first dielectric 1221 and the first non-conductive portion 12311 may be interpreted as the first dielectric 61 of FIG. 5.

According to various embodiments, the antenna module 12 may include a non-conductive adhesive material or a non-conductive bonding material disposed between the first dielectric 1221 and the first non-conductive portion 12311. The first dielectric 1221 and the first non-conductive portion 12311 may be coupled through the non-conductive adhesive material or a non-conductive bonding material. During the first feeding, the first dielectric 1221 may indirectly receive electromagnetic signals from the first conductive portion C1 through the first non-conductive portion 12311 and the non-conductive adhesive material (or the non-conductive bonding material). In various embodiments, the combination of the first dielectric 1221, the first non-conductive portion 12311, and the non-conductive adhesive material (or the non-conductive bonding material) may be interpreted as the first dielectric 61 of FIG. 5.

According to an embodiment, the second connector 1232, third connector 1233, or fourth connector 1234 may be provided substantially the same as or similar to the first connector 1231 connecting the printed circuit board 1210 and the first dielectric 1221. The second connector 1232 may include a second non-conductive portion 12321 and a second conductive portion C2 disposed on the second non-conductive portion 12321. The second conductive portion C2 may be electrically connected to the second conductive via V2 of the printed circuit board 1210 through a conductive adhesive material or a conductive bonding material such as solder. The third connector 1233 may include a third non-conductive portion 12331 and a third conductive portion C3 disposed on the third non-conductive portion 12331. The third conductive portion C3 may be electrically connected to the third conductive via V3 of the printed circuit board 1210 through a conductive adhesive material or a conductive bonding material such as solder. The fourth connector 1234 may include a fourth non-conductive portion 12341 and a fourth conductive portion C4 disposed on the fourth non-conductive portion 12341. The fourth conductive portion C4 may be electrically connected to the fourth conductive via V4 of the printed circuit board 1210 through a conductive adhesive material or a conductive bonding material such as solder.

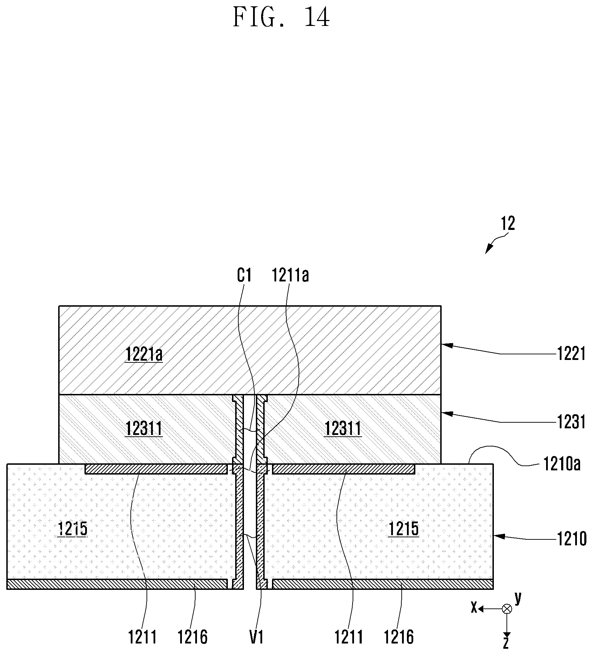

FIG. 14 is a cross-sectional view of antenna module 12 as viewed along line A-A' in FIG. 13 according to an embodiment of the present disclosure.

With reference to FIG. 14, the antenna module 12 may include a printed circuit board 1210, a first dielectric 1221, and/or a first connector 1231.

According to an embodiment, the printed circuit board 1210 may include a first antenna element (or a first patch) 1211, a ground plane 1216 (e.g., the ground plane 53 of FIG. 5), a dielectric layer (e.g., an insulating layer) 1215, and/or a first conductive via V1. The first antenna element 1211 and the ground plane 1216 may be disposed in the dielectric layer 1215. The first antenna element 1211 may be positioned closer to the first surface 1210a than the ground plane 1216. In an embodiment, the first antenna element 1211 and the ground plane 1216 may be positioned physically spaced apart from each other. When viewed from above a first surface 1210a of a printed circuit board 1210, a first antenna element 1211 may overlap with a ground plane 1216. The first antenna element 1211 may include a first opening 1211a. When viewed from above the first surface 1210a of the printed circuit board 1210, a first conductive via V1 may overlap with the first opening 1211a. The first conductive via V1 may be a part of a signal line (not shown separately) electrically connected to a communication circuit (e.g., the communication circuit 54 of FIG. 6) of the printed circuit board 1210. The signal line may be positioned to be physically spaced from the ground plane 1216.

According to an embodiment, the first connector 1231 may include a first non-conductive portion 12311 and a first conductive portion C1. 1 The first connector 1231 may be provided, for example, as a printed circuit board. The first non-conductive portion 12311 may be a non-conductive layer (e.g., a dielectric layer) of the printed circuit board, and the first conductive portion C1 may be a conductive via provided in the non-conductive layer.

According to an embodiment, the first connector 1231 may be coupled to a printed circuit board 1210. 1 The first conductive portion C1 of the connector 1231 may be electrically connected to the first conductive via V1 of the printed circuit board 1210 through a conductive adhesive material or a conductive bonding material such as solder.

According to an embodiment, the first portion 1221a of the first dielectric 1221 may be in physical contact with the first conductive portion C1.

According to various embodiments, an integral printed circuit board may be provided to replace the printed circuit board 1210 and the first connector 1231.

According to various embodiments, a metal portion (or a metal body) such as a metal pin (not shown) may be provided to replace the first connector 1231. For example, the metal portion may be connected to the first conductive via V1 through a conductive adhesive material or a conductive bonding material such as solder. The metal portion may be in physical contact with the first dielectric 1221. In various embodiments, the metal portion may be inserted into a hole or recess in the first dielectric 1221 (not shown).

In various embodiments, an integral dielectric (not shown separately) may be provided to replace at least two of the first dielectric 1221, the second dielectric 1222, the third dielectric 1223, and the fourth dielectric 1224 of FIG. 13.

According to various embodiments, the first dielectric 1221, the second dielectric 1222, the third dielectric 1223, and the fourth dielectric 1224 of FIG. 13 may be a plurality of non-conductive material members (not shown separately) disposed on the first cover 312 (see FIG. 3) of the foldable electronic device 3.

According to various embodiments, the first cover 312 (see FIG. 3) of the foldable electronic device 3 may replace the first dielectric 1221, the second dielectric 1222, the third dielectric 1223, and the fourth dielectric 1224 of FIG. 13.

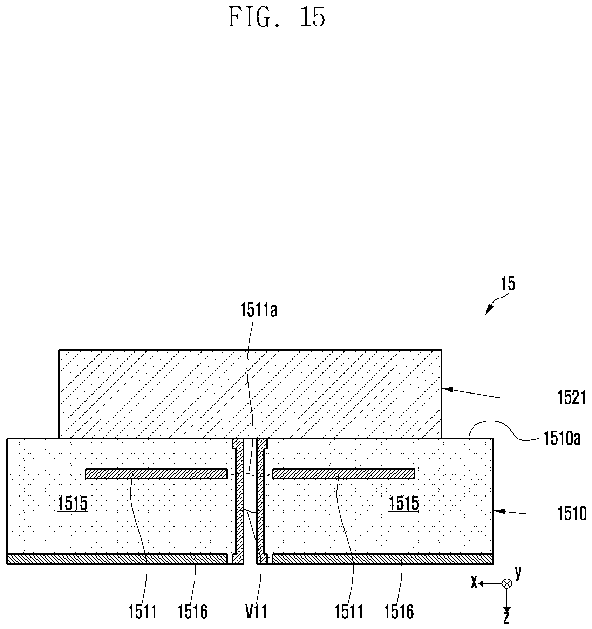

FIG. 15 is a cross-sectional view of an antenna module of another embodiment that is a variation of the embodiment of FIG. 14 according to various embodiments of the present disclosure.

With reference to FIG. 15, the antenna module 15 may include a printed circuit board 1510 and a first dielectric 1521.

According to an embodiment, the printed circuit board 1510 may include a first antenna element (or a first patch) 1511 (e.g., the first antenna element 521 of FIG. 5), a ground plane 1516 (e.g., the ground plane 53 of FIG. 5), a dielectric layer (e.g., an insulating layer) 1515, and/or a first conductive via V11. The first antenna element 1511 and the ground plane 1516 may be disposed on the dielectric layer 1515. The first antenna element 1511 may be positioned closer to the first surface 1510a (e.g., the first surface 511 of FIG. 5) than the ground plane 1516. In an embodiment, the first antenna element 1511 and the ground plane 1516 may be physically spaced apart. When viewed from above the first surface 1510a, the first antenna element 1511 may overlap with the ground plane 1516. The first antenna element 1511 may include a first opening 1511a. When viewed from above the first surface 1510a, the first conductive via V11 may overlap with the first opening 1511a. The first conductive via V11 may be part of a signal line (not shown separately) electrically connected to a communication circuit (e.g., the communication circuit 54 of FIG. 6) of the printed circuit board 1510. The signal lines may be disposed physically spaced apart from the ground plane 1516.

According to an embodiment, the first dielectric 1521 may be disposed on the first surface 1410a of the printed circuit board 1510. The first dielectric 1521 may be in physical contact with the first conductive via V11.

According to an embodiment, the first antenna element 1511 of the printed circuit board 1510 may be disposed on an interior of the printed circuit board 1510 such that it is spaced apart from the first dielectric 1521 disposed on the first surface 1510a.

According to various embodiments, the antenna module 15 may further include a metal portion (or a metal body) (e.g., a metal pin, not shown separately) directly coupled to the first conductive via V11. For example, the metal portion may be coupled to the first conductive via V11 through a conductive adhesive material or a conductive bonding material such as solder. The metal portion may be in physical contact with the first dielectric 1521. In various embodiments, the metal portion may be inserted into a recess of the first dielectric 1521 (not shown).

In various embodiments, the first cover 312 of the foldable electronic device 3 (see FIG. 3), or at least one member of a non-conductive material disposed on the first cover 312 (not shown separately), may replace the first dielectric 1521.

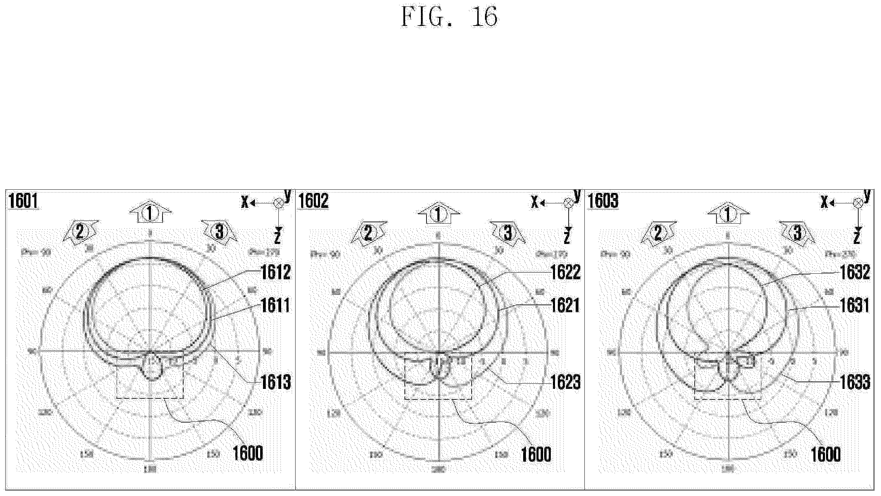

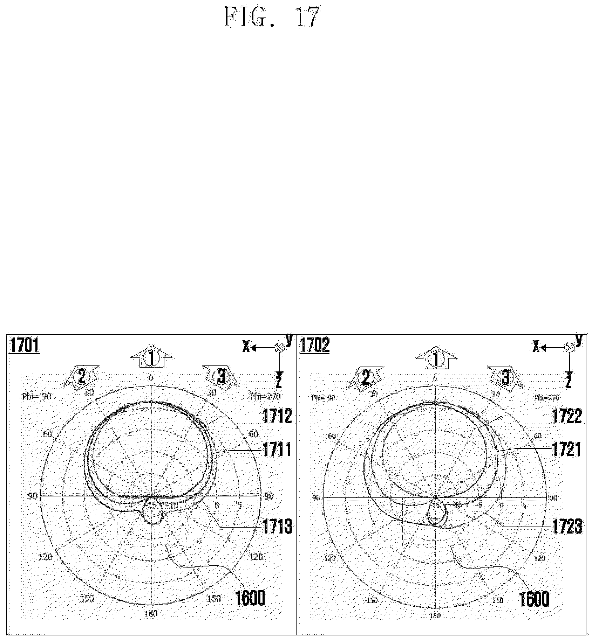

FIG. 16 are graphs illustrating radiation patterns of a first radiating portion 1600 (e.g., the first radiating portion 710 of FIG. 7) according to the permittivity of the first dielectric 1221 in the embodiment of FIG. 13 according to an embodiment of the present disclosure. FIG. 17 are graphs illustrating radiation patterns of a first radiating portion 1600 (e.g., the first radiating portion 710 of FIG. 7) along the length of the first conductive portion C1 extending in a first direction toward the first surface 1210a in the embodiment of FIG. 14 according to an embodiment of the present disclosure.

With reference to FIGS. 13 and 16, '1601' are graphs illustrating radiation patterns of the first radiating portion 1600 when the relative permittivity of the first dielectric 1221 is substantially 1. '1602' are graphs illustrating radiation patterns of the first radiating portion 1600 when the relative permittivity of the first dielectric 1221 is substantially 3. '1603' is a graph illustrating the radiation patterns of the first radiating portion 1600 when the relative permittivity of the first dielectric 1221 is substantially 5. The length of the first dielectric 1221 extending in the first direction ① may be, for example, about 0.5 mm.

With reference to FIGS. 14 and 17, '1701' are graphs illustrating radiation patterns of the first radiating portion 1600 when the length of the first conductive portion C1 extending in the first direction ① is about 0.5 mm. '1702' are graphs illustrating radiation patterns of the first radiating portion 1600 when the first conductive portion C1 has a length of about 1 mm extending in the first direction ①. The relative permittivity of the first dielectric 1221 may be substantially 1. For example, it can be interpreted that as the length of the first conductive portion C1 extending in the first direction ① increases, the length at which the feeding path is inserted into the first dielectric 1221 increases.

According to an embodiment, during the second feeding to the first radiating portion 1600, relatively more wave energy may be radiated or concentrated for a coverage area corresponding to the first direction ①. '1611','1621', and '1631' of FIG. 16 are graphs illustrating a first radiation pattern (e.g., the first beam pattern 711 of FIG. 8) for a coverage area corresponding to the first direction ① during the second feeding. '1711' and '1721' of FIG. 17 are graphs illustrating a first radiation pattern (e.g., the first beam pattern 711 of FIG. 8) for a coverage area corresponding to the first direction ① during the second feeding.

According to an embodiment, during a first feeding and a second feeding with a - 90° phase difference with respect to the first radiating portion 1600, relatively more wave energy may be radiated or concentrated for a coverage area corresponding to the second direction ② tilted with respect to the first direction ①. '1612', '1622', '1632' of FIG. 16 are graphs illustrating a second radiation pattern (e.g., the second beam pattern 712 of FIG. 8) for a coverage area corresponding to the second direction ② during the first feeding and the second feeding with a -90° phase difference. '1712' and '1722' of FIG. 17 are graphs illustrating a second radiation pattern (e.g., the second beam pattern 712 of FIG. 8) for a coverage area corresponding to the second direction ② during the first feeding and the second feeding with a -90° phase difference.

According to an embodiment, during the first feeding and the second feeding with a +90° phase difference with respect to the first radiating portion 1600, relatively more wave energy may be radiated or concentrated for a coverage area corresponding to the third direction ③ tilted with respect to the first direction ①. '1613', '1623', and '1633' of FIG. 16 are graphs illustrating a third radiation pattern (e.g., the third beam pattern 713 of FIG. 8) for a coverage area corresponding to the third direction ③ during the first feeding and the second feeding with a +90° phase difference. '1713' and '1723' of FIG. 17 are graphs illustrating a third radiation pattern (e.g., the third beam pattern 713 of FIG. 8) for a coverage area corresponding to the third direction ③ during first feeding and second feeding with a +90° phase difference.

Comparing the graphs of FIG. 16, when the relative permittivity of the first dielectric 1221 increases, the second direction ② or the third direction ③ may be further tilted corresponding to the first direction ① during the first feeding and the second feeding, such that the coverage may be expanded.

Comparing the graphs of FIG. 17, when the length of the first conductive portion C1 extending in the first direction ① increases, the second direction ② or the third direction ③ may be further tilted with respect to the first direction ① during the first feeding and the second feeding, such that the coverage may be expanded.

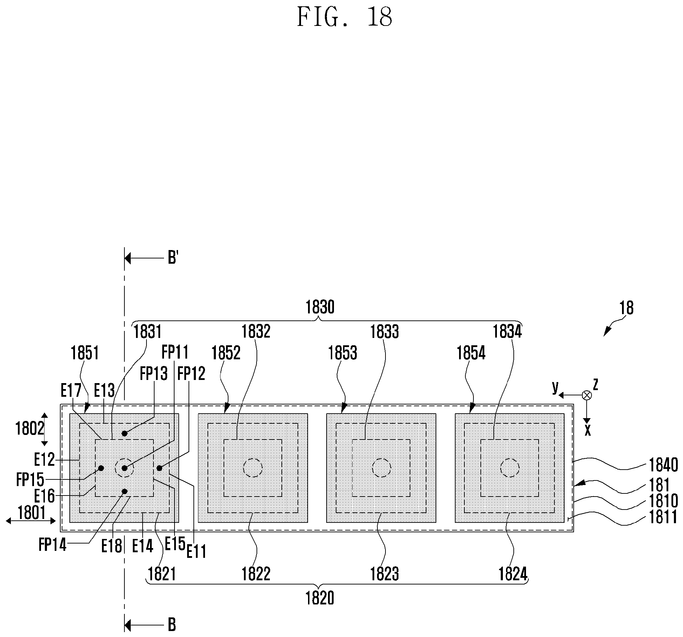

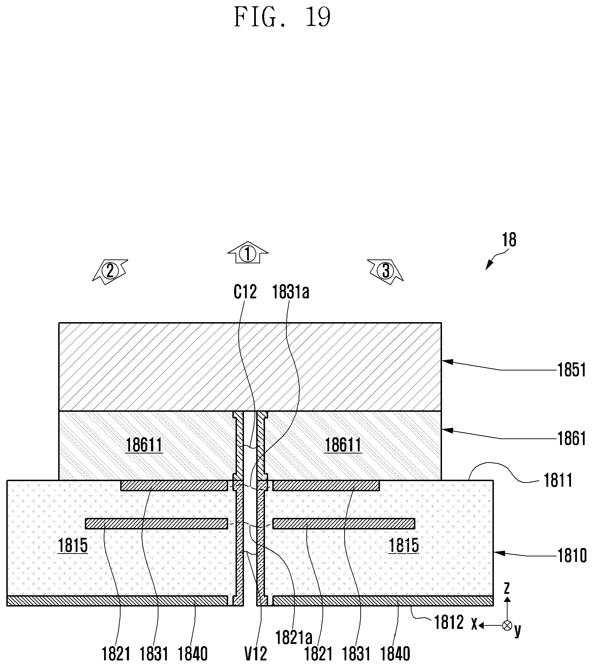

FIG. 18 is a diagram illustrating an antenna module 18 according to various embodiments of the present disclosure. FIG. 19 is a cross-sectional view of antenna module 18 as viewed along line B-B' in FIG. 18 according to various embodiments of the present disclosure.

With reference to FIGS. 18 and 19, the antenna module 18 may include an antenna structure 181, a communication circuit (e.g., the communication circuit 54 of FIG. 6), a first dielectric 1851 (e.g., the first dielectric 61 of FIG. 5), a second dielectric 1852 (e.g., the second dielectric 62 of FIG. 5), a third dielectric 1853 (e.g., the third dielectric 63 of FIG. 5), and/or a fourth dielectric 1854 (e.g., the fourth dielectric 64 of FIG. 5).

According to various embodiments, the antenna module 18 may be the third antenna module 246 of FIG. 2.

According to an embodiment, the antenna structure 181 may include a printed circuit board 1810. The printed circuit board 1810 may include a first surface 1811 (e.g., the first surface 511 of FIG. 5) and a second surface 1812 (e.g., the second surface 512 of FIG. 5) facing in an opposite direction from the first surface 1811.

According to an embodiment, the first surface 1811 of the printed circuit board 1810 may face the first cover 312 (see FIG. 3). The second surface 1812 of the printed circuit board 1810 may face the first display area ① of the first display module 34.

According to an embodiment, the printed circuit board 1810 may include a first antenna array 1820 and a second antenna array 1830. The second antenna array 1830 may be disposed on the first surface 1811, or may be located closer to the first surface 1811 of the printed circuit board 1810 than the first antenna array 1820. The first antenna array 1820 may be disposed on an interior of the printed circuit board 1810 closer to the second surface 1812 of the printed circuit board 1810 than the third antenna array 1830.

According to an embodiment, the first antenna array 1820 may include a first antenna element 1821, a second antenna element 1822, a third antenna element 1823, and/or a fourth antenna element 1824. The second antenna array 1830 may include a fifth antenna element 1831, a sixth antenna element 1832, a seventh antenna element 1833, and/or an eighth antenna element 1834. When viewed from above the first surface 1811 (e.g., when viewed in the +z axis direction), the first antenna element 1821 and the fifth antenna element 1831 may overlap. When viewed from above the first surface 1811, the second antenna element 1822 and the sixth antenna element 1832 may be overlapped. When viewed from above the first surface 1811, the third antenna element 1823 and the seventh antenna element 1833 may be overlapped. When viewed from above the first surface 1811, the fourth antenna element 1824 and the eighth antenna element 1834 may be overlapped. The first antenna array 1820 or the second antenna array 1830 may be, for example, the antenna 248 of FIG. 2.

According to an embodiment, the plurality of antenna elements 1821, 1822, 1823, and 1824 of the first antenna array 1820 may be substantially the same shape and may be spaced apart. The plurality of antenna elements 1821, 1822, 1823, and 1824 may be disposed in a sixth direction 1801 (e.g., the y-axis direction) when viewed from above the first surface 1811 (e.g., the +z-axis direction). The sixth direction 1801 may be substantially parallel to, for example, a center line A (see FIG. 3) of the foldable electronic device 3.

According to an embodiment, when viewed from above the first surface 1811 (e.g., when viewed in the +z axis direction), the plurality of antenna elements 1821, 1822, 1823, and 1824 of the first antenna array 1820 may be substantially square. The first antenna element 1821 may include a first edge E11, a second edge E12, a third edge E13, and a fourth edge E14, when viewed from above the first surface 1811. When viewed from above the first surface 1811, the first edge E11 and the second edge E12 may be spaced apart from each other in the sixth direction 1801 and may be substantially parallel to each other. When viewed from above the first surface 1811, the third edge E13 and the fourth edge E14 may be spaced apart from each other in the seventh direction 1802 and may be substantially parallel to each other. The remaining antenna elements 1822, 1823, and 1824 may be substantially the same shape as the first antenna element 1821. The shape of the plurality of antenna elements 1821, 1822, 1823, and 1824 is not limited thereto and may vary. The plurality of antenna elements 1821, 1822, 1823, and 1824 may be provided in various polygons, such as, for example, circular, elliptical, or triangular (not shown).

According to an embodiment, the plurality of antenna elements 1831, 1832, 1833, and 1834 of the second antenna array 1830 may be substantially the same shape and may be disposed at regular intervals. The plurality of antenna elements 1821, 1822, 1823, and 1824 may be disposed in the sixth direction 1801 (e.g., the y-axis direction) when viewed from above the first surface 1811 (e.g., when viewed in the +z-axis direction).

According to an embodiment, when viewed from above the first surface 1811 (e.g., when viewed in the +z axis direction), the plurality of antenna elements 1831, 1832, 1833, and 1834 of the second antenna array 1830 may be substantially square. The fifth antenna element 1831 may include a fifth edge E15, a sixth edge E16, a seventh edge E17, and an eighth edge E18 when viewed from above the first surface 1811. The fifth edge E15 may be positioned corresponding to the first edge E11 included in the first antenna element 1821 of the first antenna array 1820. The sixth edge E16 may be positioned corresponding to the second edge E12 included in the first antenna element 1821 of the first antenna array 1820. The seventh edge E17 may be positioned corresponding to the third edge E13 included in the first antenna element 1821 of the first antenna array 1820. The eighth edge E18 may be positioned corresponding to the fourth edge E14 included in the first antenna element 1821 of the first antenna array 1820. The center of the first antenna element 1821 included in the first antenna array 1820 and the center of the fifth antenna element 1831 included in the second antenna array 1830 may be substantially aligned, when viewed from above the first surface 1811. The remaining antenna elements 1832, 1833, and 1834 may be provided substantially the same as the fifth antenna element 1831. The shape of the plurality of antenna elements 1831, 1832, 1833, and 1834 is not limited thereto and may vary. The plurality of antenna elements 1831, 1832, 1833, and 1834 may be provided in various polygons, such as, for example, circular, elliptical, or triangular (not shown).

According to an embodiment, the plurality of antenna elements 1831, 1832, 1833, and 1834 of the second antenna array 1830 may be provided in a smaller size than the plurality of antenna elements 1821,1822, 1823, and 1824 of the first antenna array 1820 when viewed from above the first surface 1811.

According to various embodiments, the number or location of antenna elements included in the first antenna array 1820 and the second antenna array 1830 may vary, without limitation to the embodiments shown.

According to an embodiment, the printed circuit board 1810 may include a ground plane 1840 (e.g., the ground plane 53 of FIG. 5) that operates as an antenna ground. The ground plane 1840 may contribute to ensuring antenna radiation performance (or radio wave transmission or reception performance, or communication performance) and/or ensuring coverage, with respect to the first antenna array 1820 and the second antenna array 1830. The ground plane 53 may reduce electromagnetic interference (EMI) (or signal loss) with respect to the first antenna array 1820 and the second antenna array 1830.

According to an embodiment, the ground plane 1840 may be disposed closer to the second surface 1812 of the printed circuit board 1810 than the first antenna array 1820. When viewed from above the first surface 1811 (e.g., when viewed in the +z axis direction), the first antenna array 1820 and the second antenna array 1820 may overlap at least partially with the ground plane 1840.

According to an embodiment, the antenna structure 181 may operate as a patch antenna. For example, when a communication circuit (e.g., the communication circuit 54 of FIG. 6) provides (or feedings) an electromagnetic signal (or a radio signal, an RF signal, or a radiated current) to the plurality of antenna elements 1821, 1822, 1823, and 1824 of the first antenna array 1820, because of the plurality of antenna elements (e.g., the plurality of first patches) 1821, 1822, 1823, and 1824 resonating with the ground plane 1840 and acting as radiating elements at a selected or specified first frequency (or a first frequency band), the antenna structure 181 may operate as a resonator (e.g., a patch antenna). When a communication circuit (e.g., the communication circuit 54 of FIG. 6) provides (or feedings) an electromagnetic signal to the plurality of antenna elements 1831, 1832, 1833, and 1834 of the second antenna array 1830, because of the plurality of antenna elements (e.g., the plurality of second patches) 1831, 1832, 1833, and 1834 resonating with the ground plane 1840 and acting as radiating elements at a selected or specified second frequency (or a second frequency band), the antenna structure 181 may operate as a resonator (e.g., a patch antenna).

According to an embodiment, the printed circuit board 1810 may include a second electrical path (or a second transmission line or a second feeding line) (not shown) that transmits an electromagnetic signal (or a radio signal, an RF signal, or a radiated current) to the first antenna element 1821 of the first antenna array 1820. The second electrical path may electrically connect the first antenna element 1821 and a communication circuit (e.g., the communication circuit 54 of FIG. 6). The portion of the first antenna element 1821 to which the electromagnetic signal is transmitted from the second electrical path may be defined or interpreted as the second feeding portion FP12. In some embodiments, the second electrical path, or the portion of the second electrical path connected to the first antenna element 1821, may be defined or interpreted as the 'second feeding portion', and the portion of the first antenna element 1821 to which the electromagnetic signal is transmitted from the second electrical path may be defined or interpreted as the 'second feeding area' or the 'second feeding point'. The electromagnetic signal provided by the communication circuit (e.g., the communication circuit 54 of FIG. 6) to the second feeding portion FP12 (or the second electrical path, the second feeding area, or the second feeding point) may be defined or interpreted as a 'second feeding'.

According to an embodiment, the printed circuit board 1810 may include a third electrical path (or a third transmission line or a third feeding line) (not shown) that transmits electromagnetic signals to the first antenna element 1821 of the first antenna array 1820. The third electrical path may electrically connect the first antenna element 1821 and a communication circuit (e.g., the communication circuit 54 of FIG. 6). The portion of the first antenna element 1821 to which the electromagnetic signal is transmitted from the third electrical path may be defined or interpreted as the third feeding portion FP13. In some embodiments, the third electrical path, or the portion of the third electrical path connected to the first antenna element 1821, may be defined or interpreted as the 'third feeding portion' and the portion of the first antenna element 521 to which the electromagnetic signal from the third electrical path is transmitted may be defined or interpreted as the 'third feeding area' or the 'third feeding point'. The electromagnetic signal provided by the communication circuit (e.g., the communication circuit 54 of FIG. 6) to the third feeding portion FP13 (or the third electrical path, the third feeding area, or the third feeding point) may be defined or interpreted as a 'third feeding'.

According to an embodiment, the second feeding portion FP12 of the first antenna element 1821 included in the first antenna array 1820 may be positioned between the center and the first edge E11 of the first antenna element 1821 in the sixth direction 1801 when viewed from above the first surface 1811 (e.g., when viewed in the +z axis direction). The third feeding portion FP13 of the first antenna element 1821 included in the first antenna array 1820 may be positioned between the center and the third edge E13 of the first antenna element 1821 in the seventh direction 1802, when viewed from above the first surface 1811. The distance that the second feeding portion FP12 is spaced from the center of the first antenna element 1821 in the sixth direction 1801 and the distance that the third feeding portion FP13 is spaced from the center of the first antenna element 1821 in the seventh direction 1802 may be substantially the same. The remaining antenna elements 1822, 1823, and 1824 of the first antenna array 1820 may include a second feeding portion corresponding to the second feeding portion FP12 of the first antenna element 1821, and a third feeding portion corresponding to the third feeding portion FP13 of the first antenna element 1821.

According to an embodiment, the printed circuit board 1810 may include a fourth electrical path (or a fourth transmission line or a fourth feeding line) (not shown) that transmits an electromagnetic signal (or a radio signal, an RF signal, or a radiated current) to the fifth antenna element 1831 of the second antenna array 1830. The fourth electrical path may electrically connect the fifth antenna element 1831 and a communication circuit (e.g., the communication circuit 54 of FIG. 6). The portion of the fifth antenna element 1831 to which the electromagnetic signal is transmitted from the fourth electrical path may be defined or interpreted as the fourth feeding portion FP14. In some embodiments, the fourth electrical path, or the portion of the fourth electrical path connected to the fifth antenna element 1831, may be defined or interpreted as a 'fourth feeding portion', and the portion of the fifth antenna element 1831 to which the electromagnetic signal is transmitted from the fourth electrical path may be defined or interpreted as a 'fourth feeding area' or a 'fourth feeding point'. The electromagnetic signal provided by the communication circuit (e.g., the communication circuit 54 of FIG. 6) to the fourth feeding portion FP14 (or the fourth electrical path, the fourth feeding area, or the fourth feeding point) may be defined or interpreted as a 'fourth feeding'.

According to an embodiment, the printed circuit board 1810 may include a fifth electrical path (or a fifth transmission line or a fifth feeding line) (not shown) that transmits electromagnetic signals to the fifth antenna element 1831 of the second antenna array 1820. The fifth electrical path may electrically connect the fifth antenna element 1831 and a communication circuit (e.g., the communication circuit 54 of FIG. 6). The portion of the fifth antenna element 1831 to which the electromagnetic signal is transmitted from the fifth electrical path may be defined or interpreted as the fifth feeding portion FP15. In some embodiments, the fifth electrical path, or the portion of the fifth electrical path connected to the fifth antenna element 1831, may be defined or interpreted as a 'fifth feeding portion' and the portion of the fifth antenna element 1831 to which the electromagnetic signal is transmitted from the fifth electrical path may be defined or interpreted as a 'fifth feeding area' or a 'fifth feeding point'. The electromagnetic signal provided by the communication circuit (e.g., the communication circuit 54 of FIG. 6) to the fifth feeding portion FP15 (or the fifth electrical path, the fifth feeding area, or the fifth feeding point) may be defined or interpreted as a 'fifth feeding'.

According to an embodiment, the fourth feeding portion FP14 of the fifth antenna element 1831 included in the second antenna array 1830 may be positioned between the center and the eighth edge E18 of the fifth antenna element 1831 in the seventh direction 1802 when viewed from above the first surface 1811 (e.g., when viewed in the +z axis direction). The fifth feeding portion FP15 of the fifth antenna element 1831 included in the second antenna array 1830 may be positioned between the center and the sixth edge E16 of the second antenna element 1831 in the sixth direction 1801, when viewed from above the first surface 1811. The distance that the fourth feeding portion FP14 is spaced from the center of the fifth antenna element 1831 in the seventh direction 1802 and the distance that the fifth feeding portion FP15 is spaced from the center of the fifth antenna element 1831 in the sixth direction 1801 may be substantially the same. The remaining antenna elements 1832, 1833, and 1834 of the second antenna array 1830 may include a fourth feeding portion corresponding to the fourth feeding portion FP14 of the fifth antenna element 1831, and a fifth feeding portion corresponding to the fifth feeding portion FP15 of the fifth antenna element 1831.

According to an embodiment, the first dielectric 1851, the second dielectric 1852, the third dielectric 1853, and the fourth dielectric 1854 may be disposed on or coupled to the first surface 1811 of the printed circuit board 1810.

According to an embodiment, the first dielectric 1851 may be positioned corresponding to the first antenna element 1821 of the first antenna array 1820 and the fifth antenna element 1831 of the second antenna array 1830. The first dielectric 1851 may overlap with the first antenna element 1821 and the fifth antenna element 1831 when viewed from above the first surface 1811 of the printed circuit board 1810 (e.g., when viewed in the +z axis direction).

According to an embodiment, the second dielectric 1852 may be positioned corresponding to the second antenna element 1822 of the first antenna array 1820 and the sixth antenna element 1832 of the second antenna array 1830. The second dielectric 1852 may overlap with the second antenna element 1822 and the sixth antenna element 1832 when viewed from above the first surface 1811 of the printed circuit board 1810 (e.g., when viewed in the +z axis direction).

According to an embodiment, the third dielectric 1853 may be positioned corresponding to the third antenna element 1823 of the first antenna array 1820 and the seventh antenna element 1833 of the second antenna array 1830. The third dielectric 1853 may overlap with the third antenna element 1823 and the seventh antenna element 1833 when viewed from above the first surface 1811 of the printed circuit board 1810 (e.g., when viewed in the +z axis direction).

According to an embodiment, the fourth dielectric 1854 may be positioned corresponding to the fourth antenna element 1824 of the first antenna array 1820 and the eighth antenna element 1834 of the second antenna array 1830. The fourth dielectric 1854 may overlap with the fourth antenna element 1824 and the eighth antenna element 1834 when viewed from above the first surface 1811 of the printed circuit board 1810 (e.g., when viewed in the +z axis direction).

According to an embodiment, the antenna module 18 may include a first electrical path (or a first transmission line or a first feeding line) (e.g., a first conductive path) (not shown) that transmits an electromagnetic signal (or a radio signal, an RF signal, or a radiated current) to the first dielectric 1851. The first end of the first electrical path may be electrically connected to a communication circuit (e.g., the communication circuit 54 of FIG. 6). For example, the second end of the first electrical path may be in physical contact with or directly connected to the first dielectric 1951. The portion of the first dielectric 1851 to which the electromagnetic signal is transmitted from the second end of the first electrical path may be defined or interpreted as the first feeding portion FP11. In some embodiments, the first electrical path, or the second end of the first electrical path, may be defined or interpreted as a 'first feeding portion' and the portion of the first dielectric 1851 to which the electromagnetic signal is transmitted from the second end of the first electrical path may be defined or interpreted as a 'first feeding area' or a 'first feeding point'. The electromagnetic signal provided by the communication circuit (e.g., the communication circuit 54 of FIG. 6) to the first feeding portion FP11 (or the first electrical path, the first feeding area, or the first feeding point) may be defined or interpreted as a 'first feeding'. The remaining dielectrics 1852, 1853, and 1854 may include a first feeding portion (or a first feeding point) corresponding to the first feeding portion FP11 of the first dielectric 1851.

According to an embodiment, the first dielectric 1851 may operate as a first dielectric resonator (or first dielectric resonant antenna (DRA)) when the communication circuit (e.g., the communication circuit 54 of FIG. 6) transmits (or feedings) an electromagnetic signal (or a radio signal, RF signal, or radiated current) through the first electrical path. When the communication circuit 54 transmits (or feedings) an electromagnetic signal through the first electrical path, a first dielectric resonator may be provided because of the discontinuity between the first dielectric 1851 and a medium in contact with the first dielectric 1851 (or around the first dielectric 1851). The medium in contact with the first dielectric 1851 (or around the first dielectric 1851), for example, may include air. When the first dielectric 1851 is in contact with the first cover 312 (see FIG. 3), the medium in contact with the first dielectric 185 (or around the first dielectric 1851) may include the first cover 312.

According to an embodiment, the first dielectric 1851, the second dielectric 1852, the third dielectric 1853, and the fourth dielectric 1854 may include a non-conductive material. With respect to a frequency (e.g., a resonant frequency) of the electromagnetic signal transmitted and/or received through the antenna module 18, the first dielectric 1851, the second dielectric 1852, the third dielectric 1853, and the fourth dielectric 1854 may have a relative permittivity that is greater than that of a conductor having a relative permittivity being substantially 1.

According to an embodiment, the combination of the first dielectric resonator including the first dielectric 1851, the resonator including the first antenna element 1821 (hereinafter referred to as a 'first patch resonator'), and the resonator including the fifth antenna element 1831 (hereinafter referred to as a 'fifth patch resonator') may be defined or interpreted as the first radiating portion. In substantially the same manner as the first radiating portion, the antenna module 18 may include a second radiating portion provided by a combination of a second dielectric resonator including a second dielectric 1852, a resonator including a second antenna element 1822 (hereinafter referred to as a 'second patch resonator'), and a resonator including a sixth antenna element 1832 (hereinafter referred to as a 'sixth patch resonator'). In substantially the same manner as the first radiating portion, the antenna module 18 may include a third radiating portion provided by a combination of a third dielectric resonator including a third dielectric 1853, a resonator including a third antenna element 1823 (hereinafter referred to as a 'third patch resonator'), and a resonator including a seventh antenna element 1833 (hereinafter referred to as a 'seventh patch resonator'). In substantially the same manner as the first radiating portion, the antenna module 18 may include a fourth radiating portion provided by a combination of a fourth dielectric resonator including a fourth dielectric 1854, a resonator including a fourth antenna element 1824 (hereinafter referred to as a 'fourth patch resonator'), and a resonator including an eighth antenna element 1834 (hereinafter referred to as an 'eight patch resonator').

According to an embodiment, during the second feeding to the first radiating portion, a beam pattern of first linear polarization having a first polarization direction (e.g., the sixth direction 1801) (or oscillating in the first polarization direction) may be radiated from the first patch resonator including the first antenna element 1821 of the first radiating portion. During the second feeding to the second radiating portion, a beam pattern of first linear polarization having the first polarization direction may be radiated from the second patch resonator including the second antenna element 1822 of the second radiating portion. During the second feeding to the third radiating portion, a beam pattern of first linear polarization having the first polarization direction may be radiated from the third patch resonator including the third antenna element 1823 of the third radiating portion. During the second feeding to the fourth radiating portion, a beam pattern of first linear polarization having the first polarization direction may be radiated from the fourth patch resonator including the fourth antenna element 1824 of the fourth radiating portion. During the second feeding, interference (e.g., constructive interference and/or destructive interference) between the beam pattern from the first radiating portion, the beam pattern from the second radiating portion, the beam pattern from the third radiating portion, and the beam pattern from the fourth radiating portion, may provide a composite beam pattern (or a radiation pattern) in a first polarization direction that can radiate or concentrate relatively more wave energy for a coverage area corresponding to the first direction ① in which the first surface 1811 of the printed circuit board 1810 is facing.

According to an embodiment, during the third feeding to the first radiating portion, a beam pattern of second linear polarization having a second polarization direction (e.g., the seventh direction 1802) (or oscillating in the second polarization direction) may be radiated from the first patch resonator including the first antenna element 1821 of the first radiating portion. During the third feeding to the second radiating portion, a beam pattern of second linear polarization having the second polarization direction may be radiated from the second patch resonator including the second antenna element 1822 of the second radiating portion. During the third feeding to the third radiating portion, a beam pattern of the second linear polarization having the second polarization direction may be radiated from the third patch resonator including the third antenna element 1823 of the third radiating portion. During the third feeding to the fourth radiating portion, a beam pattern of the second linear polarization having the second polarization direction may be radiated from the fourth patch resonator including the fourth antenna element 1824 of the fourth radiating portion. During the third feeding, interference (e.g., constructive interference and/or destructive interference) between the beam pattern from the first radiating portion, the beam pattern from the second radiating portion, the beam pattern from the third radiating portion, and the beam pattern from the fourth radiating portion may provide a composite beam pattern (or a radiation pattern) in a second polarization direction that can radiate or concentrate relatively more wave energy for a coverage area corresponding to the first direction ① in which the first surface 1811 of the printed circuit board 1810 is facing.

According to an embodiment, during the fourth feeding to the first radiating portion, a beam pattern of third linear polarization having a third polarization direction (or the second polarization direction) (e.g., the seventh direction 1802) (or oscillating in the third polarization direction) may be radiated from the fifth patch resonator including the fifth antenna element 1831 of the first radiating portion. During the fourth feeding to the second radiating portion, a beam pattern of third linear polarization having the third polarization direction may be radiated from the sixth patch resonator including the sixth antenna element 1832 of the second radiating portion. During a fourth feeding to the third radiating portion, a beam pattern of a third linear polarization having a third polarization direction may be radiated from a seventh patch resonator including a seventh antenna element 1833 of the third radiating portion. During the fourth feeding to the fourth radiating portion, a beam pattern of the third linear polarization having the third polarization direction may be radiated from the eighth patch resonator including the eighth antenna element 1834 of the fourth radiating portion. During the fourth feeding, interference (e.g., constructive interference and/or destructive interference) between the beam pattern from the first radiating portion, the beam pattern from the second radiating portion, the beam pattern from the third radiating portion, and the beam pattern from the fourth radiating portion may provide a composite beam pattern (or radiation pattern) in the third polarization direction that can radiate or concentrate relatively more wave energy for a coverage area corresponding to the first direction ① in which the first surface 1811 of the printed circuit board 1810 is facing.

According to an embodiment, during a fifth feeding to the first radiating portion, a beam pattern of fourth linear polarization having a fourth polarization direction (or the first polarization direction) (e.g., the sixth direction 1801) (or oscillating in the fourth polarization direction) may be radiated from the fifth patch resonator including the fifth antenna element 1831 of the first radiating portion. During a fifth feeding to the second radiating portion, a beam pattern of fourth linear polarization having the fourth polarization direction may be radiated from a sixth patch resonator including a sixth antenna element 1832 of the second radiating portion. In a fifth feeding to the third radiating portion, a beam pattern of a fourth linear polarization having a fourth polarization direction may be radiated from a seventh patch resonator including a seventh antenna element 1833 of the third radiating portion. During a fifth feeding to the fourth radiating portion, a beam pattern of a fourth linear polarization having a fourth polarization direction may be radiated from an eighth patch resonator including the eighth antenna element 1834 of the fourth radiating portion. During the fifth feeding, interference (e.g., constructive interference and/or destructive interference) between the beam pattern from the first radiating portion, the beam pattern from the second radiating portion, the beam pattern from the third radiating portion, and the beam pattern from the fourth radiating portion may provide a composite beam pattern (or radiation pattern) in the fourth polarization direction that can radiate or concentrate relatively more wave energy for a coverage area corresponding to the first direction ① in which the first surface 1811 of the printed circuit board 1810 is facing.

According to an embodiment, during the first feeding and the second feeding to the first radiating portion, because of the electromagnetic coupling between the first dielectric resonator including the first dielectric 1851 and the first antenna element 1821, a beam pattern of first linear polarization may be provided such that a relatively more wave energy may be radiated or concentrated for a coverage area corresponding to a second direction ② or a third direction ③ tilted with respect to the first direction ①. The second direction ② and third direction ③ may be substantially perpendicular to the seventh direction 1802 (e.g., the y-axis direction), and may form an acute or obtuse angle with the first direction (① (e.g., the -z-axis direction). The second direction ② and third direction ③ may be provided substantially symmetrically when viewed in the seventh direction 1802. In an embodiment, a beam pattern of first linear polarization may be provided such that, during the first feeding and the second feeding to the first radiating portion with a - 90° phase difference or a +90° phase difference, a relatively more wave energy may be radiated or concentrated for a coverage area corresponding to the second direction ② or a coverage area corresponding to the third direction ③ In substantially the same manner as the first radiating portion, a beam pattern of the first linear polarization may be provided in which a relatively more wave energy may be radiated or concentrated in a coverage area corresponding to the second direction ② or the third direction ③ during the first feeding and the second feeding for the second radiating portion, the third radiating portion, and the fourth radiating portion. During the first feeding and the second feeding with a -90° phase difference or a +90° phase difference, interference (e.g., constructive interference and/or destructive interference) between the beam pattern from the first radiating portion, the beam pattern from the second radiating portion, the beam pattern from the third radiating portion, and the beam pattern from the fourth radiating portion may provide a composite beam pattern (or a radiation pattern) in the first polarization direction that can radiate or concentrate relatively more wave energy for a coverage area corresponding to the second direction ② or the third direction ③

According to an embodiment, during the first feeding and the third feeding to the first radiating portion, because of electromagnetic coupling between the first dielectric resonator including the first dielectric 1851 of the first radiating portion and the first antenna element 1821, a beam pattern of a second linear polarization may be provided such that a relatively more wave energy may be radiated or concentrated for a coverage area corresponding to the fourth or the fifth direction tilted with respect to the first direction ① The fourth direction and the fifth direction may be substantially parallel to the seventh direction 1802 (e.g., the y-axis direction), and may form an acute or obtuse angle with the first direction ① (e.g., the -z-axis direction). The fourth direction and the fifth direction may be provided substantially symmetrically when viewed in the sixth direction 1801. In an embodiment, a beam pattern of a second linear polarization may be provided such that, during the first feeding and the third feeding to the first radiating portion with a -90° phase difference or a +90° phase difference, a relatively more wave energy may be radiated or concentrated for a coverage area corresponding to the fourth direction or a coverage area corresponding to the fifth direction. In substantially the same manner as the first radiating portion, a beam pattern of the second linear polarization may be provided in which a relatively more wave energy may be radiated or concentrated in the first feeding and the third feeding to the second radiating portion, the third radiating portion, and the fourth radiating portion for a coverage area corresponding to the fourth direction or the fifth direction. Interference (e.g., constructive interference and/or destructive interference) between the beam pattern from the first radiation portion, the beam pattern from the second radiation portion, the beam pattern from the third radiation portion, and the beam pattern from the fourth radiation portion during the first feeding and the third feeding with a -90° phase difference or a +90° phase difference may provide a composite beam pattern (or a radiation pattern) of the second polarization direction in which a relatively more wave energy may be radiated or concentrated for a coverage area corresponding to the fourth direction or the fifth direction.

According to an embodiment, during the first feeding and the fourth feeding, because of electromagnetic coupling between the first dielectric resonator and the fifth antenna element 1831 including the first dielectric 1851 of the first radiating portion, a beam pattern of a third linear polarization may be provided such that a relatively more wave energy may be radiated or concentrated for a coverage area corresponding to the fourth or the fifth direction tilted corresponding to the first direction. In an embodiment, a beam pattern of the third linear polarization may be provided such that, during the first feeding and the fourth feeding of the first radiating portion with a -90° phase difference or a +90° phase difference, a relatively more wave energy may be radiated or concentrated for a coverage area corresponding to the fourth direction or a coverage area corresponding to the fifth direction. In substantially the same manner as the first radiating portion, a beam pattern of the third linear polarization may be provided in which a relatively more wave energy may be radiated or concentrated in the first feeding and the fourth feeding to the second radiating portion, the third radiating portion, and the fourth radiating portion in a coverage range corresponding to the fourth direction or the fifth direction. Interference (e.g., constructive interference and/or destructive interference) between the beam pattern from the first radiation portion, the beam pattern from the second radiation portion, the beam pattern from the third radiation portion, and the beam pattern from the fourth radiation portion during the first feeding and the fourth feeding with a -90° phase difference or a +90° phase difference may provide a composite beam pattern (or a radiation pattern) of the third polarization direction from which a relatively more wave energy may be radiated or concentrated for a coverage area corresponding to the fourth direction or the fifth direction.

According to an embodiment, during the first feeding and the fifth feeding to the first radiating portion, because of electromagnetic coupling between the first dielectric resonator including the first dielectric 1851 of the first radiating portion and the fifth antenna element 1831, a beam pattern of a fourth linear polarization may be provided such that a relatively more wave energy may be radiated or concentrated for a coverage area corresponding to a second direction ② or a third direction ③ tilted corresponding to the first direction ①. In an embodiment, a beam pattern of the fourth linear polarization may be provided in which the relatively more wave energy may be radiated or concentrated for the coverage area corresponding to the second direction ② or the coverage area corresponding to the third direction ③ during the first feeding and the fifth feeding to the first radiating portion with a -90° phase difference or a +90° phase difference. In substantially the same manner as the first radiating portion, a beam pattern of the fourth linear polarization may be provided in which a relatively more wave energy may be radiated or concentrated for a coverage area corresponding to the second direction ② or the third direction ③ during the first feeding and the fifth feeding for the second radiating portion, the third radiating portion, and the fourth radiating portion. During the first feeding and the fifth feeding with a -90° phase difference or a +90° phase difference, interference (e.g., constructive interference and/or destructive interference) between the beam pattern from the first radiating portion, the beam pattern from the second radiating portion, the beam pattern from the third radiating portion, and the beam pattern from the fourth radiating portion may provide a composite beam pattern (or a radiation pattern) in the fourth polarization direction that may radiate or concentrate relatively more wave energy for a coverage area corresponding to the second direction ② or the third direction ③.

According to an embodiment, electromagnetic waves (e.g., linear polarization) radiated from the first radiating portion, the second radiating portion, the third radiating portion, or the fourth radiating portion during the second feeding, the first feeding and the second feeding, or the first feeding and the third feeding, may have a first resonant frequency included in the first frequency band. The electromagnetic waves (e.g., linear polarization) radiating from the first radiating portion, the second radiating portion, the third radiating portion, and the fourth radiating portion during the fourth feeding, the first feeding and the fourth feeding, the fifth feeding, or the first feeding and the fifth feeding, may have a second resonant frequency included in a second frequency band that is different from the first frequency band.

According to an embodiment, the printed circuit board 1810 may include a first conductive via V12 disposed corresponding to the first radiating portion. The first conductive via V12 may penetrate an opening 1821a provided in a first antenna element 1821 included in the first radiating portion and an opening 1831a provided in a fifth antenna element 1831 included in the first radiating portion. The first conductive via V12 may be part of a first electrical path (or a first conductive path) connecting the first dielectric 1851 and a communication circuit (e.g., the communication circuit 54 of FIG. 6).

According to an embodiment, the antenna module 18 may include a first connector 1861 (e.g., the first connector 1231 of FIG. 12) disposed at least partially between the first dielectric 1851 and a first surface 1811 of the printed circuit board 1810 in response to the first dielectric 1851. The first connector 1861 may include a first conductive portion C12 (e.g., the first conductive portion C12 of FIG. 12) connecting the first conductive via V12 and the first dielectric 1851. One end of the first conductive portion C12 may be electrically connected to the first conductive via V12 through a conductive adhesive material or a conductive bonding material such as solder. The first conductive portion C12 may be part of a first electrical path (or a first conductive path) connecting the first dielectric 1851 and a communication circuit (e.g., the communication circuit 54 of FIG. 6).

According to an embodiment, the other end of the first conductive portion C12 may be in physical contact or direct connection with the first dielectric 1851. During the first feeding by a communication circuit (e.g., the communication circuit 54 of FIG. 6), the first dielectric 1851 may receive electromagnetic signals directly from the first conductive portion C12.

According to an embodiment, the first connector 1861 may include a first non-conductive portion 18611 (e.g., the first non-conductive portion 12311 of FIG. 14) including a non-conductive material such as a polymer. The first conductive portion C12 may be disposed on the first non-conductive portion 18611.

According to an embodiment, the first connector 1861 may be implemented as a printed circuit board. For example, the first non-conductive portion 18611 may be a non-conductive layer (e.g., a dielectric layer) of a printed circuit board, and the first conductive portion C12 may be a conductive via provided on the non-conductive layer.

According to various embodiments, the first conductive portion C12 may be connected to the first dielectric 1851 indirectly through the first non-conductive portion 18611. The first dielectric 1851 and the first non-conductive portion 18611 may be in physical contact. During the first feeding by a communication circuit (e.g., the communication circuit 54 of FIG. 6), the first dielectric 1851 may indirectly receive electromagnetic signals from the first conductive portion C12 through the first non-conductive portion 18611. In various embodiments, the first dielectric resonator may be interpreted to include a combination of the first dielectric 1851 and the first non-conducting portion 18611.

According to various embodiments, the antenna module 18 may include a non-conductive adhesive material or a non-conductive bonding material disposed between the first dielectric 1851 and the first non-conductive portion 18611. The first dielectric 1851 and the first non-conductive portion 18611 may be coupled through the non-conductive adhesive material or the non-conductive bonding material. During the first feeding by a communication circuit (e.g., the communication circuit 54 of FIG. 6), the first dielectric 1851 may indirectly receive electromagnetic signals from the first conductive portion C12 through the first non-conductive portion 18611 and the non-conductive adhesive material (or the non-conductive bonding material). In various embodiments, the first dielectric resonator may be interpreted to include a combination of the first dielectric 1851, the first non-conductive portion 18611, and the non-conductive adhesive material (or the non-conductive bonding material).

According to an embodiment, the antenna module 18 may include a second connector (e.g., the second connector 1232 of FIG. 12) disposed at least partially between the second dielectric 1852 and the first surface 1811 of the printed circuit board 1810 in response to the second dielectric 1852. The antenna module 18 may include a third connector (e.g., the third connector 1233 of FIG. 12) disposed at least partially between the third dielectric 1853 and the first surface 1811 of the printed circuit board 1810 in response to the third dielectric 1853. The antenna module 18 may include a fourth connector (e.g., the fourth connector 1234 of FIG. 12) disposed at least partially between the fourth dielectric 1854 and the first surface 1811 of the printed circuit board 1810 in response to the fourth dielectric 1854. The second connector, third connector, or fourth connector may be provided substantially the same as or similar to the first connector 1861 connecting the printed circuit board 1810 and the first dielectric 1851.

According to various embodiments, in a variation of the embodiment of FIG. 19, the antenna module 18 may be implemented with the first dielectric 1861, the second dielectric, the third dielectric, and the fourth dielectric omitted, as in the embodiment of FIG. 15.

According to various embodiments, the first dielectric 1851, the second dielectric 1852, the third dielectric 1853, and the fourth dielectric 1854 may be a plurality of non-conductive material members (not shown separately) disposed on the first cover 312 (see FIG. 3) of the foldable electronic device 3.

According to various embodiments, the first cover 312 (see FIG. 3) of the foldable electronic device 3 may replace the first dielectric 1851, the second dielectric 1852, the third dielectric 1853, and the fourth dielectric 1854.

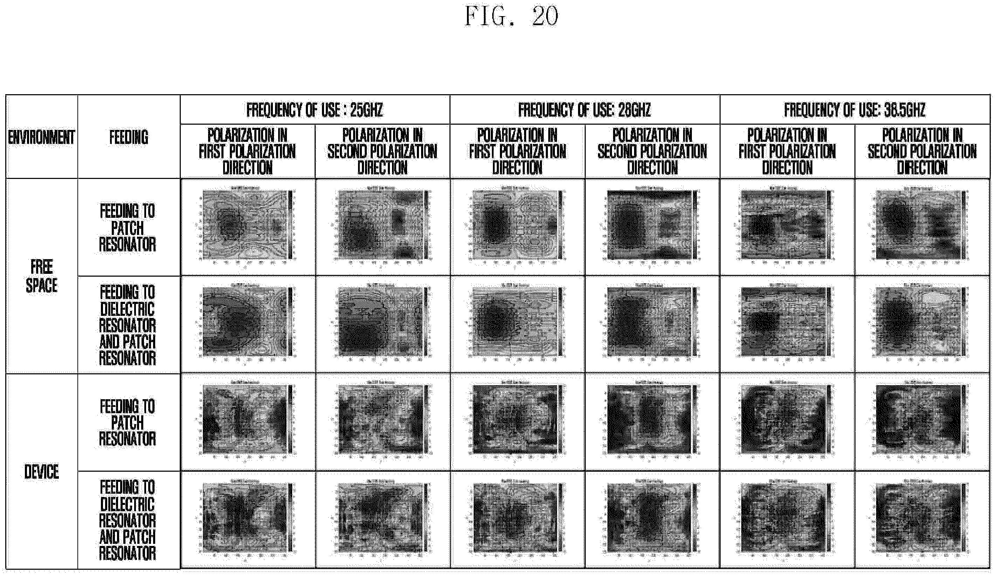

FIG. 20 are heat maps illustrating wave energy for electromagnetic waves radiated by various feedings to the antenna module 18 of FIG. 18 according to an embodiment of the present disclosure.

With reference to FIG. 20, during a feeding to at least one radiating portion provided by a combination of dielectric resonators and patch resonators included in the antenna module 18, a beam pattern that can achieve transmission and reception performance for electromagnetic signals in coverage areas that would otherwise be difficult to cover by a beam pattern radiated by a feeding to at least one patch resonator included in the antenna module 18, may be provided.

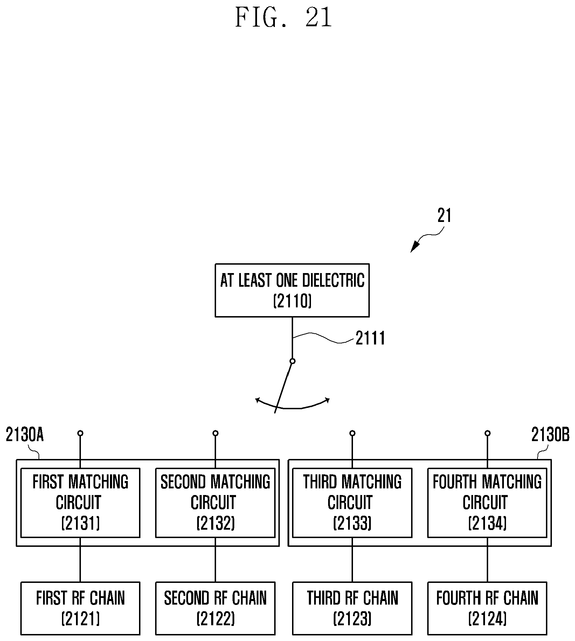

FIG. 21 is a block diagram illustrating a communication system 21 included in an electronic device (e.g., the foldable electronic device 3 of FIG. 3) according to various embodiments of the present disclosure.

With reference to FIG. 21, the communication system 21 may include at least one dielectric 2110, a first RF chain 2121, a second RF chain 2122, a third RF chain 2123, a fourth RF chain 2124, a first matching circuit 2131, a second matching circuit 2132, a third matching circuit 2133, and/or a fourth matching circuit 2134.

According to an embodiment, the at least one dielectric 2110 may be implemented to act as a dielectric resonator when fed through an electrical path (hereinafter, a 'dielectric feeding path') 2111 connected to the at least one dielectric 2110. The dielectric 2110 may include, for example, the first dielectric 1851, the second dielectric 1852, the third dielectric 1853, and/or the fourth dielectric 1854 of FIG. 18.

According to an embodiment, the first RF chain 2121 may be implemented to transmit and/or receive electromagnetic signals of a first linear polarization having a first polarization direction through at least one antenna radiator included in an electronic device (e.g., the foldable electronic device 3 of FIG. 3) in a first frequency band of use (or a first operating frequency band). In response to the first RF chain 2121, the position of the feeding portion (or the feeding point) with respect to the at least one antenna radiator (or on the at least one antenna radiator) may be provided such that the first linear polarization having the first polarization direction may be radiated through the at least one antenna radiator.

According to an embodiment, the second RF chain 2122 may be implemented to transmit and/or receive electromagnetic signals of a second linear polarization having a second polarization direction perpendicular to the first polarization direction through the at least one antenna radiator included in the electronic device (e.g., the foldable electronic device 3 of FIG. 3) in a first frequency band of use (or a first operating frequency band). In response to the second RF chain 2122, the position of the feeding portion (or the feeding point) with respect to the at least one antenna radiator (or on the at least one antenna radiator) may be provided such that the second linear polarization having the second polarization direction may be radiated through the at least one antenna radiator.

According to an embodiment, the third RF chain 2123 may be implemented to transmit and/or receive electromagnetic signals of the third linear polarization having the first polarization direction through the at least one antenna radiator included in the electronic device (e.g., the foldable electronic device 3 of FIG. 3) in a second frequency band of use (or a second operating frequency band) that is different from the first frequency band. Corresponding to the third RF chain 2123, the position of the feeding portion (or the feeding point) to the at least one antenna radiator (or on the at least one antenna radiator) may be provided such that the third linear polarization having the first polarization direction may be radiated through the at least one antenna radiator.

According to an embodiment, the fourth RF chain 2124 may be implemented to transmit and/or receive electromagnetic signals of the fourth linear polarization having the second polarization direction through the at least one antenna radiator included in the electronic device (e.g., the foldable electronic device 3 of FIG. 3) in a second frequency band of use (or a second operating frequency band). Corresponding to the fourth RF chain 2124, the position of the feeding portion (or the feeding point) to the at least one antenna radiator (or on the at least one antenna radiator) may be provided such that the fourth linear polarization having the second polarization direction may be radiated through the at least one antenna radiator.

According to an embodiment, the first RF chain 2121, the second RF chain 2122, the third RF chain 2123, and the fourth RF chain 2124 may be disposed on another printed circuit board electrically connected to the antenna module 18 of FIG. 18 (e.g., a printed circuit board on which components such as the processor 120, the memory 130, or the communication module 190 of FIG. 1 are disposed). A communication circuit (e.g., the communication circuit 54 of FIG. 6) (hereinafter, a 'second communication circuit') included in antenna module 18 of FIG. 18 may exchange signals with another communication circuit (e.g., the wireless communication module 192 of FIG. 1) (hereinafter, a 'first communication circuit') disposed on another printed circuit board. In an embodiment, the first RF chain 2121, the second RF chain 2122, the third RF chain 2123, and the fourth RF chain 2124 may be at least partially included in the first communication circuit.

According to an embodiment, the communication system 21 may include a switching circuit. The switching circuit may be included in the first communication circuit or the second communication circuit. In various embodiments, the switching circuit may be provided separately from the first communication circuit and the second communication circuit. The switching circuit may selectively electrically connect the first RF chain 2121, the second RF chain 2122, the third RF chain 2123, or the fourth RF chain 2124 to the dielectric feeding path 2111 under the control of a processor (e.g., the processor 120 of FIG. 1).

According to an embodiment, when the first RF chain 2121 is electrically connected to the dielectric feeding path 2111 by a switching circuit, the at least one dielectric 2110 may act as a dielectric resonator to electromagnetically influence the first linear polarization to reduce degradation of transmission and/or reception performance.

According to an embodiment, when the second RF chain 2122 is electrically connected to the dielectric feeding path 2111 by a switching circuit, the at least one dielectric 2110 may act as a dielectric resonator to electromagnetically influence the second linear polarization to reduce degradation of transmission and/or reception performance for the second linear polarization.

According to an embodiment, when the third RF chain 2123 is electrically connected to the dielectric feeding path 2111 by a switching circuit, the at least one dielectric 2110 may act as a dielectric resonator to electromagnetically influence the third RF chain 2123 to reduce degradation of transmission and/or reception performance for the third linear polarization.

According to an embodiment, when the fourth RF chain 2124 is electrically connected to the dielectric feeding path 2111 by a switching circuit, the at least one dielectric 2110 may act as a dielectric resonator to electromagnetically influence the fourth RF chain 2124 to reduce degradation of transmission and/or reception performance for the fourth linear polarization.

According to an embodiment, when the first RF chain 2121 is configured to be electrically connected to the dielectric feeding path 2111, the first RF chain 2121 may be electrically connected to the dielectric feeding path 2111 through the first matching circuit 2131. When the second RF chain 2122 is configured to be electrically connected to the dielectric feeding path 2111, the second RF chain 2122 may be electrically connected to the dielectric feeding path 2111 through the second matching circuit 2132. When the third RF chain 2123 is configured to be electrically connected to the dielectric feeding path 2111, the third RF chain 2123 may be electrically connected to the dielectric feeding path 2111 through the third matching circuit 2133. When the fourth RF chain 2124 is configured to be electrically connected to the dielectric feeding path 2111, the fourth RF chain 2124 may be electrically connected to the dielectric feeding path 2111 through the fourth matching circuit 2134.

According to an embodiment, the matching circuit (e.g., the first matching circuit 2131, the second matching circuit 2132, the third matching circuit 2133, or the fourth matching circuit 2134) may include at least one electrical element having a component such as a capacitance, inductance, or conductance (e.g., a lumped element or a passive element), or a circuit implemented with a combination of these electrical elements.

According to an embodiment, the matching circuit (e.g., the first matching circuit 2131, the second matching circuit 2132, the third matching circuit 2133, or the fourth matching circuit 2134) may be tunable to a resonant frequency. The matching circuit may, for example, shift the resonant frequency to a specified frequency or shift the resonant frequency by a specified amount.

According to an embodiment, the matching circuit (e.g., the first matching circuit 2131, the second matching circuit 2132, the third matching circuit 2133, or the fourth matching circuit 2134) may match impedances. The matching circuit may reduce power dissipation at the selected or specified frequency to enable efficient signal transmission. The matching circuit may reduce the amount of reflections at the selected or specified frequency.

According to an embodiment, the first matching circuit 2131 and/or the second matching circuit 2132 may contribute to isolation to reduce electromagnetic effects between the first RF chain 2121 transmitting and/or receiving the first linear polarization and the second RF chain 2122 transmitting and/or receiving the second linear polarization.

According to an embodiment, the third matching circuit 2133 and/or the fourth matching circuit 2134 may contribute to isolation to reduce electromagnetic effects between the third RF chain 2123 transmitting and/or receiving the third linear polarization and the fourth RF chain 2124 transmitting and/or receiving the fourth linear polarization.

According to an embodiment, the first matching circuit 2131, the second matching circuit 2132, the third matching circuit 2132, and/or the fourth matching circuit 2134 may be disposed on another printed circuit board electrically connected to the antenna module 18 of FIG. 18, such as a printed circuit board on which components such as the processor 120, the memory 130, or the communication module 190 of FIG. 1 are disposed. In various embodiments, the first matching circuit 2131, the second matching circuit 2132, the third matching circuit 2132, and/or the fourth matching circuit 2134 may be included in a second communication circuit disposed on another printed circuit board.

According to various embodiments, one matching circuit 2130A may be implemented to replace the first matching circuit 2131 and the second matching circuit 2132 in response to the first frequency band of use. Another matching circuit 2130B that replaces the third matching circuit 2133 and the fourth matching circuit 2134 in response to the second frequency band of use, may be implemented. A switching circuit included in the communication system 21 may, under the control of a processor (e.g., the processor 120 of FIG. 1), electrically connect the two matching circuits 2130A and 2130B selectively to the dielectric feeding path 2111.

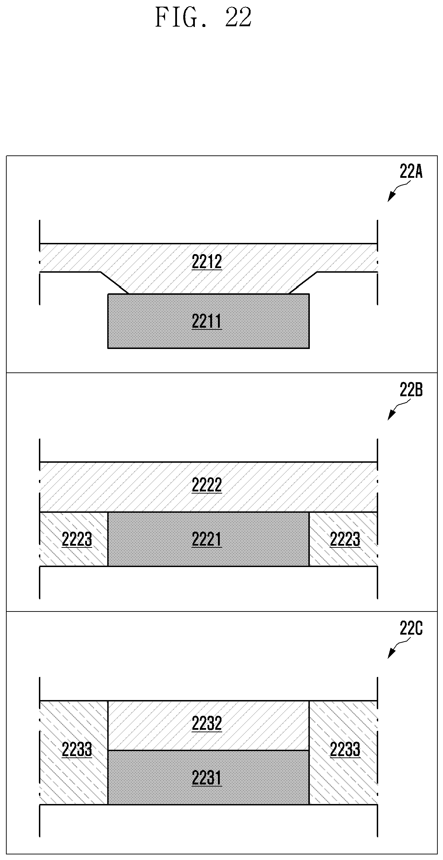

FIG. 22 is a cross-sectional view illustrating a portion of an electronic device (e.g., the foldable electronic device 3 of FIG. 3) according to various embodiments of the present disclosure.

With reference to FIG. 22, the electronic device 22A according to a first embodiment may include an antenna structure 2211 and a dielectric 2212. The antenna structure 2211 may be, for example, the antenna structure 51 of FIG. 5 or the antenna structure 181 of FIG. 18. The dielectric 2212 may be positioned facing antenna structure 2211. In an embodiment, the dielectric 2212 may be coupled to the antenna structure 2211. The dielectric 2212, for example, may be positioned in a direction in which the antenna structure 2211 substantially radiates electromagnetic waves during the feeding.

According to an embodiment, the dielectric 2212 may be electromagnetically coupled to the antenna structure 2211 during the feeding to operate as a dielectric resonator to extend coverage. The dielectric 2212 may receive electromagnetic signals from a communication circuit disposed on or electrically connected to antenna structure 2211, such as communication circuit 54 of FIG. 6.

According to an embodiment, the dielectric 2212 may include a non-conductive material (e.g., a polymer). The dielectric 2212 may have a relative permittivity that is greater than a conductor having a relative permittivity being substantially 1.

According to various embodiments, the dielectric 2212 may be included in a housing that provides an exterior surface of the electronic device 22A. The dielectric 2212 may be, for example, the first cover 312 of the foldable electronic device 3 of FIG. 3.

According to an embodiment, in the electronic device 22A according to the first embodiment, the portion of the dielectric 2212 that faces the antenna structure 2211 or is in physical contact with (or coupled to) the antenna structure 2211 may have a relatively greater thickness. When viewed from above the dielectric 2212, the portion of the dielectric 2212 that overlaps with the antenna element included in the antenna structure 2211 may have a relatively greater thickness.

The electronic device 22B according to another second embodiment may include the antenna structure 2221, the dielectric 2222, and/or the metal body 2223.

The antenna structure 2221 may be, for example, the antenna structure 51 of FIG. 5 or the antenna structure 181 of FIG. 18. The dielectric 2222 may be coupled to the antenna structure 2221 or may be positioned facing the antenna structure 2221. In an embodiment, the dielectric 2222 may be coupled to the antenna structure 2221. The dielectric 2222, for example, may be positioned in a direction in which the antenna structure 2221 substantially radiates electromagnetic waves during the feeding.

According to an embodiment, the dielectric 2222 may be electromagnetically coupled to the antenna structure 2221 during the feeding to operate as a dielectric resonator to extend coverage. The dielectric 2222 may receive electromagnetic signals from a communication circuit disposed on or electrically connected to the antenna structure 2221 (e.g., the communication circuit 54 of FIG. 6).

According to an embodiment, the dielectric 2222 may include a non-conductive material (e.g., a polymer). The dielectric 2222 may have a relative permittivity that is greater than a conductor having a relative permittivity being substantially 1.

According to various embodiments, the dielectric 2222 may be included in a housing that provides an exterior surface of the electronic device 22B. The dielectric 2222 may be, for example, the first cover 312 of the foldable electronic device 3 of FIG. 3.

According to an embodiment, the metal body 2223 may be located on the interior of the electronic device 22B. The metal body 2223 may be disposed to at least partially surround the antenna structure 2221, as viewed from above the dielectric 2222. The metal body 2223 may include, for example, openings or recesses, and the antenna structure 2221 may be inserted into the openings or recesses of the metal body 2223. In various embodiments, the metal body 2223 may be coupled to the antenna structure 2221 and/or the dielectric 2222.

The electronic device 22C according to yet another third embodiment may include an antenna structure 2231, a dielectric 2232, and/or a metal body 2233.

The antenna structure 2231 may be, for example, the antenna structure 51 of FIG. 5 or the antenna structure 181 of FIG. 18. The dielectric 2232 may be positioned face to face with antenna structure 2231. The dielectric 2232 may be coupled to the antenna structure 2231. The dielectric 2232, for example, may be positioned in a direction in which the antenna structure 2231 substantially radiates electromagnetic waves during the feeding.

According to an embodiment, the dielectric 2232 may be electromagnetically coupled to the antenna structure 2231 during the feeding to operate as a dielectric resonator to extend coverage. The dielectric 2232 may receive electromagnetic signals from a communication circuit disposed on or electrically connected to the antenna structure 2231, such as the communication circuit 54 of FIG. 6.

According to an embodiment, the dielectric 2232 may include a non-conductive material (e.g., a polymer). The dielectric 2232 may have a relative permittivity that is greater than a conductor having a relative permittivity being substantially 1.

According to an embodiment, the metal body 2233 may be disposed to at least partially surround the antenna structure 2231 and/or the dielectric 2232, as viewed from above the dielectric 2232. The metal body 2233 may include, for example, openings or recesses, and the antenna structure 2231 and dielectric 2232 may be inserted into the openings or recesses of the metal body 2233. In various embodiments, the metal body 2233 may be coupled to the antenna structure 2231 and/or the dielectric 2232.

According to various embodiments, the dielectric 2232 and the metal body 2233 may be included in a housing that provides an exterior surface of the electronic device 22C. The dielectric 2232 may be, for example, a portion included in the first cover 312 of the foldable electronic device 3 of FIG. 3, and the metal body 2233 may be the other portion included in the first cover 312.

According to an exemplary embodiment of the present disclosure, the electronic device (e.g., the foldable electronic device 3) may include a wireless communication circuit (e.g., a communication circuit 54), an antenna structure 51, a non-conductive dielectric (e.g., a first dielectric 61), and a conductive path. The antenna structure 51 may include a printed circuit board 510 electrically connected to the wireless communication circuit (e.g., the communication circuit 54). The printed circuit board 510 may include a first surface 511 and a second surface 512 facing in an opposite direction from the first surface 511. The printed circuit board 510 may include an antenna element (e.g., a first antenna element 521) disposed on the first surface 511 or disposed on an interior of the printed circuit board 510 closer to the first surface 511 than the second surface 512. A non-conductive dielectric (e.g., a first dielectric 61) may face the first surface 511 and may overlap with the antenna element (e.g., the first antenna element 521) when viewed from above the first surface 511. The conductive path may be disposed at least partially on the printed circuit board 510 and may be electrically connected to the wireless communication circuit (e.g., the communication circuit 54). The conductive path may be in physical contact with a non-conductive dielectric (e.g., a first dielectric 61).

According to an exemplary embodiment of the present disclosure, the conductive path may be physically separated from an antenna element (e.g., the first antenna element 521).

According to an exemplary embodiment of the present disclosure, the conductive path may penetrate an opening 5211 provided in the antenna element (e.g., the first antenna element 521).

According to an exemplary embodiment of the present disclosure, the conductive path may include a conductive via (e.g., a first conductive via V1) included in the printed circuit board 510.

According to an exemplary embodiment of the present disclosure, the electronic device 3 may further include a connector (e.g., a first connector 1231) disposed between the non-conductive dielectric 1221 and the first surface 1210a. The conductive path may include a conductive via (e.g., a first conductive via V1) included in the printed circuit board 1210, and a conductive portion (e.g., a first conductive portion C1) included in the connector (e.g., the first connector 1231) for electrical connection with the conductive via (e.g., the first conductive via V1). The conductive portion (e.g., the first conductive portion C1) may be in physical contact with the non-conductive dielectric 1221.

According to exemplary embodiments of the present disclosure, the connector (e.g., the first connectors 1231) may be another printed circuit board. The conductive portion (e.g., the first conductive portion C1) may be a conductive via provided on the another printed circuit board.

According to an exemplary embodiment of the present disclosure, the printed circuit board 1810 may further include other antenna elements (e.g., a fifth antenna element 1831) disposed closer to the first surface 1811 than the antenna elements (e.g., the first antenna element 1821).

According to an exemplary embodiment of the present disclosure, a wireless communication circuit (e.g., a communication circuit 54) may be disposed on the second surface 512.

According to an exemplary embodiment of the present disclosure, the wireless communication circuit (e.g., the communication circuit 54) may vary the phase of the electromagnetic signal provided to the antenna element (e.g., a first antenna element 521) and the phase of the electromagnetic signal provided by the conductive path.

According to an exemplary embodiment of the present disclosure, the printed circuit board 510 may further include a ground plane 53 disposed closer to the second surface 512 than the antenna elements (e.g., the first antenna element 521).

According to an exemplary embodiment of the present disclosure, the electronic device (e.g., the foldable electronic device 3) may further include another wireless communication circuit. The electronic device (e.g., the foldable electronic device 3) may further include a switching circuit disposed in an electrical path between the conductive path and the another wireless communication circuit.

According to an exemplary embodiment of the present disclosure, the electronic device (e.g., the foldable electronic device 3) may further include a matching circuit (e.g., the first matching circuit 2131) disposed in an electrical path between the conductive path and the another wireless communication circuit.

According to an exemplary embodiment of the present disclosure, the portion of the non-conductive dielectric 2212 overlapping with the antenna element (e.g., the first antenna element 521) may have a relatively greater thickness when viewed from above the first surface 511.

According to an exemplary embodiment of the present disclosure, the electronic device (e.g., the foldable electronic device 3) may further include a cover (e.g., the first cover 312) that provides an exterior surface of the electronic device (e.g., the foldable electronic device 3). A non-conductive dielectric (e.g., a first dielectric 61) may be positioned between the first surface 511 and the cover (e.g., the first cover 312).

According to an exemplary embodiment of the present disclosure, the non-conductive dielectric (e.g., the first dielectric 61) may be included in a housing (e.g., the foldable housing 30) that provides the appearance of an electronic device (e.g., the foldable electronic device 3).

According to an exemplary embodiment of the present disclosure, the electronic device 3 may include a wireless communication circuit 54, an antenna structure 181, a non-conductive dielectric (e.g., a first dielectric 1851), and a conductive path. The antenna structure 181 may include a printed circuit board 1810 electrically connected to the wireless communication circuit 54. The printed circuit board 1810 may include a first surface 1811 and a second surface 1812 facing in an opposite direction from the first surface 1811. The printed circuit board 1810 may include a first antenna element 1821 disposed on the first surface 1811, or disposed within the interior of the printed circuit board 1810 closer to the first surface 1811 than the second surface 1812. The printed circuit board 1810 may include a second antenna element (e.g., a fifth antenna element 1831) disposed closer to the first surface 1811 than the first antenna element 1821. A non-conductive dielectric (e.g., a first dielectric 1851) may face the first surface 1811 and may overlap with the first antenna element 1821 and the second antenna element (e.g., the fifth antenna element 1831) when viewed from above the first surface 1811. The conductive paths may be disposed at least partially on the printed circuit board 1810 and may be electrically connected to the wireless communication circuit 54. The conductive path may be in physical contact with a non-conductive dielectric (e.g., a first dielectric 1851).

According to an exemplary embodiment of the present disclosure, the conductive path may be physically separated from the first antenna element 1821 and the second antenna element (e.g., the fifth antenna element 1831).

According to an exemplary embodiment of the present disclosure, the conductive path may penetrate an opening 1821a provided in the first antenna element 1821 and an opening 1831a provided in the second antenna element (e.g., the fifth antenna element 1831).

According to an exemplary embodiment of the present disclosure, the conductive path may include a conductive via (e.g., a first conductive via V12) included in the printed circuit board 1810.

According to an exemplary embodiment of the present disclosure, the electronic device (e.g., the foldable electronic device 3) may further include a connection (e.g., a first connector 1861) disposed between a non-conductive dielectric (e.g., a first dielectric 1851) and the first surface 1811. The conductive path may include a conductive via (e.g., first conductive via V12) included in the printed circuit board 1810, and a conductive portion (e.g., a first conductive portion C12) included in the connector (e.g., the first connector 1861) for electrical connection with the conductive via (e.g., the first conductive via V12). The conductive portion (e.g., the first conductive portion C12) may be in physical contact with a non-conductive dielectric (e.g., the first dielectric 1851).

The embodiments disclosed in this disclosure and the drawings are only specific examples presented to more easily explain the technical content and help in understanding the present disclosure, and are not intended to limit the scope of the present disclosure. Therefore, the scope of various embodiments of the present disclosure should be interpreted that modified or altered forms other than the embodiments disclosed herein are included in the scope of various embodiments of the present disclosure. Additionally, it will be understood that any embodiment(s) described herein can be used in conjunction with any other embodiment(s) described herein.

## Claims

1. An electronic device (3) comprising:
a wireless communication circuit (54);
an antenna structure (51) including a printed circuit board (510) electrically connected to the wireless communication circuit (54), wherein the printed circuit board (510) includes a first surface (511), a second surface (512) facing in the opposite direction from the first surface (511), and an antenna element (521) disposed on the first surface (511) or disposed inside the printed circuit board (510) closer to the first surface (511) than the second surface (512);
a non-conductive dielectric (61) facing the first surface (511) and overlapping with the antenna element (521) when viewed from above the first surface (511); and
a conductive path at least a portion of which is disposed on the printed circuit board (510) and which is connected to the wireless communication circuit (54),
wherein the conductive path is in physical contact with the non-conductive dielectric (61).

2. The electronic device of claim 1, wherein the conductive path is physically separated from the antenna element (521).

3. The electronic device of claim 1 or claim 2, wherein the conductive path penetrates an opening (5211) provided in the antenna element (521).

4. The electronic device of any one of claims 1 to 3, wherein the conductive path comprises a conductive via (V1) included in the printed circuit board (510).

5. The electronic device of any one of claims 1 to 3, further comprising the connector (1231) disposed between the conductive dielectric (1221) and the first surface (1210a),
wherein the conductive dielectric comprises a conductive via (V1) included in the printed circuit board (1210) and a conductive portion (C1) included in the connector (1231) so as to be electrically connected to the conductive via (V1), and
wherein the conductive part (C1) is in physical contact with the non-conductive dielectric (1221).

6. The electronic device of claim 5, wherein the connector (1231) is another printed circuit board, and the conductive portion (C1) is a conductive via provided on the another printed circuit board.

7. The electronic device of any one of claims 1 to 6,
wherein the printed circuit board (1810) further comprises another antenna element (1831) disposed closer to the first surface (1811) than the antenna element (1821), and
wherein the first antenna element (1821) and the second antenna element (1831) overlap each other when viewed from above the first surface (1811).

8. The electronic device of any one of claims 1 to 7, wherein the wireless communication circuit (54) is disposed on the second surface (512).

9. The electronic device of any one of claims 1 to 8, wherein the wireless communication circuit (54) varies the electromagnetic signal provided to the antenna element (521) and the phase of the electromagnetic signal provided to the conductive path.

10. The electronic device of any one of claims 1 to 9, wherein the printed circuit board (510) further comprises a ground plane (53) disposed closer to the second surface (512) than the antenna element (521).

11. The electronic device of any one of claims 1 to 10, further comprising another wireless communication circuit and a switching circuit disposed in an electrical path between the conductive path and the another wireless communication circuit.

12. The electronic device of any one of claims 11, further comprising a matching circuit (2131) disposed in an electrical path between the conductive path and the another wireless communication circuit.

13. The electronic device of any one of claims 1 to 12, wherein, the portion of the non-conductive dielectric (2212) overlapping with the antenna element (521) has a relatively greater thickness, when viewed from above the first surface (511).

14. The electronic device of any one of claims 1 to 13, further comprising a cover providing an outer surface of the electronic device (3),
wherein the non-conductive dielectric (61) is positioned between the first surface (511) and the cover (312).

15. The electronic device of any one of claims 1 to 13, wherein, the non-conductive dielectric (6) is included in a housing (30) that provides the appearance of the electronic device (3).
